(19) Europäisches Patentamt
European Patent Office
Office européen des brevets

(11) EP 3 809 479 B1

(12) EUROPEAN PATENT SPECIFICATION

(45) Date of publication and mention of the grant of the patent:
**12.07.2023 Bulletin 2023/28**

(21) Application number: **19203056.7**

(22) Date of filing: **14.10.2019**

(51) International Patent Classification (IPC):
***H10K 50/12*** *(2023.01)* ***H10K 85/60*** *(2023.01)*

(52) Cooperative Patent Classification (CPC):
**H10K 50/121;** H10K 85/322; H10K 85/40; H10K 85/654; H10K 85/6572; H10K 2101/20; H10K 2101/30

# (54) ORGANIC ELECTROLUMINESCENT DEVICE EMITTING BLUE LIGHT

BLAULICHTEMITTIERENDE ORGANISCHE ELEKTROLUMINESZENTE VORRICHTUNG

DISPOSITIF ÉLECTROLUMINESCENT ORGANIQUE ÉMETTANT UNE LUMIÈRE BLEUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**21.04.2021 Bulletin 2021/16**

(73) Proprietor: **Samsung Display Co., Ltd.**
**Gyeonggi-do 17113 (KR)**

(72) Inventors:
- **Koch, Federico**
  **97453 Schonungen (DE)**
- **Kasparek, Christian**
  **69124 Heidelberg (DE)**

(74) Representative: **Jacobi, Markus Alexander**
**Patentanwälte**
**Isenbruck Bösl Hörschler PartG mbB**
**Eastsite One**
**Seckenheimer Landstrasse 4**
**68163 Mannheim (DE)**

(56) References cited:
**EP-A1- 2 958 158**
**EP-A1- 3 144 997**
**EP-A1- 3 399 566**
**EP-A1- 3 490 023**
**WO-A1-2015/135624**
**WO-A1-2019/052939**
**US-A1- 2016 093 823**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 809 479 B1

## Description

The present invention relates to organic electroluminescent devices comprising a light-emitting layer B comprising a host material $H^B$, a first thermally activated delayed fluorescence (TADF) material $E^B$, and an emitter material $S^B$ as defined in claim 1.

Description

Organic electroluminescent devices containing one or more light-emitting layers based on organics such as, e.g., organic light emitting diodes (OLEDs), light emitting electrochemical cells (LECs) and light-emitting transistors gain increasing importance. In particular, OLEDs are promising devices for electronic products such as e.g. screens, displays and illumination devices. In contrast to most electroluminescent devices essentially based on inorganics, organic electroluminescent devices based on organics are often rather flexible and producible in particularly thin layers. The OLED-based screens and displays already available today bear particularly beneficial brilliant colors, contrasts and are comparably efficient with respect to their energy consumption.

A central element of an organic electroluminescent device for generating light is a light-emitting layer placed between an anode and a cathode. When a voltage (and current) is applied to an organic electroluminescent device, holes and electrons are injected from an anode and a cathode, respectively, to the light-emitting layer. Typically, a hole transport layer is located between light-emitting layer and the anode, and an electron transport layer is located between light-emitting layer and the cathode. The different layers are sequentially disposed. Excitons of high energy are then generated by recombination of the holes and the electrons. The decay of such excited states (e.g., singlet states such as S1 and/or triplet states such as T1) to the ground state (S0) desirably leads to light emission.

In order to enable efficient energy transport and emission, an organic electroluminescent device comprises one or more host compounds and one or more emitter compounds as dopants. Prior art document EP 3 490 023 A1 discloses an OLED device with a light emitting layer comprising a TADF emitter and two host materials.

Challenges when generating organic electroluminescent devices are thus the improvement of the illumination level of the devices (i.e., brightness per current), obtaining a desired light spectrum and achieving suitable (long) lifespans.

There is still a lack of efficient and stable OLEDs that emit in the visible light spectrum. Accordingly, there is still the unmet technical need for organic electroluminescent devices which have a long lifetime and high quantum yields. Surprisingly, it has been found that an organic electroluminescent device's light-emitting layer comprising one thermally activated delayed fluorescence (TADF) material, an emitter material and a host material provides an organic electroluminescent device having good lifetime and quantum yields and exhibiting emission in the visible.

Accordingly, one aspect of the present invention relates to an organic electroluminescent device which comprises a light-emitting layer B comprising:

(i) a host material $H^B$, which has a lowermost excited singlet state energy level $S1^H$, a lowermost excited triplet state energy level $T1^H$, and a highest occupied molecular orbital HOMO($H^B$) having an energy $E^{HOMO}(H^B)$;

(ii) a first thermally activated delayed fluorescence (TADF) material $E^B$, which has a lowermost excited singlet state energy level $S1^E$, a lowermost excited triplet state energy level $T1^E$, and a highest occupied molecular orbital HOMO($E^B$) having an energy $E^{HOMO}(E^B)$; and

(iii) an emitter material $S^B$, which has a lowermost excited singlet state energy level $S1^S$ and a highest occupied molecular orbital HOMO($S^B$) having an energy $E^{HOMO}(S^B)$;

wherein the relations expressed by the following formulas (1) to (5) apply:

$$S1^H > S1^E \qquad (1)$$

$$S1^H > S1^S \qquad (2)$$

$$S1^E > S1^S \qquad (3)$$

$$E^{HOMO}(E^B) > E^{HOMO}(S^B) \qquad (4)$$

$$E^{HOMO}(E^B) > E^{HOMO}(H^B) \qquad (5);$$

and wherein TADF material $E^B$ comprises or consists of a structure according to Formula NRCT as defined in claim 1.

According to the invention, the lowermost excited singlet state of the host material $H^B$ is higher in energy than the lowermost excited singlet state of the first thermally activated delayed fluorescence (TADF) material $E^B$.

The lowermost excited singlet state of the host material $H^B$ is higher in energy than the lowermost excited singlet state of the emitter material $S^B$. The lowermost excited singlet state of the first TADF material $E^B$ is higher in energy than the lowermost excited singlet state of the emitter material $S^B$.

In one embodiment of the invention, the relations expressed by formulas (3a) applies:

$$S1^E - S1^S \leq 0.4 \text{ eV} \qquad (3a).$$

In one embodiment of the invention, the relations expressed by formulas (3a) applies:

$$S1^E - S1^S \leq 0.3 \text{ eV} \qquad (3b).$$

In one embodiment of the invention, the relations expressed by formulas (3a) applies:

$$S1^E - S1^S \leq 0.2 \text{ eV} \qquad (3c).$$

In one embodiment of the invention, the relations expressed by one of the following formulas (6) and (7) applies:

$$0.2 \text{ eV} \leq E^{HOMO}(E^B) - E^{HOMO}(S^B) \leq 0.8 \text{ eV} \qquad (6).$$

$$0.2 \text{ eV} \leq E^{HOMO}(E^B) - E^{HOMO}(H^B) \leq 0.8 \text{ eV} \qquad (7).$$

In this embodiment, the highest occupied molecular orbital of the TADF material $E^B$ is higher in energy than the highest occupied molecular orbital of the emitter material $S^B$ by at least 0.2 eV and by 0.8 eV at the maximum, preferably by at least 0.3 eV and by 0.7 eV at the maximum, in particular by at least 0.4 eV and by 0.6 eV at the maximum.

In an alternative embodiment of the invention, the highest occupied molecular orbital of the TADF material $E^B$ is higher in energy than the highest occupied molecular orbital of the host material $H^B$ by at least 0.2 eV and by 0.8 eV at the maximum, preferably by at least 0.3 eV and by 0.7 eV at the maximum, in particular by at least 0.4 eV and by 0.6 eV at the maximum.

As used herein, the terms "TADF material" and "TADF emitter" may be understood interchangeably. When one of the terms "emitter" "emitter compound" or the like is used, this may be understood in that preferably a TADF material of the present invention is meant, in particular one or those designated as $E^B$.

According to the present invention, a TADF material is characterized in that it exhibits a $\Delta E_{ST}$ value, which corresponds to the energy difference between the lowermost excited singlet state (S1) and the lowermost excited triplet state (T1), of less than 0.4 eV, preferably less than 0.3 eV, more preferably less than 0.2 eV. Accordingly in an embodiment of the present invention, the TADF material $E^B$ is characterized in that it has a $\Delta E_{ST}$ value, which corresponds to the energy difference between $S1^E$ and $T1^E$, of less than 0.4 eV. In a preferred embodiment of the present invention, the TADF material $E^B$ is characterized in that it has a $\Delta E_{ST}$ value of less than 0.3 eV, less than 0.2 eV.

In one embodiment of the invention, the relations expressed by formula (8) applies:

$$S1^S > T1^E \qquad (8),$$

wherein the lowermost excited singlet state energy level $S1^S$ is higher in energy than the lowermost excited triplet state energy level $T1^E$.

In a preferred embodiment, the lowermost excited triplet state of the host material $H^B$ ($T1^H$) is higher in energy than the lowermost excited triplet state of the TADF material $E^B$ ($T1^E$): $T1^H > T1^E$.

In a preferred embodiment, the lowermost excited triplet state of the host material $H^B$ ($T1^H$) is higher in energy

than the lowermost excited triplet state of the emitter material $S^B$ ($T1^S$): $T1^H > T1^S$.

In one embodiment of the invention, mass ratio of TADF material $E^B$ to the emitter material $S^B$ ($S^B : B^B$) is >1. In one embodiment of the invention, the mass ratio $S^B : E^B$ is in the range of 1.5:1 to 30:1, in the range of 2:1 to 25:1, or in the range of 3:1 to 20:1. For example, the mass ratio $S^B : E^B$ is in the range of (approximately) 15:1, 12:1, 10:1 or8:1.

As used herein, the terms organic electroluminescent device and opto-electronic light-emitting devices may be understood in the broadest sense as any device comprising a light-emitting layer B comprising a host material $H^B$, a TADF material $E^B$ of Formula I-NRCT as defined in claim 1 and an emitter material $S^B$ It will be understood that the light-emitting layer B may also comprise more than one TADF materials $E^B$ and/or more than one emitter material $S^B$ each having the properties as described herein. According to the present invention, the light-emitting layer B comprises at least one TADF material $E^B$ and at least one emitter material $S^B$ each having the properties as described herein. According to one embodiment of the present invention, the light-emitting layer B comprises one TADF material $E^B$ and one emitter material $S^B$ each having the properties as described herein.

As used herein, the terms organic electroluminescent device and opto-electronic light-emitting devices may be understood in the broadest sense as any device comprising a light-emitting layer B comprising a host material $H^B$, a TADF material of Formula I-NRCT as defined in claim 1 and an emitter material $S^B$

The organic electroluminescent device may be understood in the broadest sense as any device based on organic materials that is suitable for emitting light in the visible or nearest ultraviolet (UV) range, i.e., in the range of a wavelength of from 380 to 800 nm. More preferably, organic electroluminescent device may be able to emit light in the visible range, i.e., of from 400 to 800 nm.

In a preferred embodiment, the organic electroluminescent device is a device selected from the group consisting of an organic light emitting diode (OLED), a light emitting electrochemical cell (LEC), and a light-emitting transistor.

Particularly preferably, the organic electroluminescent device is an organic light emitting diode (OLED). Optionally, the organic electroluminescent device as a whole may be intransparent, semi-transparent or (essentially) transparent.

The term "layer" as used in the context of the present invention preferably is a body that bears an extensively planar geometry.

The light-emitting layer B preferably bears a thickness of not more than 1 mm, more preferably not more than 0.1 mm, even more preferably not more than 10 $\mu$m, even more preferably not more than 1 $\mu$m, in particular not more than 0.1 $\mu$m.

The person skilled in the art will notice that the light-emitting layer B will typically be incorporated in the organic electroluminescent device of the present invention.

Preferably, such organic electroluminescent device comprises at least the following layers: at least one light-emitting layer B, at least one anode layer A and at least one cathode layer C.

Preferably, the anode layer A contains at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof.

Preferably, the cathode layer C contains at least one component selected from the group consisting of Al, Au, Ag, Pt, Cu, Zn, Ni, Fe, Pb, In, W, Pd, LiF, Ca, Ba, Mg, and mixtures or alloys of two or more thereof.

Preferably, the light-emitting layer B is located between an anode layer A and a cathode layer C. Accordingly, the general set-up is preferably A - B - C. This does of course not exclude the presence of one or more optional further layers. These can be present at each side of A, of B and/or of C.

In a preferred embodiment, the organic electroluminescent device comprises at least the following layers:

A) an anode layer A containing at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof;

B) the light-emitting layer B; and

C) a cathode layer C containing at least one component selected from the group consisting of Al, Au, Ag, Pt, Cu, Zn, Ni, Fe, Pb, In, W, Pd, LiF, Ca, Ba, Mg, and mixtures or alloys of two or more thereof,

wherein the light-emitting layer B is located between the anode layer A and the a cathode layer C.

In one embodiment, when the organic electroluminescent device is an OLED, it may optionally comprise the following layer structure:

A) an anode layer A, exemplarily comprising indium tin oxide (ITO);

HTL) a hole transport layer HTL;

B) a light-emitting layer B according to present invention as described herein;

ETL) an electron transport layer ETL; and

C) a cathode layer, exemplarily comprising Al, Ca and/or Mg.

Preferably, the order of the layers herein is A - HTL - B - ETL - C.

Furthermore, the organic electroluminescent device may optionally comprise one or more protective layers protecting the device from damaging exposure to harmful species in the environment including, exemplarily moisture, vapor and/or gases.

Preferably, the anode layer A is located on the surface of a substrate. The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C transparent. Preferably, the anode layer A comprises a large content or even consists of transparent conductive oxides (TCOs).

Such anode layer A may exemplarily comprise indium tin oxide, aluminum zinc oxide, fluor tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene.

Particularly preferably, the anode layer A (essentially) consists of indium tin oxide (ITO) (e.g., $(InO_3)_{0.9}(SnO_2)_{0.1}$). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. The hole injection layer (HIL) may also prevent the diffusion of metals from the anode layer A into the hole transport layer (HTL). The HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)-phenyl]benzidine), MeO-TPD (N,N,N',N'-tetrakis(4-methoxyphenyl)-benzi-dine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL) typically a hole transport layer (HTL) is located. Herein, any hole transport compound may be used. Exemplarily, electron-rich heteroaromatic compounds such as triarylamines and/or carbazoles may be used as hole transport compound. The HTL may decrease the energy barrier between the anode layer A and the light-emitting layer B (serving as emitting layer (EML)). The hole transport layer (HTL) may also be an electron blocking layer (EBL). Preferably, hole transport compounds bear comparably high energy levels of their triplet states T1. Exemplarily the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)-amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may exemplarily be used as inorganic dopant.

Tetrafluorotetracyanoquinodimethane (F4-TCNQ), copper-pentafluorobenzoate (Cu(I)pFBz) or transition metal complexes may exemplarily be used as organic dopant.

The EBL may exemplarily comprise mCP (1,3-bis(carbazol-9-yl)benzene), TCTA, 2-TNATA, mCBP (3,3-di(9H-carbazol-9-yl)biphenyl), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, tris-Pcz, CzSi (9-(4-tert-butylphenyl)-3,6-bis(triphenylsilyl)-9H-carbazole), and/or DCB (N,N'-dicarbazolyl-1,4-dimethylbenzene).

In one embodiment of the invention, the emitter material $S^B$ is selected from the group consisting of a fluorescence emitter and an organic TADF emitter, whereas the organic TADF emitter is characterized in that it has a $\Delta E_{ST}$ value, which corresponds to the energy difference between $S1^S$ and $T1^S$, of less than 0.4 eV.

In a preferred embodiment, the emitter material $S^B$ is an organic TADF emitter.

In one embodiment of the invention, the relation between the lowermost excited triplet state energy level $T1^S$ of $S^B$ and the lowermost excited triplet state energy level $T1^E$ of $E^B$ expressed by formula (9) applies:

$$T1^S > T1^E \qquad (9).$$

In one embodiment of the invention, the relations expressed by $T1^S - T1^E \leq 0.4$ eV applies.

In one embodiment of the invention, the relations expressed by $T1^S - T1^E \leq 0.3$ eV applies.

In one embodiment of the invention, the relations expressed by $T1^S - T1^E \leq 0.2$ eV applies.

In a preferred embodiment, the following relation apply $S1^E > S1^S$ , $T1^S > T1^E$ and $S1^E - T1^S \leq 0.4$ eV. In other words, the lowermost excited singlet state of the TADF material $E^B$ is higher in energy than lowermost excited singlet state of the emitter material $S^B$, and the lowermost excited triplet state of the emitter material $S^B$ is higher in energy than the lowermost excited triplet state of the TADF material $E^B$. In a preferred embodiment, all four states are within a range (i.e., difference in energy) of 0.4 eV or less, preferably in a range of 0.3 eV or less, particular in a range of 0.2 eV or less.

Due to the low energy difference between the lowermost excited singlet and triplet states of the TADF materials $E^B$ and $S^B$ exciton transfer between different states of $E^B$ and $S^B$ is sufficiently enabled. In addition, transfers between states of different multiplicities may be enabled due to the low energy difference.

This may include energy transfer

(a) from a singlet state of the TADF material to the singlet state of the emitter material,
(b) from a triplet state of the TADF material to the triplet state to the emitter material,
(c) from a singlet state of the TADF material to the triplet state of the emitter material, and/or
(d) from a triplet state of the TADF material to the singlet state of the other emitter material.
(e) from a singlet state of the emitter material to the singlet state of the TADF material,
(f) from a triplet state of the emitter material to the triplet state to the TADF material,
(g) from a singlet state of the emitter material to the triplet state of the TADF material, and/or
(h) from a triplet state of the emitter material to the singlet state of the other TADF material.

Surprisingly it was found, that the main contribution to the emission band of the optoelectronic device according to the invention can be attributed to the emission of emitter material $S^B$, indicating a sufficient transfer of energy from $E^B$ to $S^B$.

In another embodiment of the invention, the relation expressed by formula (10a), (10b) or (10c) applies:

$$E^{HOMO}(H^B) > E^{HOMO}(S^B) \qquad (10a)$$

$$E^{HOMO}(S^B) > E^{HOMO}(H^B) \qquad (10b)$$

$$-0.1\ eV \leq E^{HOMO}(H^B) - E^{HOMO}(S^B) \leq 0.1\ eV \qquad (10c).$$

In a preferred embodiment, the emitter material $S^B$ has a highest occupied molecular orbital $HOMO(S^B)$ having an energy $E^{HOMO}(S^B)$ and the host compound $H^B$ has a highest occupied molecular orbital $HOMO(H^B)$ having an energy $E^{HOMO}(H^B)$, wherein $E^{HOMO}(E^B) - E^{HOMO}(H^B) \leq 0.3$ eV and $E^{HOMO}(E^B) - E^{HOMO}(H^B) > -0.3$ eV. In other words, the $HOMO(H^B)$ of the host $H^B$ can be higher or lower in energy compared to the $HOMO(S^B)$ of the emitter material $S^B$, but the difference does not exceed 0.3 eV, more preferably does not exceed 0.2 eV.

In another embodiment of the invention, the relation between the lowest unoccupied molecular orbital $LUMO(E^B)$ of $E^B$ having an energy $E^{LUMO}(E^B)$ and the lowest unoccupied molecular orbital $LUMO(S^B)$ of $S^B$ having an energy $E^{LUMO}(S^B)$ expressed by formula (11) applies:

$$E^{LUMO}(E^B) > E^{LUMO}(S^B) \qquad (11).$$

In one embodiment of the invention, the lowest unoccupied molecular orbital $LUMO(S^B)$ of $S^B$ having an energy $E^{LUMO}(S^B)$ is higher in energy than the lowest unoccupied molecular orbital $LUMO(S^B)$ of $S^B$ having an energy $E^{LUMO}(S^B)$ and the lowest unoccupied molecular orbital $LUMO(H^B)$ of $H^B$ having an energy $E^{LUMO}(H^B)$ is higher in energy than the lowest unoccupied molecular orbital $LUMO(S^B)$ of $S^B$ having an energy $E^{LUMO}(S^B)$, expressed the formulas (11) and (11a):

$$E^{LUMO}(E^B) > E^{LUMO}(S^B) \qquad (11)$$

$$E^{LUMO}(H^B) > E^{LUMO}(S^B) \qquad (11a).$$

In one embodiment of the invention, the relations expressed by one of the following formulas (11b) and (11c) applies:

$$0.2\ eV \leq E^{LUMO}(H^B) - E^{LUMO}(E^B) \leq 0.8\ eV (11b).$$

$$0.2\ eV \leq E^{LUMO}(E^B) - E^{LUMO}(S^B) \leq 0.8\ eV (11c).$$

In one embodiment of the present invention, the emitter material $S^B$ is a TADF material, i.e., one or more TADF emitter. Accordingly in an embodiment of the present invention, the emitter $S^B$ is characterized in that it has a $\Delta E_{ST}$ value, which corresponds to the energy difference between $S1^S$ and $T1^S$, of less than 0.4 eV. In a preferred embodiment of the present invention, the emitter material $S^B$ is characterized in that it has a $\Delta E_{ST}$ value of less than 0.3 eV, less than 0.2 eV, less than 0.1 eV, or even less than 0.05 eV.

In one embodiment of the present invention, the TADF material $E^B$ and the emitter material $S^B$ are both organic TADF emitters.

In one embodiment of the invention, the lowermost excited triplet state energy level $T1^S$ of the TADF material $E^B$ is between 2.2 eV and 3.5 eV, preferably between 2.3 eV and 3.2 eV, more preferably between 2.4 eV and 3.1 eV or even between 2.5 eV and 3.0 eV.

In one embodiment of the invention, the relations of the lowest unoccupied molecular orbital of the host material LUMO($H^B$), the lowest unoccupied molecular orbital of the TADF material LUMO($E^B$), and the lowest unoccupied molecular orbital of the emitter material LUMO($S^B$) expressed by the following formulas (10a) and (10b) apply:

$$E^{LUMO}(E^B) > E^{LUMO}(S^B) \qquad (10a)$$

$$E^{LUMO}(H^B) > E^{LUMO}(S^B) \qquad (10b).$$

In one embodiment of the invention, the relation expressed by the following formula (10c) applies:

$$E^{LUMO}(H^B) > E^{LUMO}(S^B) \qquad (10c).$$

In one embodiment of the present invention, the relations expressed by the following formula applies:

$$E^{LUMO}(H^B) > E^{LUMO}(E^B) > E^{LUMO}(S^B) \qquad (10d).$$

According to the invention, the emission layer B comprises at least one host material $H^B$, the TADF material $E^B$ and the emitter material $S^B$.

In a preferred embodiment of the invention, the light-emitting layer B comprises 39.8-98 %, more preferably 57-93 %, even more preferably 74-87 % by weight of the host compound $H^B$.

In a preferred embodiment of the invention, the light-emitting layer B comprises 0.1-50 %, more preferably 0.5-40 %, even more preferably 1-30 % by weight of the TADF material $E^B$.

In a preferred embodiment of the invention, the light-emitting layer B comprises 0.1-50 %, more preferably 0.5-40 %, even more preferably 1-30 % by weight of the emitter material $S^B$.

In a preferred embodiment of the invention, the emitter material $S^B$ is an organic TADF emitter, wherein the light-emitting layer B comprises 1-50 %, more preferably 5-40 %, even more preferably 10-30 % by weight of the emitter material SB.

In a preferred embodiment of the invention, the emitter material $S^B$ is a NRCT emitter, wherein the light-emitting layer B comprises 0.1-10 %, more preferably 0.5-5 %, even more preferably 1-3 % by weight of the emitter material $S^B$.

In one embodiment of the invention, the emitter material $S^B$ is a fluorescence emitter, wherein the light-emitting layer B comprises 0.1-10 %, more preferably 0.5-5 %, even more preferably 1-3 % by weight of the emitter material $S^B$.

In a preferred embodiment of the invention, the TADF material $E^B$ is an organic TADF emitter according to

Formula I-NRCT as defined in claim 1, wherein the light-emitting layer B comprises 1-50 %, more preferably 5-40 %, even more preferably 10-30 % by weight of the emitter material EB.

In a preferred embodiment of the invention, the TADF material $E^B$ is a NRCT emitter of Formula I-NRCT as defined in claim 1, wherein the light-emitting layer B comprises 0.1-10 %, more preferably 0.5-5 %, even more preferably 1-3 % by weight of the emitter material $E^B$.

In a preferred embodiment of the invention, the light-emitting layer B comprises up to 93 % by weight of one or more further host compounds $H^{B2}$ differing from $H^B$.

In a preferred embodiment of the invention, the light-emitting layer B comprises up to 93 % by weight of one or more solvents.

In a preferred embodiment of the invention, the light-emitting layer B comprises (or consists of):

(i) 39.8-98 %, more preferably 57-93 %, even more preferably 74-87 % by weight of the host compound $H^B$;
(ii) 0.1-50 %, more preferably 0.5-40 %, even more preferably 1-30 % by weight of the TADF material $E^B$; and
(iii) 0.1-50 %, more preferably 0.5-40 %, even more preferably 1-30 % by weight of the emitter material $S^B$; and optionally
(iv) 0-60 % by weight of one or more further host compounds $H^{B2}$ differing from $H^B$; and optionally
(v) 0-60 % by weight of one or more solvents.

Preferably, the contents of (i) to (v) sum up to 100 % by weight.

In a preferred embodiment, the emitter material $S^B$ and the TADF material of Formula I-NRCT as defined in claim 1 are each independently from each other a NRCT emitter, wherein the light-emitting layer B comprises (or consists of):

(i) 39.8-98 %, more preferably 57-93 %, even more preferably 74-87 % by weight of the host compound $H^B$;
(ii) 0.1-10 %, more preferably 0.5-5 %, even more preferably 1-3 % by weight of the TADF material $E^B$; and
(iii) 0.1-10 %, more preferably 0.5-5 %, even more preferably 1-3 % by weight of the emitter material $S^B$; and optionally
(iv) 0-60 % by weight of one or more further host compounds $H^{B2}$ differing from $H^B$; and optionally
(v) 0-60 % by weight of one or more solvents.

In a preferred embodiment, the emitter material $S^B$ is an organic TADF emitter and the TADF material $E^B$ is a NRCT emitter of Formula I-NRCT as defined in claim 1, wherein the light-emitting layer B comprises (or consists of):

(i) 39.8-98 %, more preferably 57-93 %, even more preferably 74-87 % by weight of the host compound $H^B$;
(ii) 0.1-10 %, more preferably 0.5-5 %, even more preferably 1-3 % by weight of the TADF material $E^B$; and
(iii) 1-50 %, more preferably 5-40 %, even more preferably 10-30 % by weight of the emitter material $S^B$; and optionally
(iv) 0-59.9 % by weight of one or more further host compounds $H^{B2}$ differing from $H^B$; and optionally
(v) 0-59.9 % by weight of one or more solvents.

In a preferred embodiment, the emitter material $S^B$ is a NRCT emitter and the TADF material $E^B$ is an organic TADF emitter of Formula I-NRCT as defined in claim 1, wherein the light-emitting layer B comprises (or consists of):

(i) 39.8-98 %, more preferably 57-93 %, even more preferably 74-87 % by weight of the host compound $H^B$;
(ii) 1-50 %, more preferably 5-40 %, even more preferably 10-30 % by weight of the TADF material $E^B$; and
(iii) 0.1-10 %, more preferably 0.5-5 %, even more preferably 1-3 % by weight of the emitter material $S^B$; and optionally
(iv) 0-59.1 % by weight of one or more further host compounds $H^{B2}$ differing from $H^B$; and optionally
(v) 0-59.1 % by weight of one or more solvents.

In a preferred embodiment, the emitter material $S^B$ is a fluorescence emitter and the TADF material $E^B$ is a NRCT emitter of Formula I-NRCT as defined in claim 1, wherein the light-emitting layer B comprises (or consists of):

(i) 39.8-98 %, more preferably 57-93 %, even more preferably 74-87 % by weight of the host compound $H^B$;
(ii) 0.1-10 %, more preferably 0.5-5 %, even more preferably 1-3 % by weight of the TADF material $E^B$; and
(iii) 0.1-10 %, more preferably 0.5-5 %, even more preferably 1-3 % by weight of the emitter material $S^B$; and optionally
(iv) 0-60 % by weight of one or more further host compounds $H^{B2}$ differing from $H^B$; and optionally
(v) 0-60 % by weight of one or more solvents.

In a preferred embodiment, the emitter material $S^B$ is a fluorescence emitter and the TADF material $E^B$ is an organic TADF emitter of Formula I-NRCT as defined in claim 1, wherein the light-emitting layer B comprises (or consists of):

(i) 39.8-98 %, more preferably 57-93 %, even more preferably 74-87 % by weight of the host compound $H^B$;
(ii) 1-50 %, more preferably 5-40 %, even more preferably 10-30 % by weight of the TADF material $E^B$; and
(iii) 0.1-10 %, more preferably 0.5-5 %, even more preferably 1-3 % by weight of the emitter material $S^B$; and optionally
(iv) 0-59.1 % by weight of one or more further host compounds $H^{B2}$ differing from $H^B$; and optionally
(v) 0-59.1 % by weight of one or more solvents.

Exemplarily, the host material $H^B$ and/or the optionally present further host compound $H^{B2}$ may be selected from the group consisting of CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). In one embodiment of the invention, the emission layer B comprises a so-called mixed-host system with at least one hole-dominant (n-type) host and one electron-dominant (p-type) host.

In one embodiment, the emission layer B comprises the first TADF material $E^B$ and the second TADF material $S^B$, and hole-dominant host $H^B$ selected from the group consisting of CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9*H*-carbazole.

As used herein, if not defined more specifically in a particular context, the designation of the colors of emitted and/or absorbed light is as follows:

| | |
|---|---|
| violet: | wavelength range of >380-420 nm; |
| deep blue: | wavelength range of >420-470 nm; |
| sky blue: | wavelength range of >470-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter compounds, such colors refer to the emission maximum $\lambda_{max}^{PMMA}$ of a poly(methyl methacrylate) (PMMA) film with typically 1 - 10% by weight of the emitter. Therefore, exemplarily, a deep blue emitter has an emission maximum $\lambda_{max}^{PMMA}$ in the range of from 420 to 470 nm, a sky blue emitter has an emission maximum $\lambda_{max}^{PMMA}$ in the range of from 470 to 500 nm, a green emitter has an emission maximum $\lambda_{max}^{PMMA}$ in a range of from 500 to 560 nm, a red emitter has an emission maximum $\lambda_{max}^{PMMA}$ in a range of from 620 to 800 nm.

In one embodiment, the TADF material $E^B$ exhibits a photoluminescence quantum yield PLQY($E^B$) and the emitter material $S^B$ exhibits a photoluminescence quantum yield PLQY($S^B$), wherein PLQY($E^B$) and PLQY($S^B$) are determined in PMMA and the following formula (12) applies

$$\mathrm{PLQY}(E^B) > \mathrm{PLQY}(S^B) \qquad (12).$$

In a preferred embodiment of the invention, The organic electroluminescent device exhibits an emission maximum $\lambda_{max}$(D) of 440 to 560 nm.

In a preferred embodiment of the invention, The organic electroluminescent device exhibits an emission maximum $\lambda_{max}$(D) of 440 to 470 nm.

In a preferred embodiment of the invention, The organic electroluminescent device exhibits an emission maximum $\lambda_{max}$(D) of 510 to 550 nm.

*Near-range-charge-transfer (NRCT) emitters*

A *Near-range-charge-transfer* (NRCT) emitter in the context of the present invention is any emitter that has an emission spectrum, which exhibits a full width at half maximum (FWHM) of less than or equal to 0.25 eV (≤ 0.25 eV), measured with 1% by weight of NRCT emitter in PMMA at room temperature (RT).

As used herein and not otherwise specified, the each spectral property determined herein is determined at a content of 1% by weight of the respective emitter in PMMA at room temperature (RT). As used herein and not otherwise

specified, the FWHM is determined at a content of 1% by weight of the respective emitter in PMMA at room temperature (RT).

In a preferred embodiment of the present invention, a NRCT emitter in the context of the present invention is any emitter that has an emission spectrum, which exhibits a FWHM of ≤ 0.24 eV, more preferably ≤ 0.23 eV, even more preferably ≤ 0.22 eV, ≤ 0.21 eV or ≤ 0.20 eV, measured with 1% by weight of NRCT emitter in PMMA at room temperature (RT). In other embodiments of the present invention, an emitter exhibits a FWHM of ≤ 0.19 eV, ≤ 0.19 eV, ≤ 0.18 eV, ≤ 0.17 eV, ≤ 0.16 eV, ≤ 0.15 eV, ≤ 0.14 eV, ≤ 0.13 eV, ≤ 0.12 eV, or ≤ 0.11 eV.

Typical NRCT emitters are described in literature by Hatakeyama et al. (Advanced Materials, 2016, 28(14):2777-2781,DOI: 10.1002/adma.201505491) to show a delayed component in the time-resolved photoluminescence spectrum and exhibits a near-range HOMO-LUMO separation as described.

Typical NRCT emitters only show one emission band in the emission spectrum, wherein typical fluorescence emitters display several distinct emission bands due to vibrational progression.

In one embodiment of the invention, the TADF material $E^B$ and/or the emitter material $S^B$ is a NRCT emitter. In one embodiment of the invention, the TADF material $E^B$ and the emitter material $S^B$ are both each a NRCT emitter. In another embodiment of the invention, the TADF material $E^B$ is no NRCT emitter. In this case, the TADF material $E^B$ is an emitter which shows TADF properties, but not the properties of a NRCT emitter as defined herein. In further embodiment of the invention, the emitter material $S^B$ is no NRCT emitter. In this case, the emitter material $S^B$ is an emitter which does not have the properties of a NRCT emitter as defined herein. In one embodiment of the invention, the emitter material $S^B$ is a fluorescent emitter. In one embodiment of the invention, the emitter material $S^B$ is a fluorescent emitter which is no NRCT emitter. In further embodiment of the invention, neither the TADF material $E^B$ nor the emitter material $S^B$ are NRCT emitters.

An NRCT emitter may, in each context of the present invention, optionally each be a boron containing NRCT emitter, in particular a blue boron containing NRCT emitter.

In a preferred embodiment, the TADF material $E^B$ is a NRCT emitter.

In one embodiment, the TADF material $E^B$ and/or the emitter material $S^B$ is a boron containing NRCT emitter.

In one embodiment, the TADF material $E^B$ and the emitter material $S^B$ is a boron containing NRCT emitter.

In a preferred embodiment, the TADF material $E^B$ is a boron containing NRCT emitter.

In one embodiment, the TADF material $E^B$ is a blue boron containing NRCT emitter.

In a preferred embodiment, a NRCT emitter comprises or consists of a polycyclic aromatic compound.

TADF material $E^B$ of Formula I-NRCT as defined in claim 1 and the emitter material $S^B$ comprises or consists of a polycyclic aromatic compound.

In a preferred embodiment, the emission spectrum of a film with 1 % by weight of the TADF material $E^B$ has a full width at half maximum (FWHM), which is smaller than 0.2 eV.

In a preferred embodiment, the TADF material $E^B$ is a boron containing emitter with an emission spectrum of a film with 1 % by weight of the TADF material $E^B$, which has a full width at half maximum (FWHM), which is smaller than 0.2 eV.

In a preferred embodiment, the TADF material $E^B$ is a blue boron containing emitter with an emission spectrum of a film with 1 % by weight of the TADF material $E^B$, which has a full width at half maximum (FWHM), which is smaller than 0.2 eV.

In a preferred embodiment, the TADF material $E^B$ comprises or consists of a polycyclic aromatic compound with an emission spectrum of a film with 1 % by weight of the TADF material $E^B$, which has a full width at half maximum (FWHM), which is smaller than 0.2 eV.

In an embodiment not forming part of the claimed invention, the TADF material $E^B$ comprises or consists of a polycyclic aromatic compound according to formula (1) or (2) or a specific example described in US-A 2015/236274. US-A 2015/236274 also describes examples for synthesis of such compounds.

According to the claimed invention, the TADF material $E^B$ comprises or consists of a structure according to Formula I:

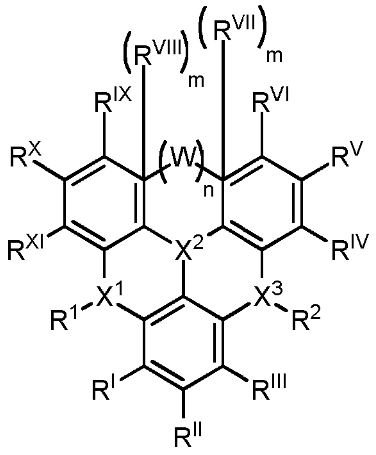

Formula I

Wherein n is 0 or 1.

m = 1-n.
$X^1$ is N or B.
$X^2$ is N or B.
$X^3$ is N or B.
W is selected from the group consisting of $Si(R^3)_2$, $C(R^3)_2$ and $BR^3$.
each of $R^1$, $R^2$ and $R^3$ is independently from each other selected from the group consisting of:

$C_1$-$C_5$-alkyl, which is optionally substituted with one or more substituents $R^6$;

$C_6$-$C_{60}$-aryl, which is optionally substituted with one or more substituents $R^6$; and

$C_3$-$C_{57}$-heteroaryl, which is optionally substituted with one or more substituents $R^6$;

each of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ is independently from another selected from the group consisting of: hydrogen, deuterium, $N(R^5)_2$, $OR^5$, $Si(R^5)_3$, $B(OR^5)_2$, $OSO_2R^5$, $CF_3$, CN, halogen,

$C_1$-$C_{40}$-alkyl, which is optionally substituted with one or more substituents $R^5$ and wherein one or more non-adjacent $CH_2$-groups are each optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-alkoxy, which is optionally substituted with one or more substituents $R^5$ and wherein one or more non-adjacent $CH_2$-groups are each optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_1$-$C_{40}$-thioalkoxy, which is optionally substituted with one or more substituents $R^5$ and wherein one or more non-adjacent $CH_2$-groups are each optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkenyl, which is optionally substituted with one or more substituents $R^5$ and wherein one or more non-adjacent $CH_2$-groups are each optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_2$-$C_{40}$-alkynyl, which is optionally substituted with one or more substituents $R^5$ and wherein one or more non-adjacent $CH_2$-groups are each optionally substituted by $R^5C=CR^5$, C=C, $Si(R^5)_2$, $Ge(R^5)_2$, $Sn(R^5)_2$, C=O, C=S, C=Se, $C=NR^5$, $P(=O)(R^5)$, SO, $SO_2$, $NR^5$, O, S or $CONR^5$;

$C_6$-$C_{60}$-aryl, which is optionally substituted with one or more substituents $R^5$; and

$C_3$-$C_{57}$-heteroaryl, which is optionally substituted with one or more substituents $R^5$.

$R^5$ is at each occurrence independently from another selected from the group consisting of: hydrogen, deuterium, OPh, $CF_3$, CN, F,

$C_1$-$C_5$-alkyl, wherein optionally one or more hydrogen atoms are independently from each other substituted by deuterium, CN, $CF_3$, or F;

$C_1$-$C_5$-alkoxy, wherein optionally one or more hydrogen atoms are independently from each other substituted by deuterium, CN, $CF_3$, or F;

$C_1$-$C_5$-thioalkoxy, wherein optionally one or more hydrogen atoms are independently from each other substituted by deuterium, CN, $CF_3$, or F;

$C_2$-$C_5$-alkenyl, wherein optionally one or more hydrogen atoms are independently from each other substituted by deuterium, CN, $CF_3$, or F;

$C_2$-$C_5$-alkynyl, wherein optionally one or more hydrogen atoms are independently from each other substituted by deuterium, CN, $CF_3$, or F;

$C_6$-$C_{18}$-aryl, which is optionally substituted with one or more $C_1$-$C_5$-alkyl substituents;

$C_3$-$C_{17}$-heteroaryl, which is optionally substituted with one or more $C_1$-$C_5$-alkyl substituents;

$N(C_6$-$C_{18}$-aryl$)_2$,

$N(C_3$-$C_{17}$-heteroaryl$)_2$; and

$N(C_3$-$C_{17}$-heteroaryl$)(C_6$-$C_{18}$-aryl).

$R^6$ is at each occurrence independently from another selected from the group consisting of hydrogen, deuterium, OPh, $CF_3$, CN, F,

$C_1$-$C_5$-alkyl, wherein optionally one or more hydrogen atoms are independently from each other substituted by deuterium, CN, $CF_3$, or F;

$C_1$-$C_5$-alkoxy, wherein optionally one or more hydrogen atoms are independently from each other substituted by deuterium, CN, $CF_3$, or F;

$C_1$-$C_5$-thioalkoxy, wherein optionally one or more hydrogen atoms are independently from each other substituted by deuterium, CN, $CF_3$, or F;

$C_2$-$C_5$-alkenyl, wherein optionally one or more hydrogen atoms are independently from each other substituted by deuterium, CN, $CF_3$, or F;

$C_2$-$C_5$-alkynyl, wherein optionally one or more hydrogen atoms are independently from each other substituted by deuterium, CN, $CF_3$, or F;

$C_6$-$C_{18}$-aryl, which is optionally substituted with one or more $C_1$-$C_5$-alkyl substituents;

$C_3$-$C_{17}$-heteroaryl, which is optionally substituted with one or more $C_1$-$C_5$-alkyl substituents;

$N(C_6$-$C_{18}$-aryl$)_2$,

$N(C_3$-$C_{17}$-heteroaryl$)_2$; and

$N(C_3$-$C_{17}$-heteroaryl$)(C_6$-$C_{18}$-aryl).

According to a preferred embodiment, two or more of the substituents selected from the group consisting of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ that are positioned adjacent to another may each form a mono- or

polycyclic, aliphatic, aromatic and/or benzo-fused ring system with another.

According to a preferred embodiment, at least one of $X^1$, $X^2$ and $X^3$ is B and at least one of $X^1$, $X^2$ and $X^3$ is N.

According to a preferred embodiment of the invention, at least one substituent selected from the group consisting of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ optionally forms a mono- or polycyclic, aliphatic, aromatic and/or benzo-fused ring system with one or more substituents of the same group that is/are positioned adjacent to the at least one substituent.

According to a preferred embodiment of the invention, at least one of $X^1$, $X^2$ and $X^3$ is B and at least one of $X^1$, $X^2$ and $X^3$ is N.

In one embodiment, the TADF material $E^B$ comprises or consists of a structure according to Formula 1 and n = 0.

In one embodiment, each of $R^1$ and $R^2$ is each independently from each other selected from the group consisting of

$C_1$-$C_5$-alkyl, which is optionally substituted with one or more substituents $R^6$;

$C_6$-$C_{30}$-aryl, which is optionally substituted with one or more substituents $R^6$; and

$C_3$-$C_{30}$-heteroaryl, which is optionally substituted with one or more substituents $R^6$.

In one embodiment, $R^1$ and $R^2$ is each independently from each other selected from the group consisting of Me, $^i$Pr, $^t$Bu, CN, $CF_3$,

Ph, which is optionally substituted with one or more substituents independently from each other selected from the group consisting of Me, $^i$Pr, $^t$Bu, CN, $CF_3$, and Ph;
pyridinyl, which is optionally substituted with one or more substituents independently from each other selected from the group consisting of Me, $^i$Pr, $^t$Bu, CN, $CF_3$, and Ph;
pyrimidinyl, which is optionally substituted with one or more substituents independently from each other selected from the group consisting of Me, ’Pr, $^t$Bu, CN, $CF_3$, and Ph; and
triazinyl, which is optionally substituted with one or more substituents independently from each other selected from the group consisting of Me, $^i$Pr, $^t$Bu, CN, $CF_3$, and Ph.

In one embodiment, each of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ is independently from another selected from the group consisting of: hydrogen, deuterium, halogen, Me, $^i$Pr, $^t$Bu, CN, $CF_3$,

Ph, which is optionally substituted with one or more substituents independently from each other selected from the group consisting of Me, $^i$Pr, $^t$Bu, CN, $CF_3$, and Ph;
pyridinyl, which is optionally substituted with one or more substituents independently from each other selected from the group consisting of Me, $^i$Pr, $^t$Bu, CN, $CF_3$, and Ph;
pyrimidinyl, which is optionally substituted with one or more substituents independently from each other selected from the group consisting of Me, $^i$Pr, $^t$Bu, CN, $CF_3$, and Ph;
carbazolyl, which is optionally substituted with one or more substituents independently from each other selected from the group consisting of Me, $^i$Pr, $^t$Bu, CN, $CF_3$, and Ph;
triazinyl, which is optionally substituted with one or more substituents independently from each other selected from the group consisting of Me, $^i$Pr, $^t$Bu, CN, $CF_3$, and Ph;
and $N(Ph)_2$.

In one embodiment, each of $R^I$, $R^{II}$, $R^{III}$, $R^{IV}$, $R^V$, $R^{VI}$, $R^{VI}$, $R^{VIII}$, $R^{IX}$, $R^X$, and $R^{XI}$ is independently from another selected from the group consisting of: hydrogen, deuterium, halogen, Me, $^i$Pr, $^t$Bu, CN, $CF_3$,

Ph, which is optionally substituted with one or more substituents independently from each other selected from the group consisting of Me, $^i$Pr, $^t$Bu, CN, $CF_3$, and Ph;
pyridinyl, which is optionally substituted with one or more substituents independently from each other selected from the group consisting of Me, $^i$Pr, $^t$Bu, CN, $CF_3$, and Ph;
pyrimidinyl, which is optionally substituted with one or more substituents independently from each other selected from the group consisting of Me, $^i$Pr, $^t$Bu, CN, $CF_3$, and Ph;
carbazolyl, which is optionally substituted with one or more substituents independently from each other selected from the group consisting of Me, $^i$Pr, $^t$Bu, CN, $CF_3$, and Ph;
triazinyl, which is optionally substituted with one or more substituents independently from each other selected from the group consisting of Me, $^i$Pr, $^t$Bu, CN, $CF_3$, and Ph;

and $N(Ph)_2$; and
$R^1$ and $R^2$ is each independently from each other selected from the group consisting of

$C_1$-$C_5$-alkyl, which is optionally substituted with one or more substituents $R^6$;
$C_6$-$C_{30}$-aryl, which is optionally substituted with one or more substituents $R^6$; and
$C_3$-$C_{30}$-heteroaryl, which is optionally substituted with one or more substituents $R^6$.

In one embodiment of the invention, the emitter material $S^B$ is a near-range-charge-transfer (NRCT) emitter. According to the invention, a NRCT material shows a delayed component in the time-resolved photoluminescence spectrum and exhibits a near-range HOMO-LUMO separation as described by Hatakeyama et al. (Advanced Materials, 2016, 28(14):2777-2781,DOI: 10.1002/adma.201505491).

In one embodiment, the emitter material $S^B$ is a boron containing NRCT emitter.

In one embodiment, the emitter material $S^B$ is a blue boron containing NRCT emitter.

In a preferred embodiment, the emitter material $S^B$ comprises or consists of a polycyclic aromatic compound.

In a preferred embodiment, the emission spectrum of a film with 1 % by weight of the emitter material $S^B$ has a full width at half maximum (FWHM), which is smaller than 0.2 eV.

In a preferred embodiment, the emitter material $S^B$ is a boron containing emitter with an emission spectrum of a film with 1 % by weight of the emitter material $S^B$, which has a full width at half maximum (FWHM), which is smaller than 0.2 eV.

In a preferred embodiment, the emitter material $S^B$ is a blue boron containing emitter with an emission spectrum of a film with 1 % by weight of the emitter material $S^B$, which has a full width at half maximum (FWHM), which is smaller than 0.2 eV.

In a preferred embodiment, the emitter material $S^B$ comprises or consists of a polycyclic aromatic compound with an emission spectrum of a film with 1 % by weight of , the emitter material $S^B$, which has a full width at half maximum (FWHM), which is smaller than 0.2 eV.

In a preferred embodiment, the emitter material $S^B$ comprises or consists of a polycyclic aromatic compound according to formula (1) or (2) or a specific example described in US-A 2015/236274. US-A 2015/236274 also describes examples for synthesis of such compounds.

In one embodiment, the emitter material $S^B$ comprises or consists of a structure according to Formula I.

In a one embodiment, the TADF material $E^B$ and/or the emitter material $S^B$ is a blue boron-containing NRCT emitter selected from the following group:

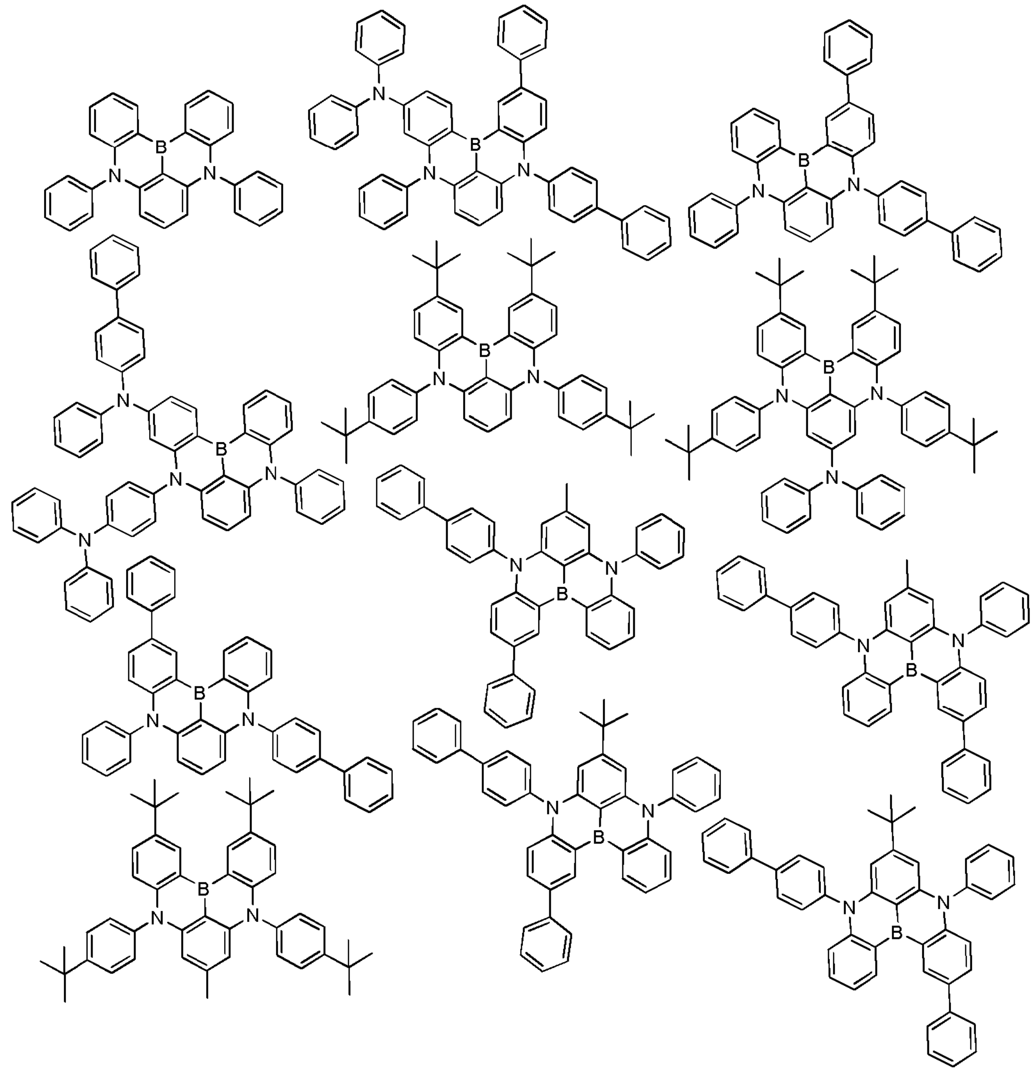

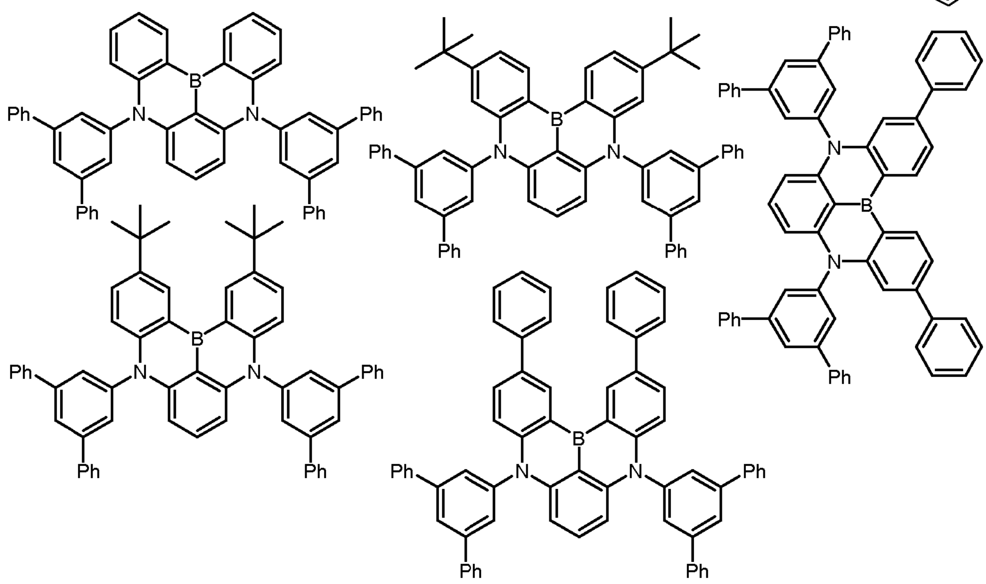

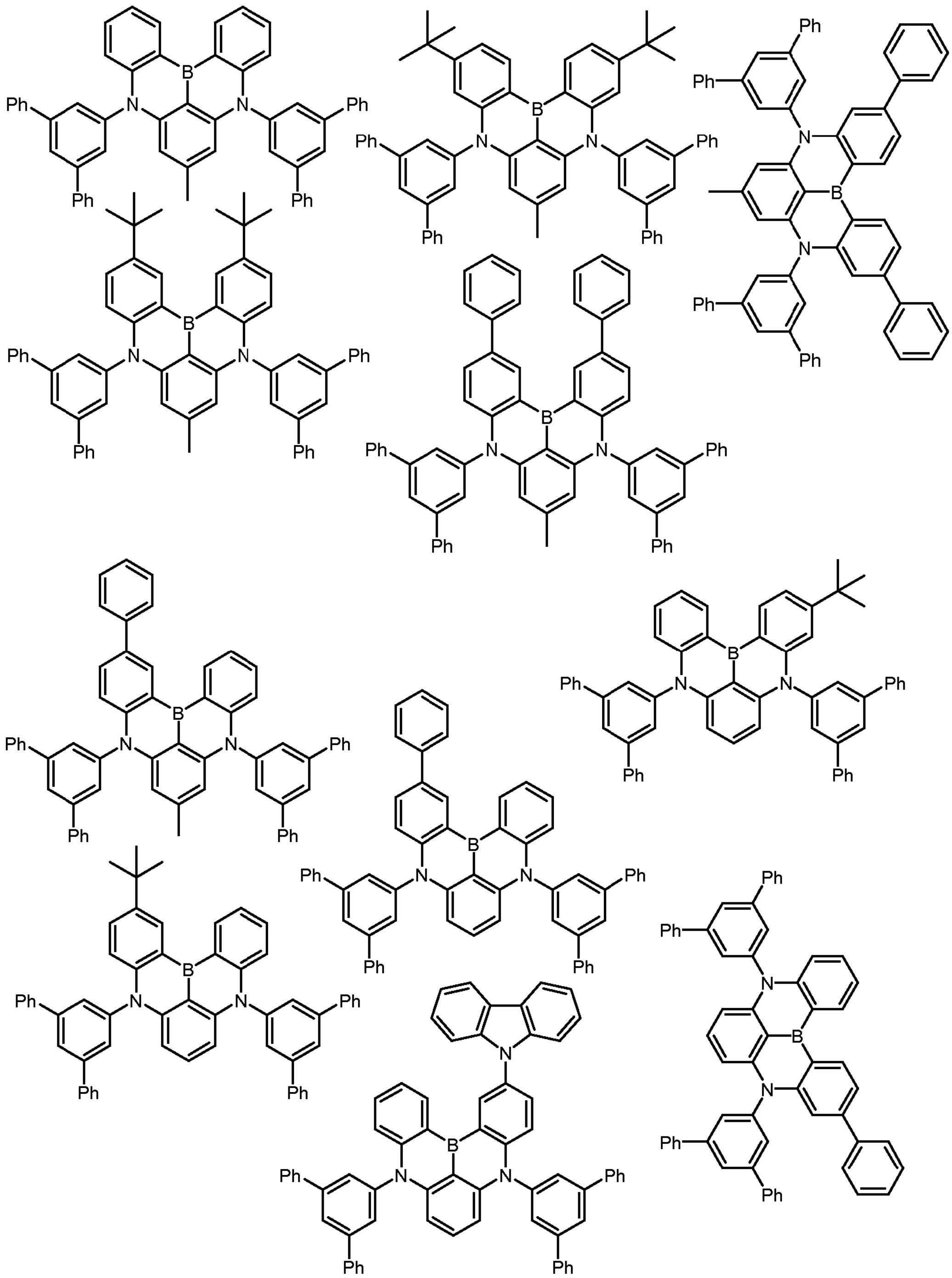

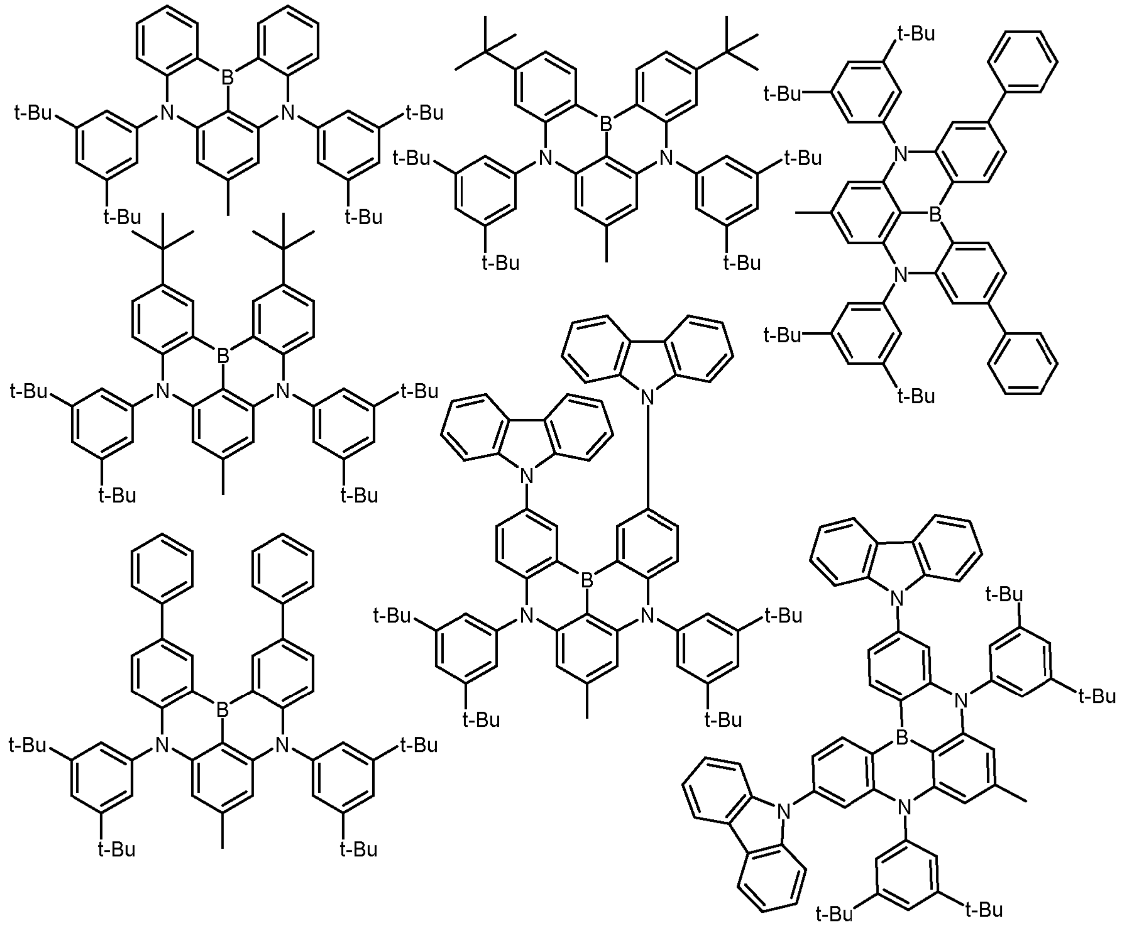

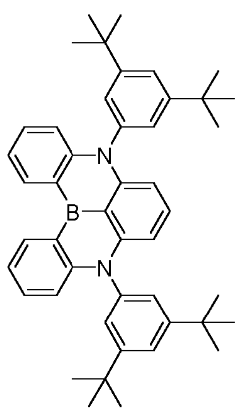

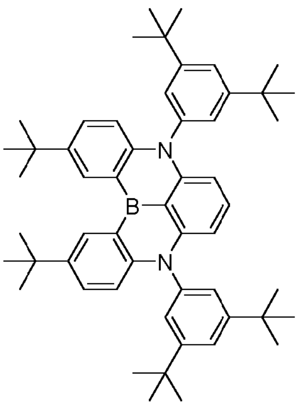

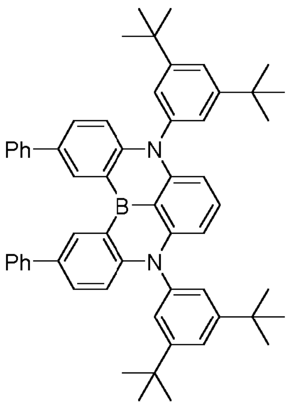

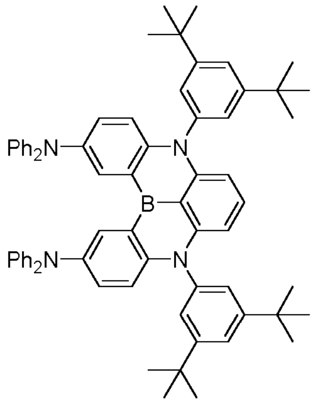

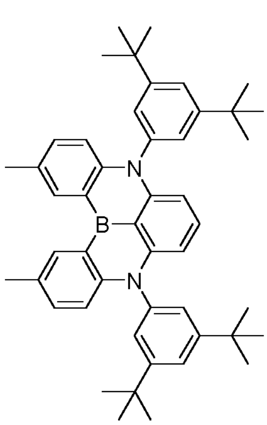

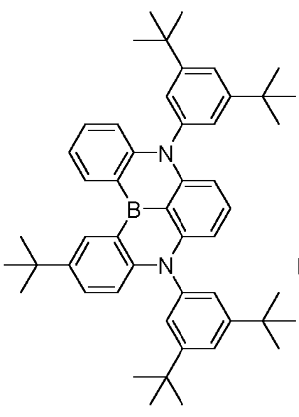

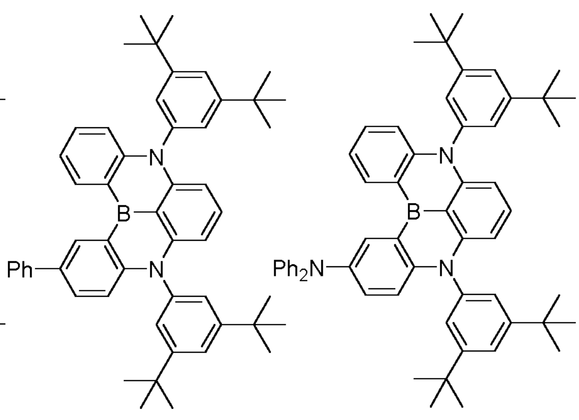

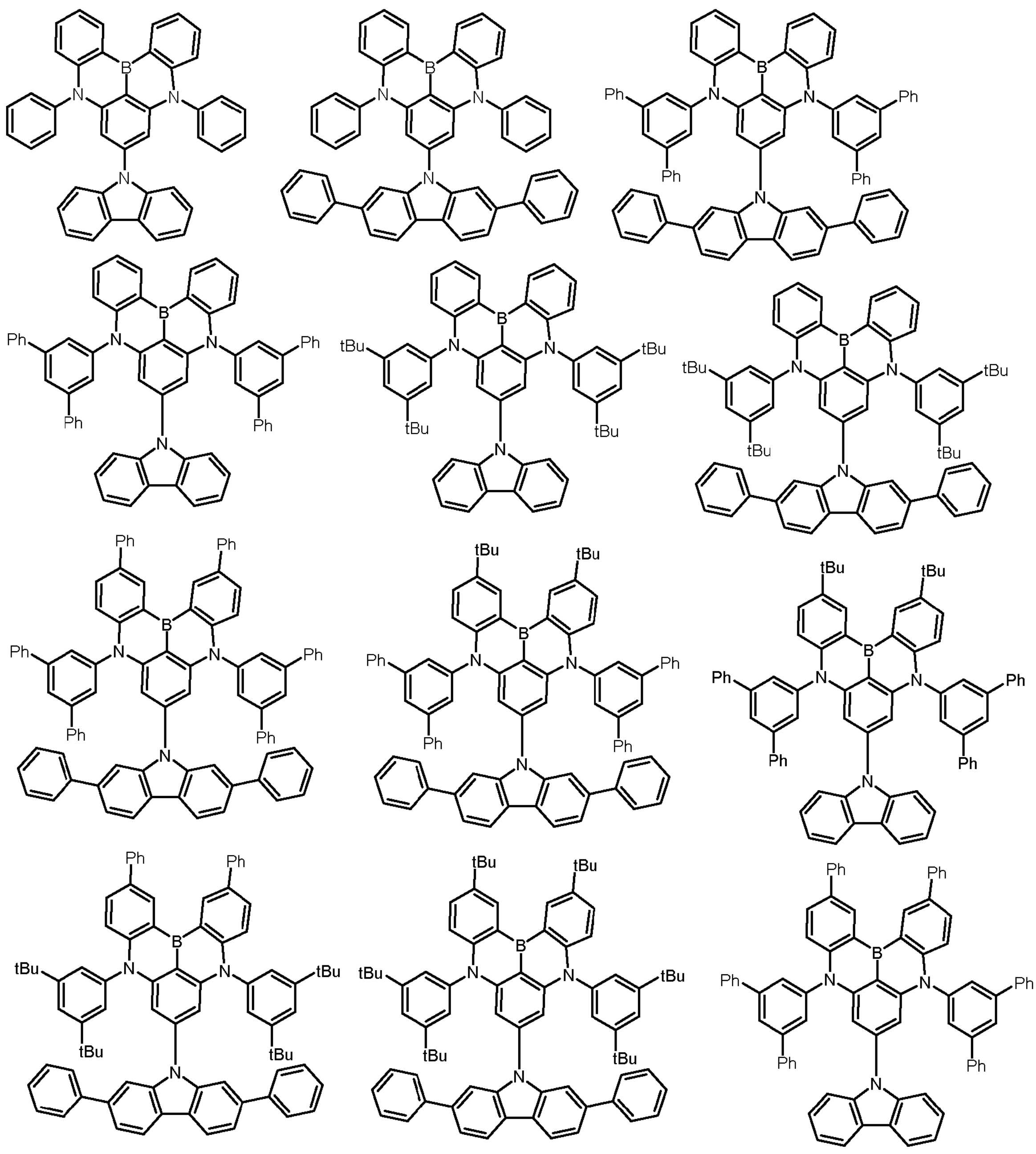

In a one embodiment, the TADF material $E^B$ and/or the emitter material $S^B$ is a green boron-containing NRCT emitter selected from the following group:

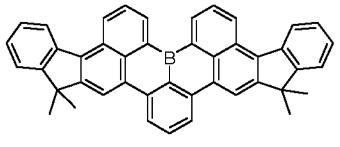

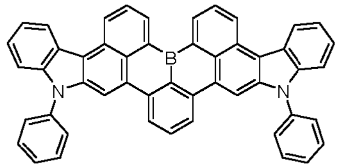

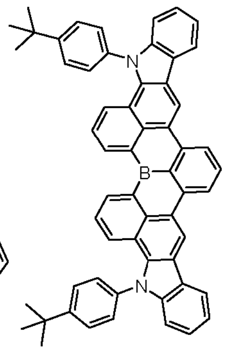

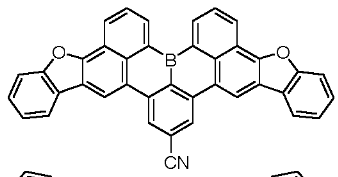

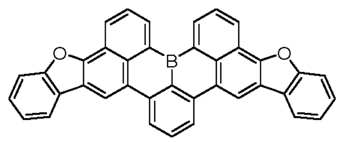

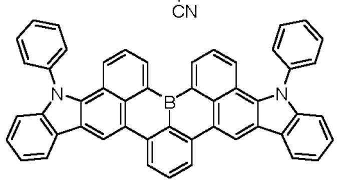

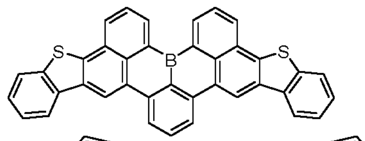

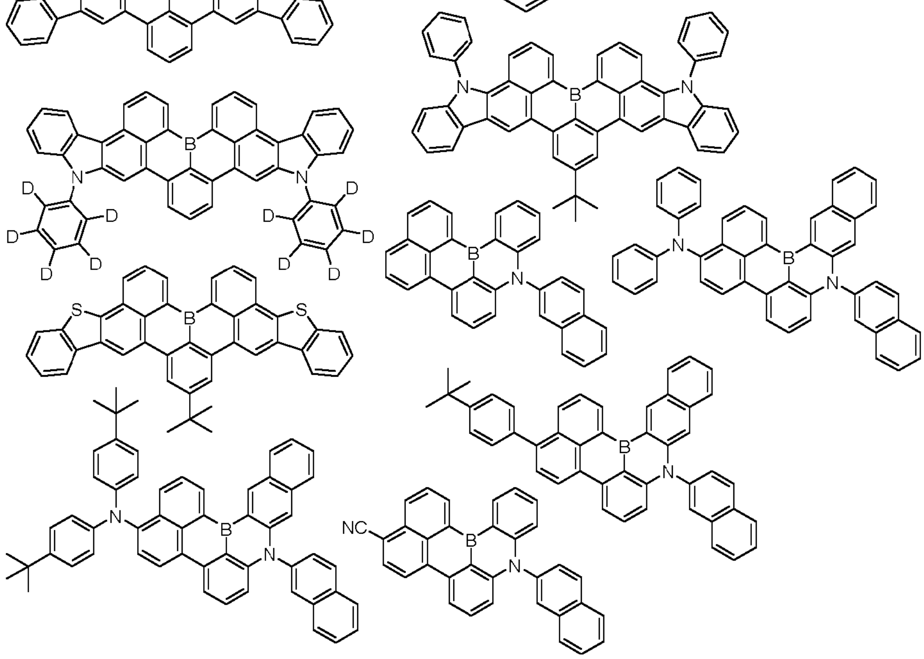

*Organic TADF emitters*

In a preferred embodiment, the TADF material $E^B$ and/or the emitter material $S^B$ is an organic TADF material. According to the invention, organic emitter or organic material means that the emitter or material (predominantly) consists of the elements hydrogen (H), carbon (C), nitrogen (N), boron (B), silicon (Si) and optionally fluorine (F), optionally bromine (Br) and optionally oxygen (O). Particularly preferably, it does not contain any transition metals.

In a preferred embodiment, the TADF material $E^B$ is an organic TADF material. In a preferred embodiment, the emitter material $S^B$ is an organic emitter. In a more preferred embodiment, the TADF material $E^B$ and the emitter material $S^B$ are both organic TADF materials.

In a preferred embodiment, the TADF material $E^B$ is a material of Formula I-NRCT as defined in claim 1 and the emitter material $S^B$ is an organic TADF material, which is chosen from molecules of a structure of Formula I-TADF

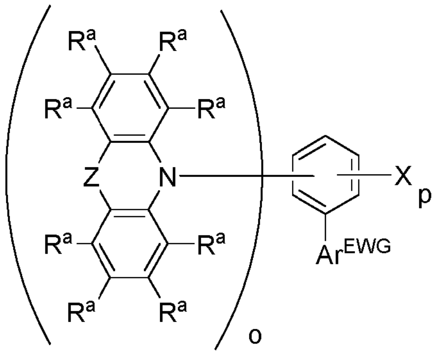

Formula I-TADF

wherein

o is at each occurrence independently from another 1 or 2;
p is at each occurrence independently from another 1 or 2;
X is at each occurrence independently from another selected $Ar^{EWG}$, H, CN or $CF_3$;
Z is at each occurrence independently from another selected from the group consisting of a direct bond, $CR^3R^4$, $C{=}CR^3R^4$, C=O, $C{=}NR^3$, $NR^3$, O, $SiR^3R^4$, S, S(O) and $S(O)_2$;
$Ar^{EWG}$ is at each occurrence independently from another a structure according to one of Formulas IIa to IIk

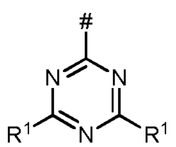

Formula IIa

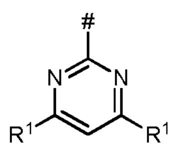

Formula IIb

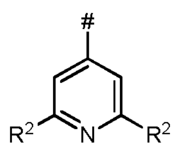

Formula IIc

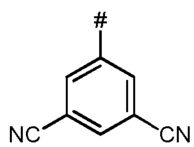

Formula IId

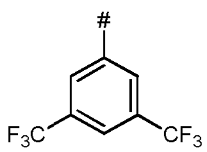

Formula IIe

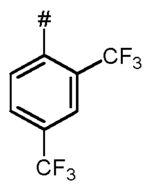

Formula IIf

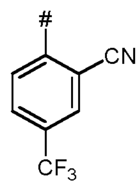

Formula IIg

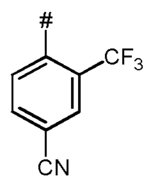

Formula IIh

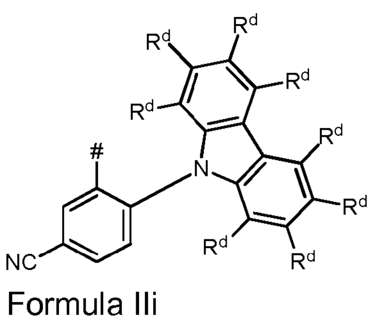

Formula IIi

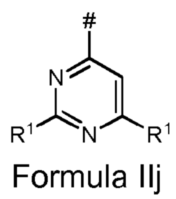

Formula IIj

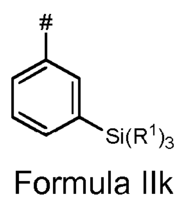

Formula IIk

wherein # represents the binding site of the single bond linking $Ar^{EWG}$ to the substituted central phenyl ring of Formula I-TADF;
$R^1$ is at each occurrence independently from another selected from the group consisting of hydrogen, deuterium, $C_1$-$C_5$-alkyl, wherein one or more hydrogen atoms are optionally substituted by deuterium, and $C_6$-$C_{18}$-aryl, which is optionally substituted with one or more substituents $R^6$;
$R^2$ is at each occurrence independently from another selected from the group consisting of hydrogen, deuterium,

$C_1$-$C_5$-alkyl, wherein one or more hydrogen atoms are optionally substituted by deuterium, and $C_6$-$C_{18}$-aryl, which is optionally substituted with one or more substituents $R^6$;
$R^a$, $R^3$ and $R^4$ is at each occurrence independently from another selected from the group consisting of hydrogen, deuterium, $N(R^5)_2$, $OR^5$,
$SR^5$, $Si(R^5)_3$, $CF_3$, CN, F,
$C_1$-$C_{40}$-alkyl which is optionally substituted with one or more substituents $R^5$ and wherein one or more non-adjacent $CH_2$-groups are optionally substituted by $R^5C$=$CR^5$, C=C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S or $CONR^5$;
$C_1$-$C_{40}$-thioalkoxy which is optionally substituted with one or more substituents $R^5$ and wherein one or more non-adjacent $CH_2$-groups are optionally substituted by $R^5C$=$CR^5$, C=C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S or $CONR^5$; and
$C_6$-$C_{60}$-aryl which is optionally substituted with one or more substituents $R^5$; $C_3$-$C_{57}$-heteroaryl which is optionally substituted with one or more substituents $R^5$;
$R^5$ is at each occurrence independently from another selected from the group consisting of hydrogen, deuterium, $N(R^6)_2$, $OR^6$, $SR^6$, $Si(R^6)_3$, $CF_3$, CN, F,
$C_1$-$C_{40}$-alkyl which is optionally substituted with one or more substituents $R^6$ and wherein one or more non-adjacent $CH_2$-groups are optionally substituted by $R^6C$=$CR^6$, C=C, $Si(R^6)_2$, $Ge(R^6)_2$, $Sn(R^6)_2$, C=O, C=S, C=Se, C=$NR^6$, P(=O)($R^6$), SO, $SO_2$, $NR^6$, O, S or $CONR^6$;
$C_6$-$C_{60}$-aryl which is optionally substituted with one or more substituents $R^6$; and $C_3$-$C_{57}$-heteroaryl which is optionally substituted with one or more substituents $R^6$;
$R^6$ is at each occurrence independently from another selected from the group consisting of hydrogen, deuterium, OPh, $CF_3$, CN, F,
$C_1$-$C_5$-alkyl, wherein one or more hydrogen atoms are optionally, independently from each other substituted by deuterium, CN, $CF_3$, or F;
$C_1$-$C_5$-alkoxy,
wherein one or more hydrogen atoms are optionally, independently from each other substituted by deuterium, CN, $CF_3$, or F;
$C_1$-$C_5$-thioalkoxy, wherein one or more hydrogen atoms are optionally, independently from each other substituted by deuterium, CN, $CF_3$, or F;
$C_6$-$C_{18}$-aryl which is optionally substituted with one or more $C_1$-$C_5$-alkyl substituents;
$C_3$-$C_{17}$-heteroaryl which is optionally substituted with one or more $C_1$-$C_5$-alkyl substituents;
$N(C_6$-$C_{18}$-aryl$)_2$;
$N(C_3$-$C_{17}$-heteroaryl$)_2$, and
$N(C_3$-$C_{17}$-heteroaryl)($C_6$-$C_{18}$-aryl);
$R^d$ is at each occurrence independently from another selected from the group consisting of hydrogen, deuterium, $N(R^5)_2$, $OR^5$,
$SR^5$, $Si(R^5)_3$, $CF_3$, CN, F,
$C_1$-$C_{40}$-alkyl which is optionally substituted with one or more substituents $R^5$ and wherein one or more non-adjacent $CH_2$-groups are optionally substituted by $R^5C$=$CR^5$, C=C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S or $CONR^5$;
$C_1$-$C_{40}$-thioalkoxy which is optionally substituted with one or more substituents $R^5$ and wherein one or more non-adjacent $CH_2$-groups are optionally substituted by $R^5C$=$CR^5$, C=C, $Si(R^5)_2$, $Ge(R^5)_2$, $Sn(R^5)_2$, C=O, C=S, C=Se, C=$NR^5$, P(=O)($R^5$), SO, $SO_2$, $NR^5$, O, S or $CONR^5$; and
$C_6$-$C_{60}$-aryl which is optionally substituted with one or more substituents $R^5$; $C_3$-$C_{57}$-heteroaryl which is optionally substituted with one or more substituents $R^5$;
wherein the substituents $R^a$, $R^3$, $R^4$ or $R^5$ independently from each other optionally may form a mono- or polycyclic, aliphatic, aromatic and/or benzo-fused ring system with one or more substituents $R^a$, $R^3$, $R^4$ or $R^5$ and wherein the one or more substituents $R^d$ independently from each other optionally may form a mono- or polycyclic, aliphatic, aromatic and/or benzo-fused ring system with one or more substituents $R^d$.

According to the invention, the substituents $R^a$, $R^3$, $R^4$ or $R^5$ at each each occurrence independently from each other may optionally form a mono- or polycyclic, aliphatic, aromatic and/or benzo-fused ring system with one or more substituents $R^a$, $R^3$, $R^4$ or $R^5$.

According to the invention, the substituents $R^d$ at each occurrence independently from each other may optionally form a mono- or polycyclic, aliphatic, aromatic and/or benzo-fused ring system with one or more other substituents $R^d$.

In a particularly preferred embodiment of the invention, Z is a direct bond at each occurrence.

In an embodiment not forming part of the claimed invention, the TADF material $E^B$ is an organic TADF material, which is chosen from molecules of a structure of Formula I-TADF.

In an embodiment not forming part of the claimed invention, the TADF material $E^B$ comprises at least one triazine structure according to Formula IIa.

In an embodiment not forming part of the claimed invention, the TADF material $E^B$ is an organic TADF material, which is chosen from molecules of a structure of Formula II-TADF

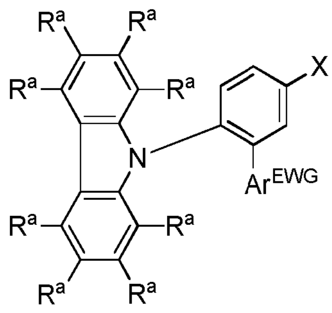

Formula II-TADF.

$R^a$ is at each occurrence independently from another selected from the group consisting of hydrogen, deuterium, Me, $^iPr$, $^tBu$, CN, $CF_3$,
Ph, which is optionally substituted with one or more substituents independently from each other selected from the group consisting of Me, $^iPr$, $^tBu$, CN, $CF_3$ and Ph;
pyridinyl, which is optionally substituted with one or more substituents independently from each other selected from the group consisting of Me, $^iPr$, $^tBu$, CN, $CF_3$ and Ph;
pyrimidinyl, which is optionally substituted with one or more substituents independently from each other selected from the group consisting of Me, $^iPr$, $^tBu$, CN, $CF_3$ and Ph;
carbazolyl, which is optionally substituted with one or more substituents independently from each other selected from the group consisting of Me, $^iPr$, $^tBu$, CN, $CF_3$ and Ph;
triazinyl, which is optionally substituted with one or more substituents independently from each other selected from the group consisting of Me, $^iPr$, $^tBu$, CN, $CF_3$ and Ph; and $N(Ph)_2$.

$R^d$ is at each occurrence independently from another selected from the group consisting of hydrogen, deuterium, Me, $^iPr$, $^tBu$, CN, $CF_3$,

Ph, which is optionally substituted with one or more substituents independently from each other selected from the group consisting of Me, $^iPr$, $^tBu$, CN, $CF_3$ and Ph;
pyridinyl, which is optionally substituted with one or more substituents independently from each other selected from the group consisting of Me, $^iPr$, $^tBu$, CN, $CF_3$ and Ph;
pyrimidinyl, which is optionally substituted with one or more substituents independently from each other selected from the group consisting of Me, $^iPr$, $^tBu$, CN, $CF_3$ and Ph;
carbazolyl, which is optionally substituted with one or more substituents independently from each other selected from the group consisting of Me, $^iPr$, $^tBu$, CN, $CF_3$ and Ph;
triazinyl, which is optionally substituted with one or more substituents independently from each other selected from the group consisting of Me, $^iPr$, $^tBu$, CN, $CF_3$ and Ph; and $N(Ph)_2$.

Preferably X is CN.

In an embodiment not forming part of the claimed invention, the TADF material $E^B$ is chosen from a structure of Formula III:

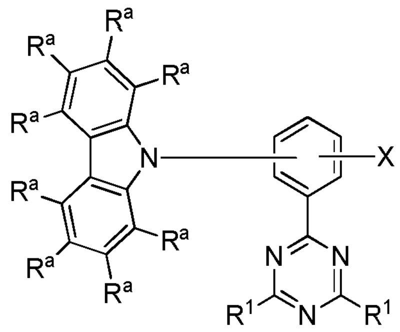

(Formula III),

wherein $R^a$, X and $R^1$ are defined as above.

In an embodiment not forming part of the claimed invention, $E^B$ is chosen from molecules of a structure of Formula IIIa:

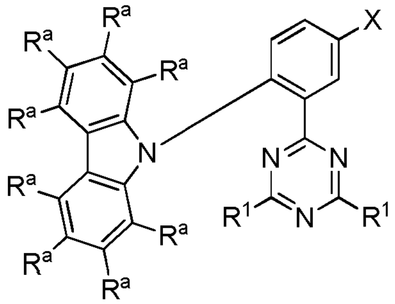

(Formula IIIa),

wherein $R^a$, X and $R^1$ are defined as above.

In an embodiment not forming part of the claimed invention, $E^B$ is chosen from molecules of a structure of Formula IIIa-1:

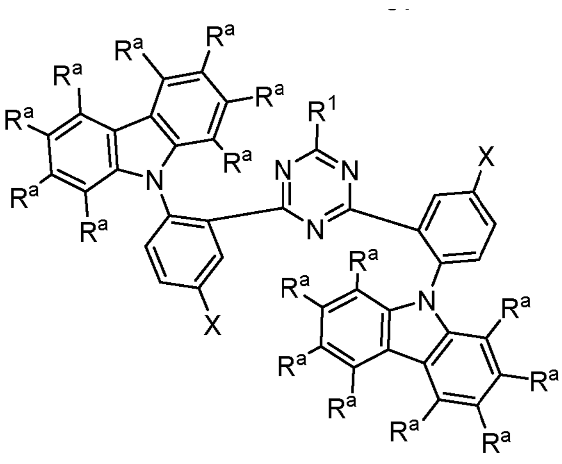

(Formula IIIa-1),

wherein $R^a$, X and $R^1$ are defined as above.

In an embodiment not forming part of the claimed invention, $E^B$ is chosen from molecules of a structure of Formula IIIa-2:

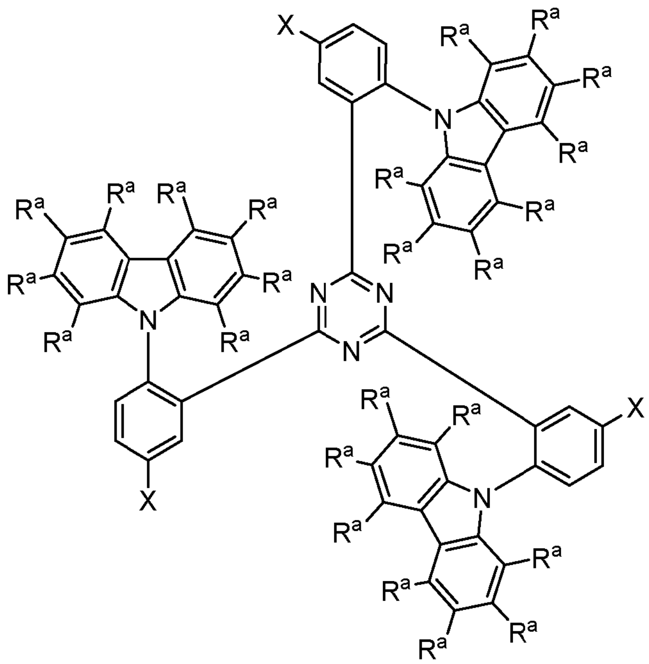

(Formula IIIa-2),

wherein $R^a$, X and $R^1$ are defined as above.

In an embodiment not forming part of the claimed invention, $E^B$ is chosen from molecules of a structure of Formula IIIb:

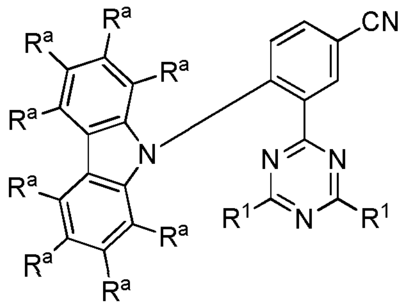

(Formula IIIb),

wherein $R^a$ and $R^1$ are defined as above.

In an embodiment not forming part of the claimed invention, $E^B$ is chosen from molecules of a structure of Formula IIIa-1:

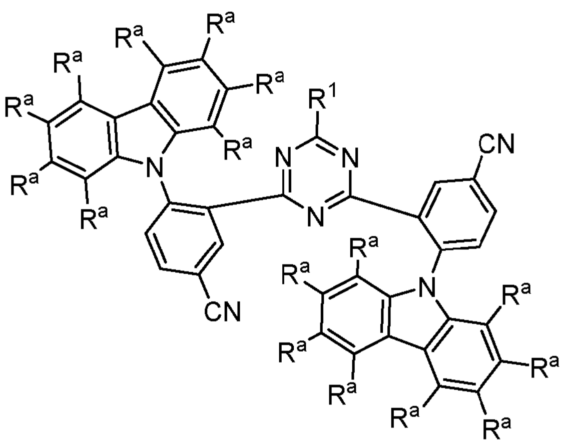

(Formula IIIb-1),

wherein $R^a$ and $R^1$ are defined as above.

In an embodiment not forming part of the claimed invention, $E^B$ is chosen from molecules of a structure of Formula IIIc:

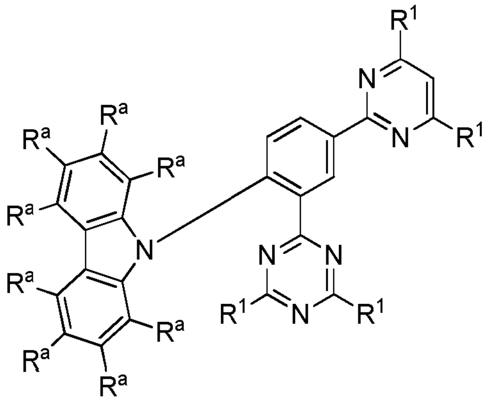

(Formula IIIc),

wherein $R^a$ and $R^1$ are defined as above.

In an embodiment not forming part of the claimed invention, $E^B$ is chosen from molecules of a structure of Formula IIId:

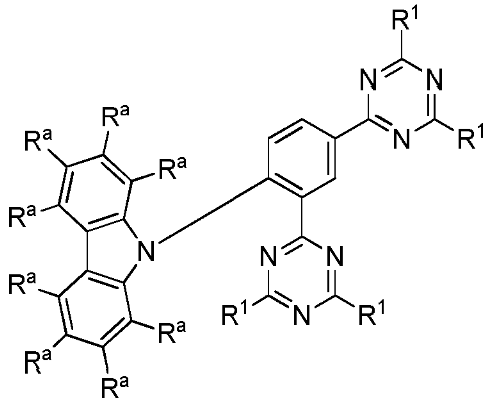

(Formula IIId),

wherein $R^a$ and $R^1$ are defined as above.

In an embodiment not forming part of the claimed invention, $E^B$ is chosen from molecules of a structure of Formula IV:

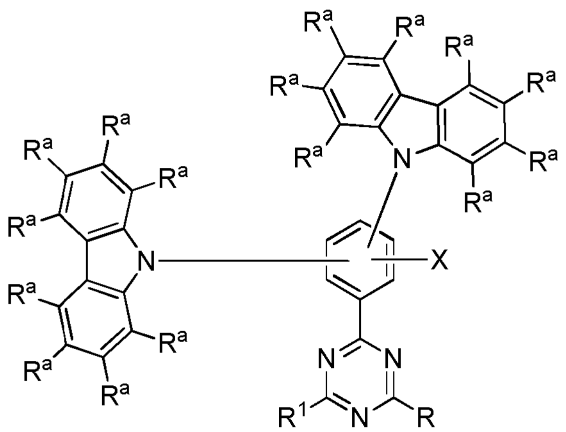

(Formula IV),

wherein $R^a$, $R^1$ and X are defined as above.

In an embodiment not forming part of the claimed invention, $E^B$ is chosen from molecules of a structure of Formula IVa:

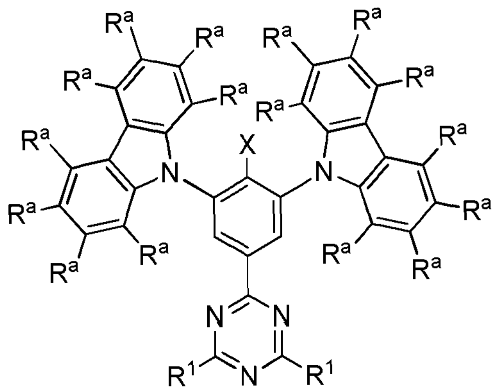

(Formula IVa),

wherein $R^a$, $R^1$ and X are defined as above.

In an embodiment not forming part of the claimed invention, $E^B$ is chosen from molecules of a structure of Formula IVb:

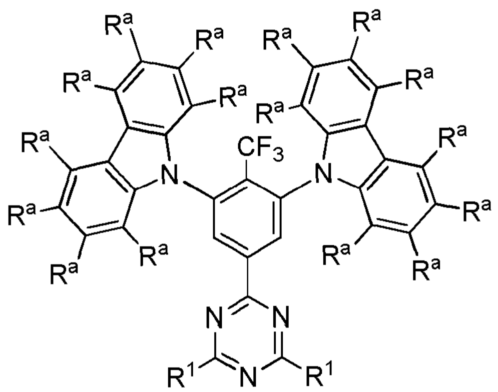

(Formula IVb),

wherein $R^a$ and $R^1$ are defined as above.

In an embodiment not forming part of the claimed invention, $E^B$ is chosen from molecules of a structure of Formula V:

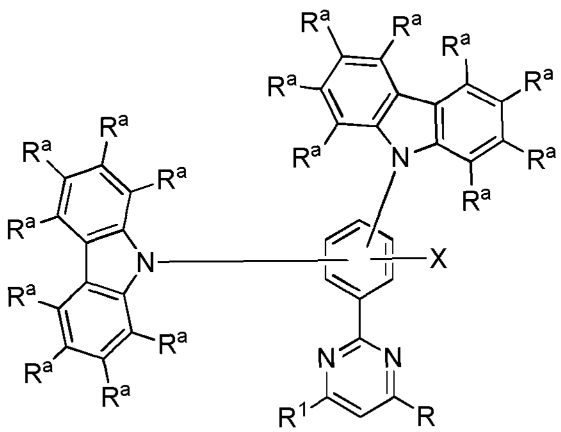

(Formula V),

wherein $R^a$, $R^1$ and X are defined as above.

In an embodiment not forming part of the claimed invention, $E^B$ is chosen from molecules of a structure of Formula Va:

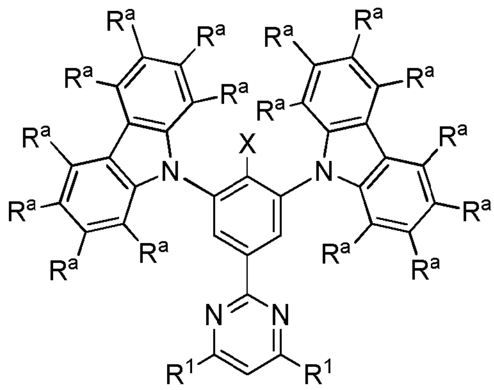

(Formula Va),

wherein $R^a$, $R^1$ and X are defined as above.

In an embodiment not forming part of the claimed invention, $E^B$ is chosen from molecules of a structure of Formula Vb:

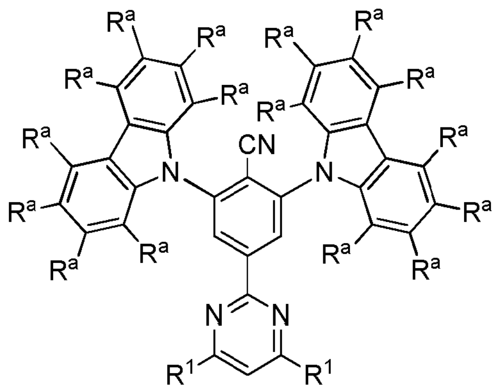

(Formula Vb),

wherein $R^a$ and $R^1$ are defined as above.

In an embodiment not forming part of the claimed invention, $E^B$ is chosen from molecules of a structure of Formula VI:

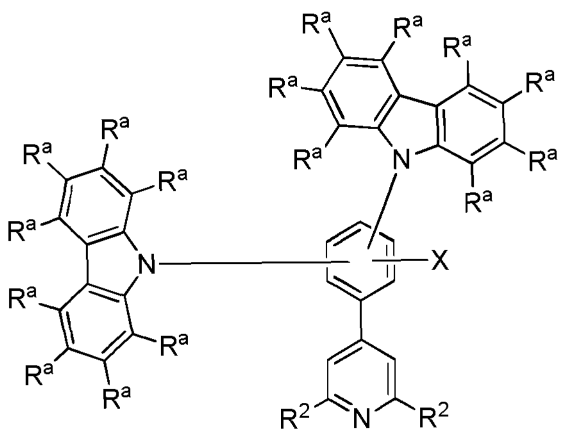

(Formula VI),

wherein $R^a$, $R^1$ and X are defined as above.

In an embodiment not forming part of the claimed invention, $E^B$ is chosen from molecules of a structure of Formula Via:

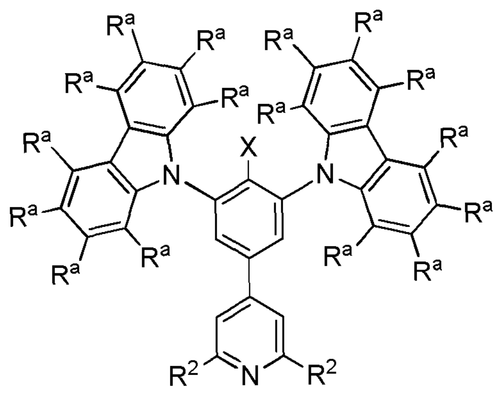

(Formula Via),

wherein $R^a$, $R^1$ and X are defined as above.

In an embodiment not forming part of the claimed invention, $E^B$ is chosen from molecules of a structure of Formula VIb:

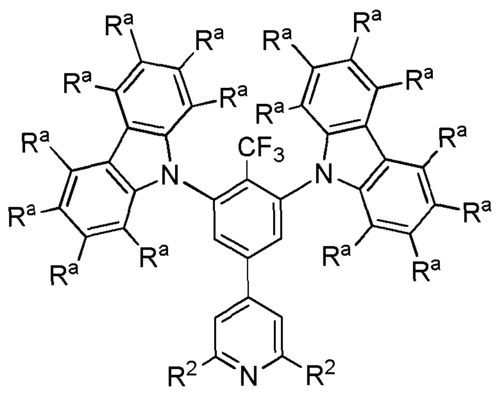

(Formula VIb),

wherein $R^a$ and $R^1$ are defined as above.

In an embodiment not forming part of the claimed invention, $E^B$ is chosen from molecules of a structure of Formula VII:

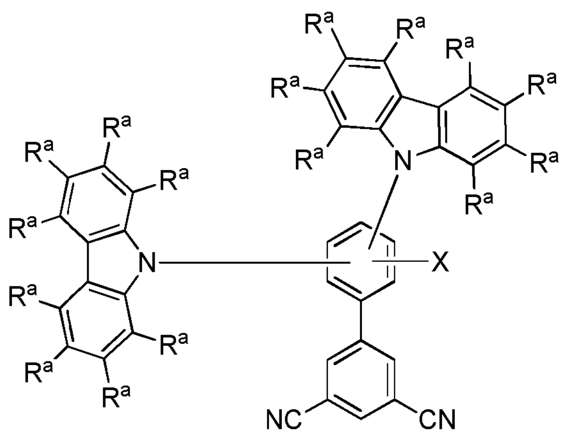

(Formula VII),

wherein $R^a$ and X are defined as above.

In an embodiment not forming part of the claimed invention, $E^B$ is chosen from molecules of a structure of Formula VIIa:

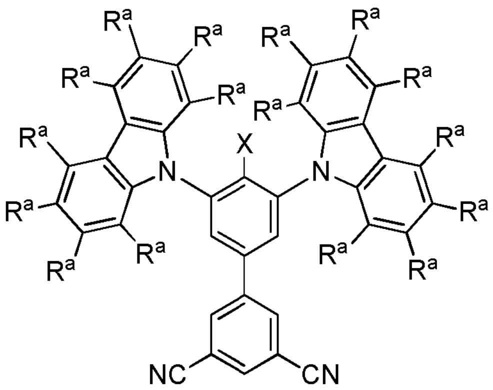

(Formula VIIa),

wherein $R^a$ and X are defined as above.

In an embodiment not forming part of the claimed invention, $E^B$ is chosen from molecules of a structure of Formula VIIb:

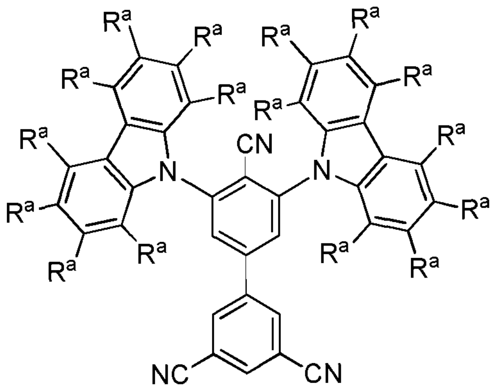

(Formula VIIb),

wherein $R^a$ is defined as above.

In an embodiment not forming part of the claimed invention, $E^B$ is chosen from molecules of a structure of Formula VIII:

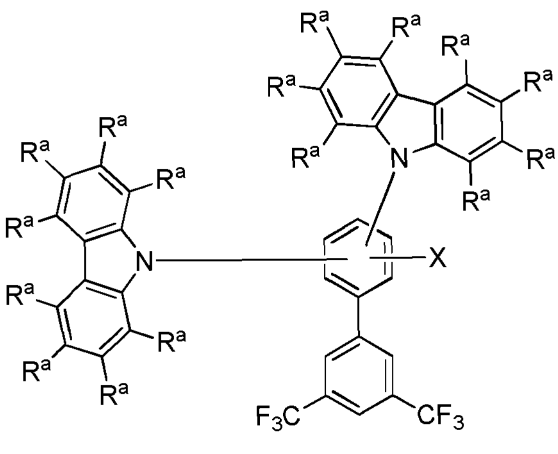

(Formula VIII),

wherein $R^a$ and X are defined as above.

In an embodiment not forming part of the claimed invention, $E^B$ is chosen from molecules of a structure of Formula VIIIa:

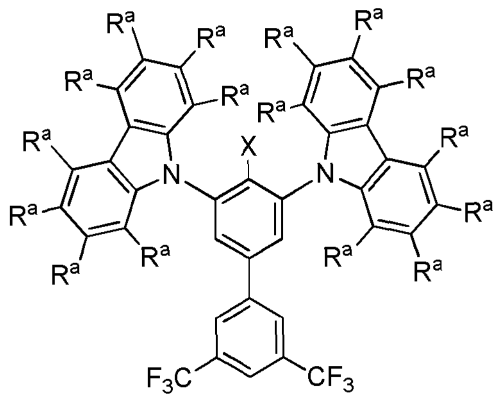

(Formula VIIIa),

wherein $R^a$ and X are defined as above.

In an embodiment not forming part of the claimed invention, $E^B$ is chosen from molecules of a structure of Formula VIIIb:

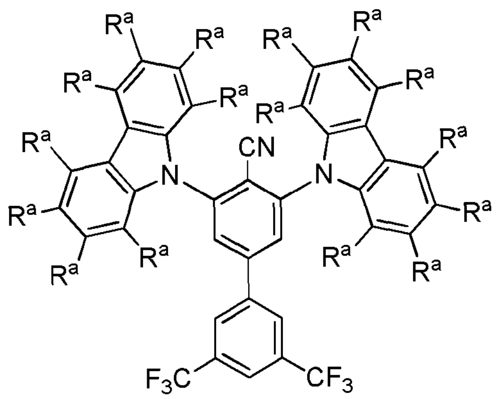

(Formula VIIIb),

wherein $R^a$ is defined as above.

In an embodiment not forming part of the claimed invention, $E^B$ is chosen from molecules of a structure of Formula IX:

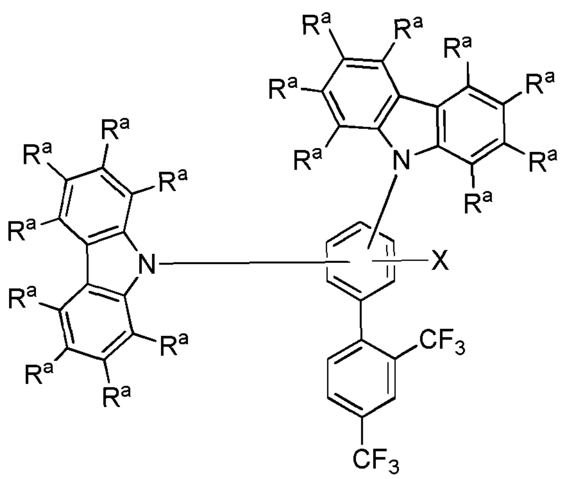

(Formula IX),

wherein $R^a$ and X are defined as above.

In an embodiment not forming part of the claimed invention, $E^B$ is chosen from molecules of a structure of Formula IXa:

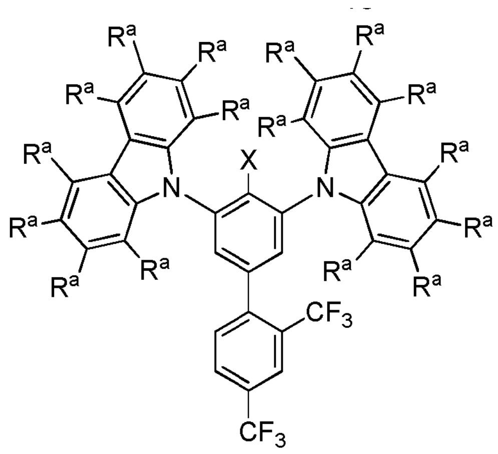

(Formula IXa),

wherein $R^a$ and X are defined as above.

In an embodiment not forming part of the claimed invention, $E^B$ is chosen from molecules of a structure of Formula IXb:

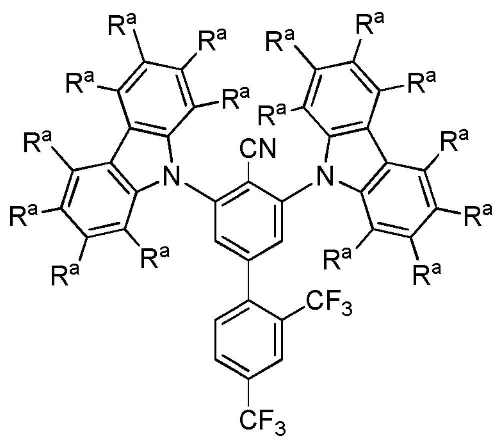

(Formula IXb),

wherein $R^a$ is defined as above.

In an embodiment not forming part of the claimed invention, $E^B$ is chosen from molecules of a structure of Formula X:

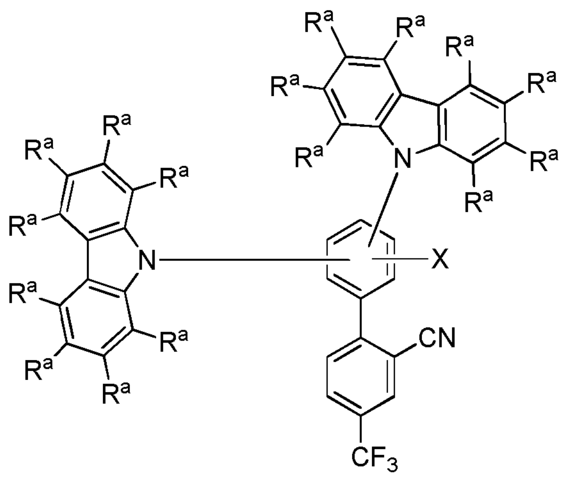

(Formula X),

wherein $R^a$ and X are defined as above.

In an embodiment not forming part of the claimed invention, $E^B$ is chosen from molecules of a structure of Formula Xa:

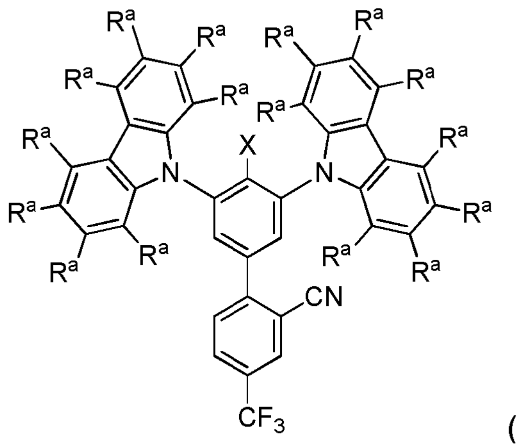

(Formula Xa),

wherein $R^a$ and X are defined as above.

In an embodiment not forming part of the claimed invention, $E^B$ is chosen from molecules of a structure of Formula Xb:

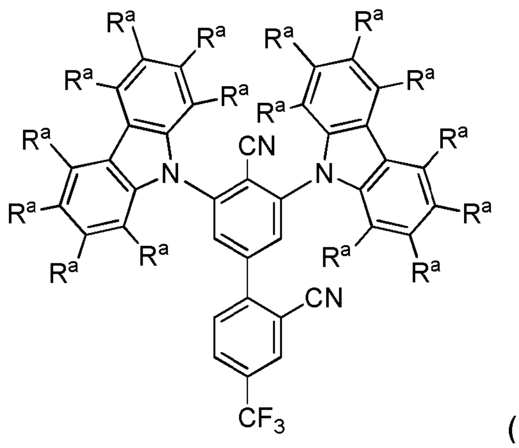

(Formula Xb),

wherein $R^a$ is defined as above.

In an embodiment not forming part of the claimed invention, $E^B$ is chosen from molecules of a structure of Formula XI:

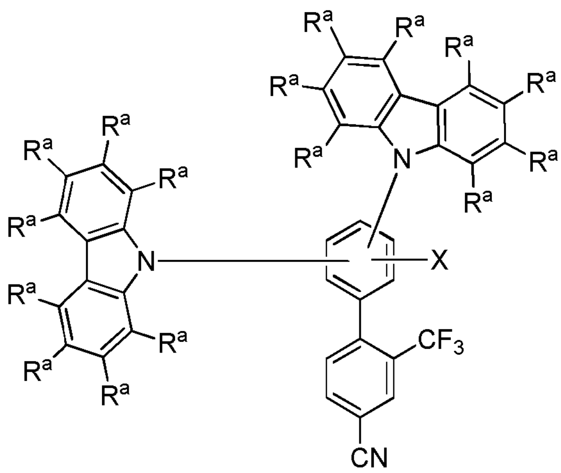

(Formula XI),

wherein $R^a$ and X are defined as above.

In an embodiment not forming part of the claimed invention, $E^B$ is chosen from molecules of a structure of Formula XIa:

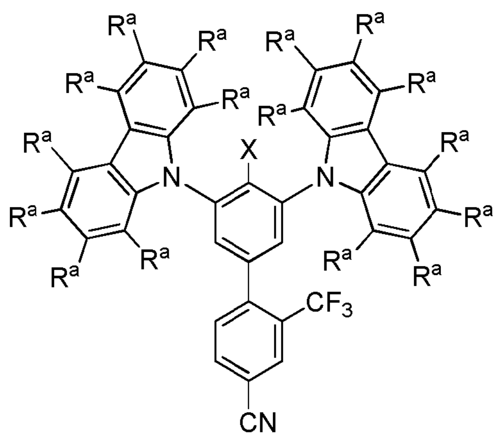

(Formula Xia),

wherein $R^a$ and X are defined as above.

In an embodiment not forming part of the claimed invention, $E^B$ is chosen from molecules of a structure of Formula XIb:

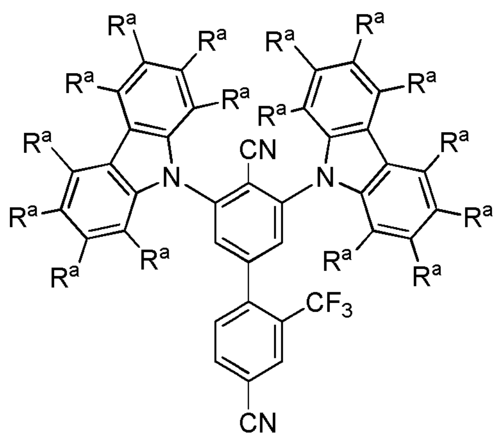

(Formula XIb),

wherein $R^a$ is defined as above.

In an embodiment not forming part of the claimed invention, $E^B$ is chosen from molecules of a structure of Formula XII:

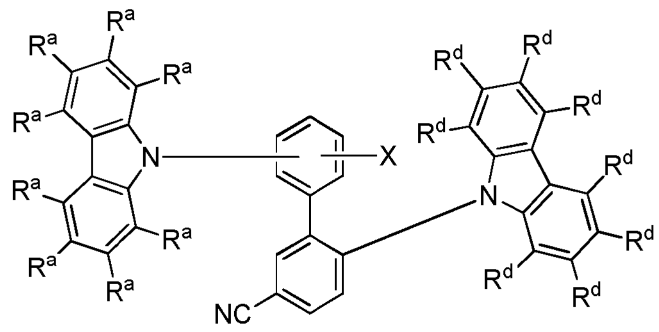

(Formula XII),

wherein $R^a$, X and $R^d$ are defined as above.

In an embodiment not forming part of the claimed invention, $E^B$ is chosen from molecules of a structure of Formula XIIa:

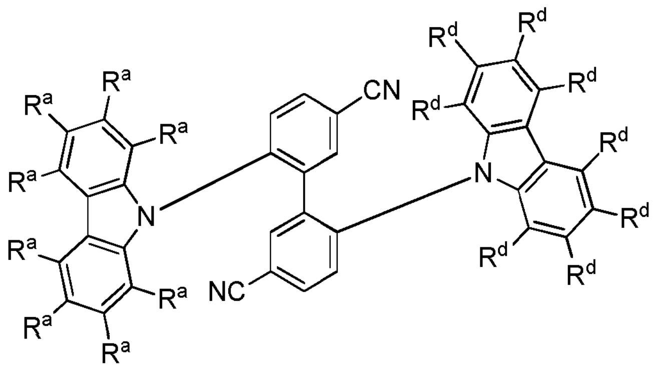

(Formula XIIa),

wherein $R^a$, X and $R^d$ are defined as above.

In an embodiment not forming part of the claimed invention, $E^B$ is chosen from molecules of a structure of Formula XIIb:

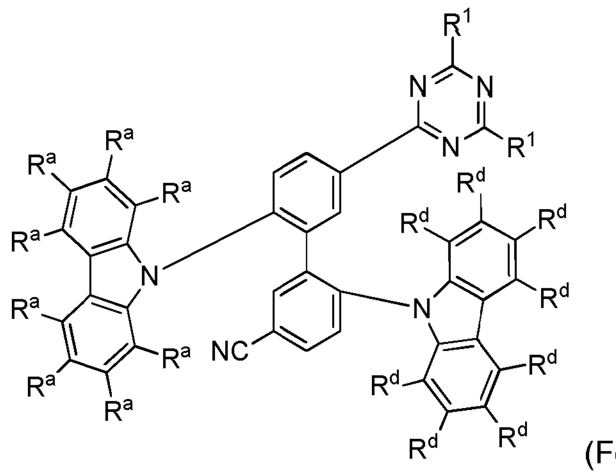

(Formula XIIb),

wherein $R^a$, X and $R^d$ are defined as above.

The synthesis of the molecules of a structure of Formula I-TADF can be accomplished via standard reactions and reaction conditions known to the skilled artesian. Typically, in a first step a coupling reaction, preferably a palladium catalyzed coupling reaction, is performed.

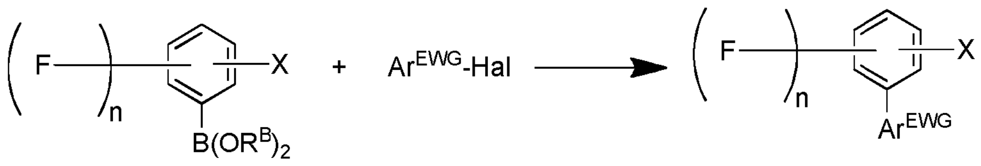

E1 E2 E3

**E1** can be any boronic acid ($R^B$=H) or an equivalent boronic acid ester ($R^B$=alkyl or aryl), in particular two $R^B$ form a ring to give e.g. boronic acid pinacol esters, of fluoro-(trifluoromethyl)phenyl, difluoro-(trifluoromethyl)phenyl, fluoro-(cyano)phenyl or difluoro-(cyano)phenyl. As second reactant **E2** preferably $Ar^{EWG}$-Br is used. Reaction conditions of such palladium catalyzed coupling reactions are known the person skilled in the art, e.g. from WO 2017/005699, and it is known that the reacting groups of **E1** and **E2** can be interchanged to optimize the reaction yields.

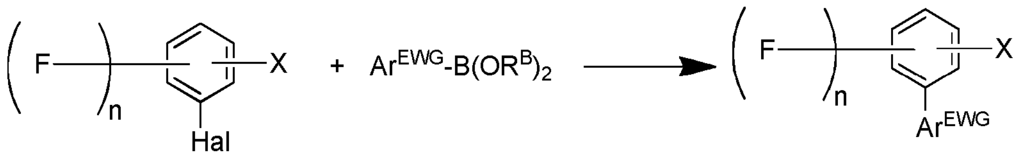

E4 E5 E3

In a second step, the molecules according to Formular I-TADF are obtained via the reaction of a nitrogen heterocycle in a nucleophilic aromatic substitution with the aryl halide, preferably aryl fluoride, or aryl dihalide, preferably aryl difluoride, **E3**. Typical conditions include the use of a base, such as tribasic potassium phosphate or sodium hydride, for example, in an aprotic polar solvent, such as dimethyl sulfoxide (DMSO) or N,N-dimethylformamide (DMF), for example.

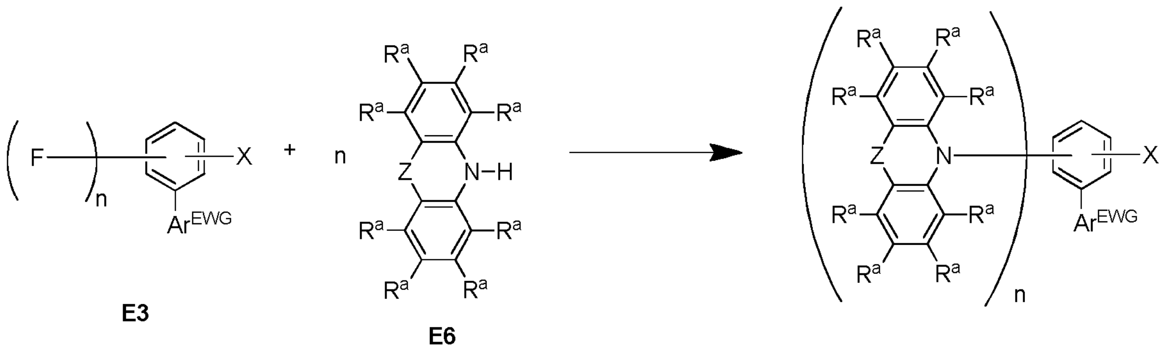

E3 E6

In particular, the donor molecule E6 is a 3,6-substituted carbazole (e.g., 3,6-dimethylcarbazole, 3,6 diphenylcarbazole, 3,6-di-tert-butylcarbazole), a 2,7-substituted carbazole (e.g., 2,7 dimethylcarbazole, 2,7-diphenylcarbazole, 2,7-di-tert-butylcarbazole), a 1,8-substituted carbazole (e.g., 1,8-dimethylcarbazole, 1,8-diphenylcarbazole, 1,8-di-tert-butylcarbazole), a 1 substituted carbazole (e.g., 1-methylcarbazole, 1-phenylcarbazole, 1-tert-butylcarbazole), a 2 substituted carbazole (e.g., 2-methylcarbazole, 2-phenylcarbazole, 2-tert-butylcarbazole), or a 3 substituted carbazole (e.g., 3-methylcarbazole, 3-phenylcarbazole, 3-tert-butylcarbazole).

Alternatively, a halogen-substituted carbazole, particularly 3-bromocarbazole, can be used as **E6**.

In a subsequent reaction a boronic acid ester functional group or boronic acid functional group may be exemplarily introduced at the position of the one or more halogen substituents, which was introduced via **E6**, to yield the corresponding carbazol-3-ylboronic acid ester or carbazol-3-ylboronic acid, e.g., via the reaction with bis(pinacolato)diboron (CAS No. 73183-34-3). Subsequently, one or more substituents $R^a$ may be introduced in place of the boronic acid ester group or the boronic acid group via a coupling reaction with the corresponding halogenated reactant $R^a$-Hal, preferably $R^a$-Cl and $R^a$-Br.

Alternatively, one or more substituents $R^a$ may be introduced at the position of the one or more halogen substituents, which was introduced via D-H, via the reaction with a boronic acid of the substituent $R^a$ [$R^a$-$B(OH)_2$] or a

corresponding boronic acid ester.

An alternative synthesis route comprises the introduction of a nitrogen heterocycle via copper-or palladium-catalyzed coupling to an aryl halide or aryl pseudohalide, preferably an aryl bromide, an aryl iodide, aryl triflate or an aryl tosylate.

Device wherein the emitter material $S^B$ is a blue fluorescence emitter

In one embodiment of the invention, the emitter material $S^B$ is a fluorescence emitter, in particular a blue fluorescence emitter.

In one embodiment, the emitter material $S^B$ is a blue fluorescence emitter selected from the following group:

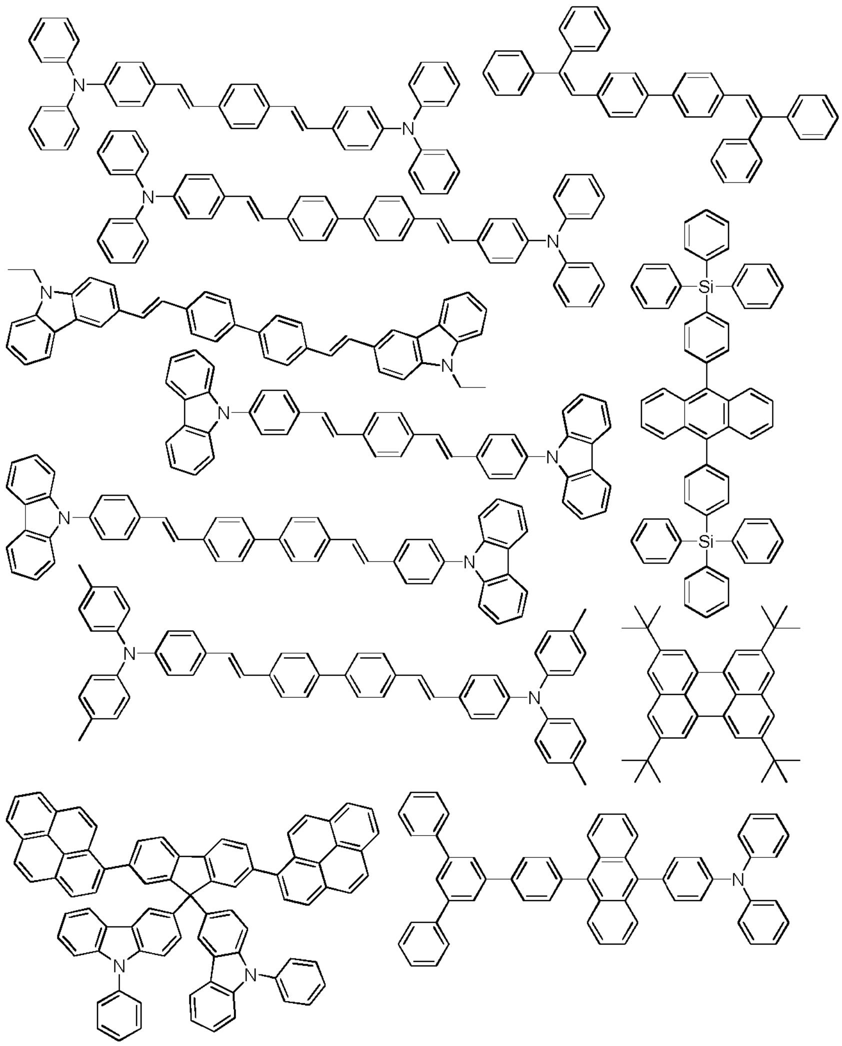

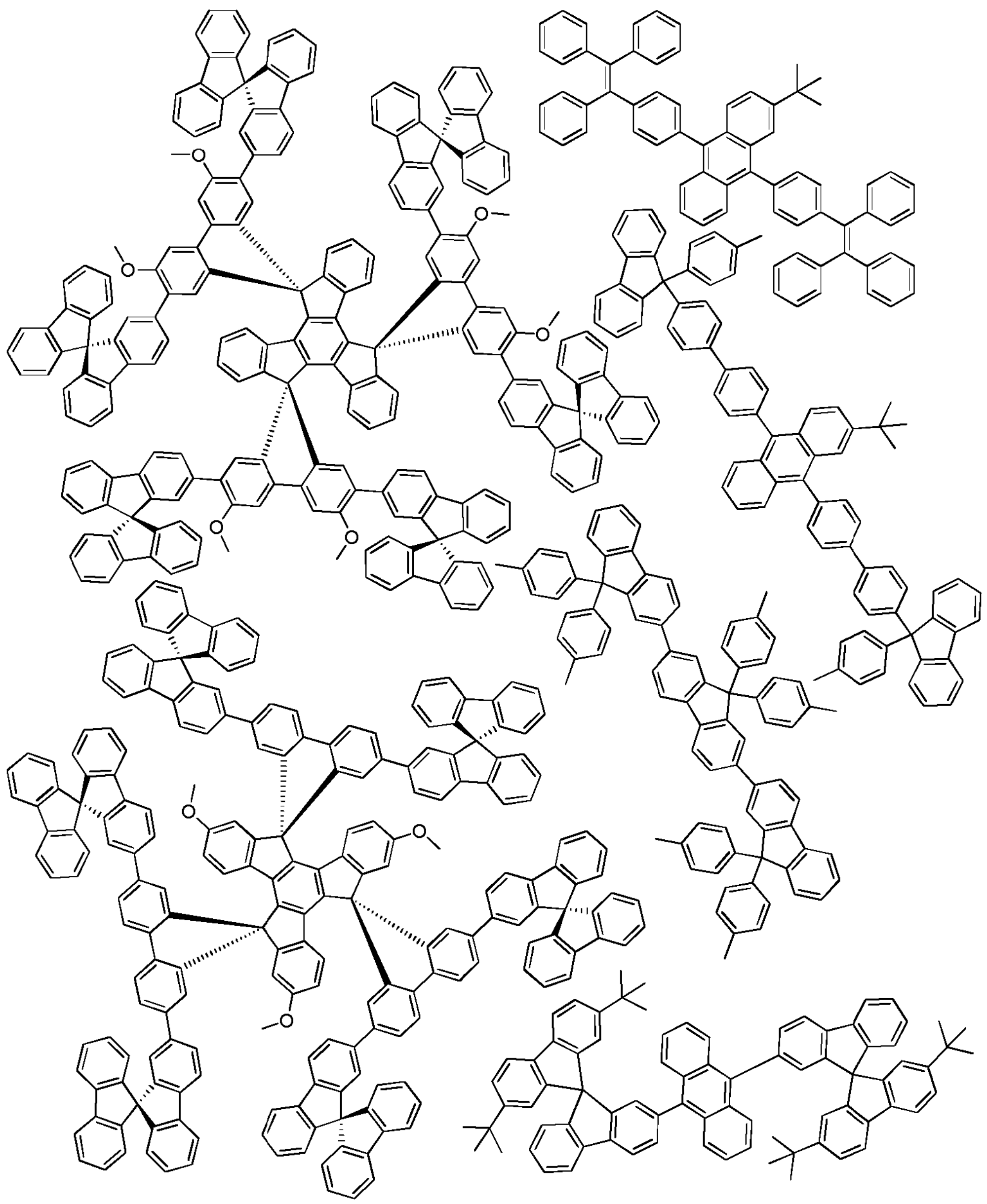

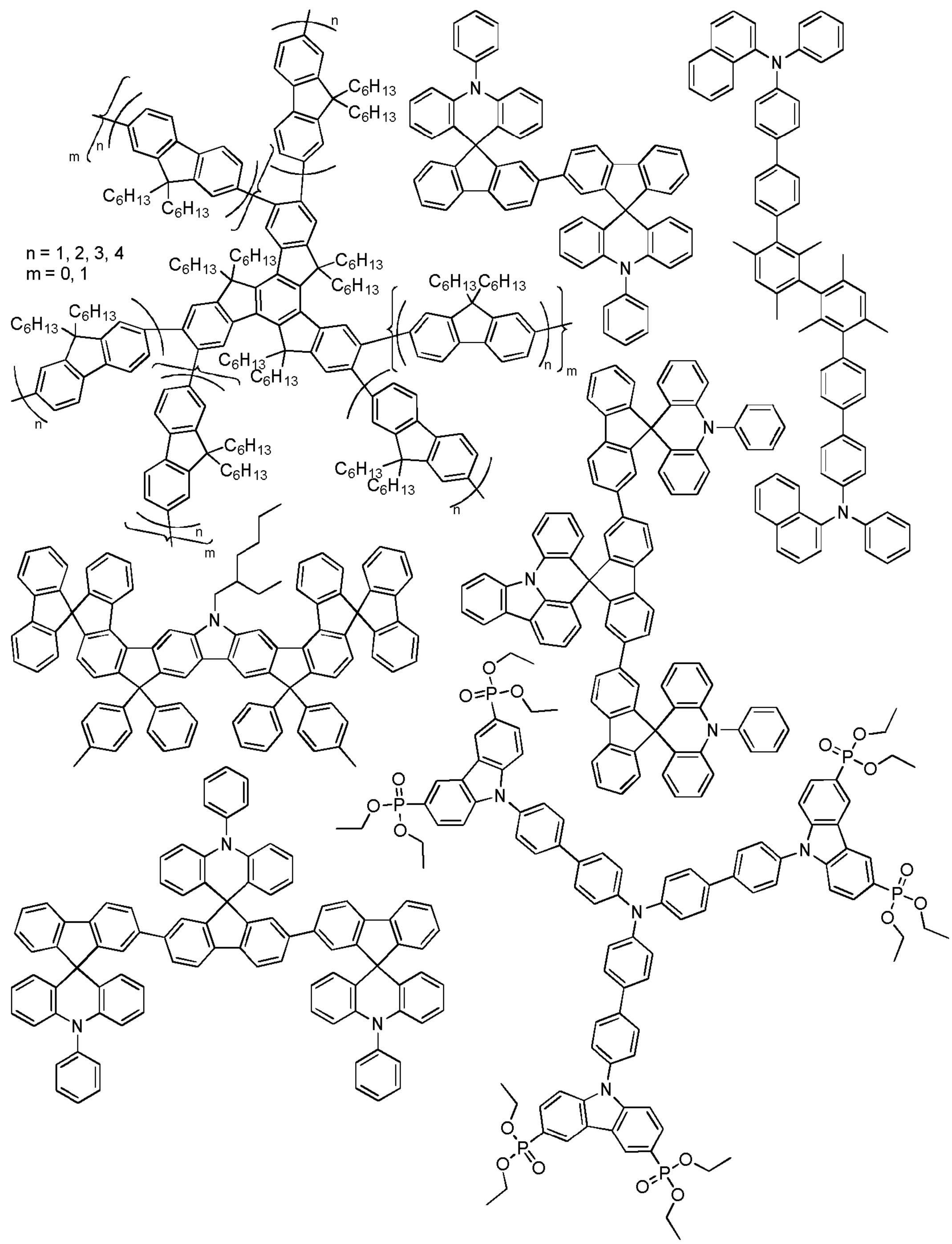

n = 1, 2, 3, 4
m = 0, 1

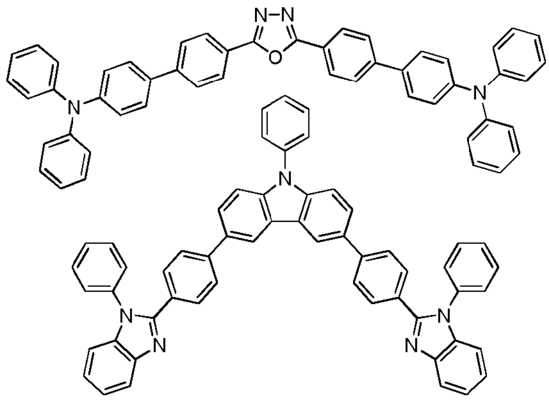

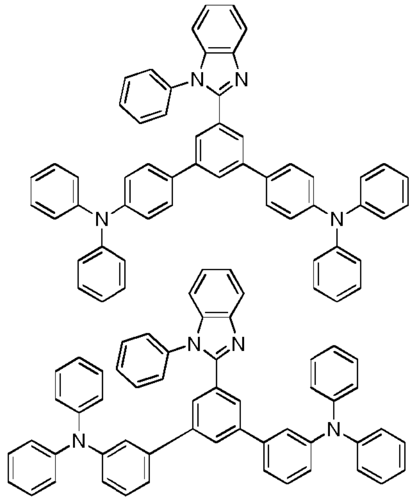

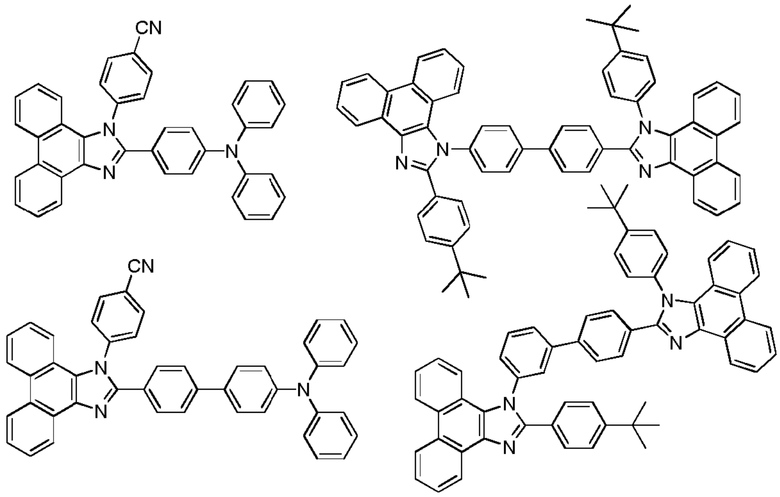

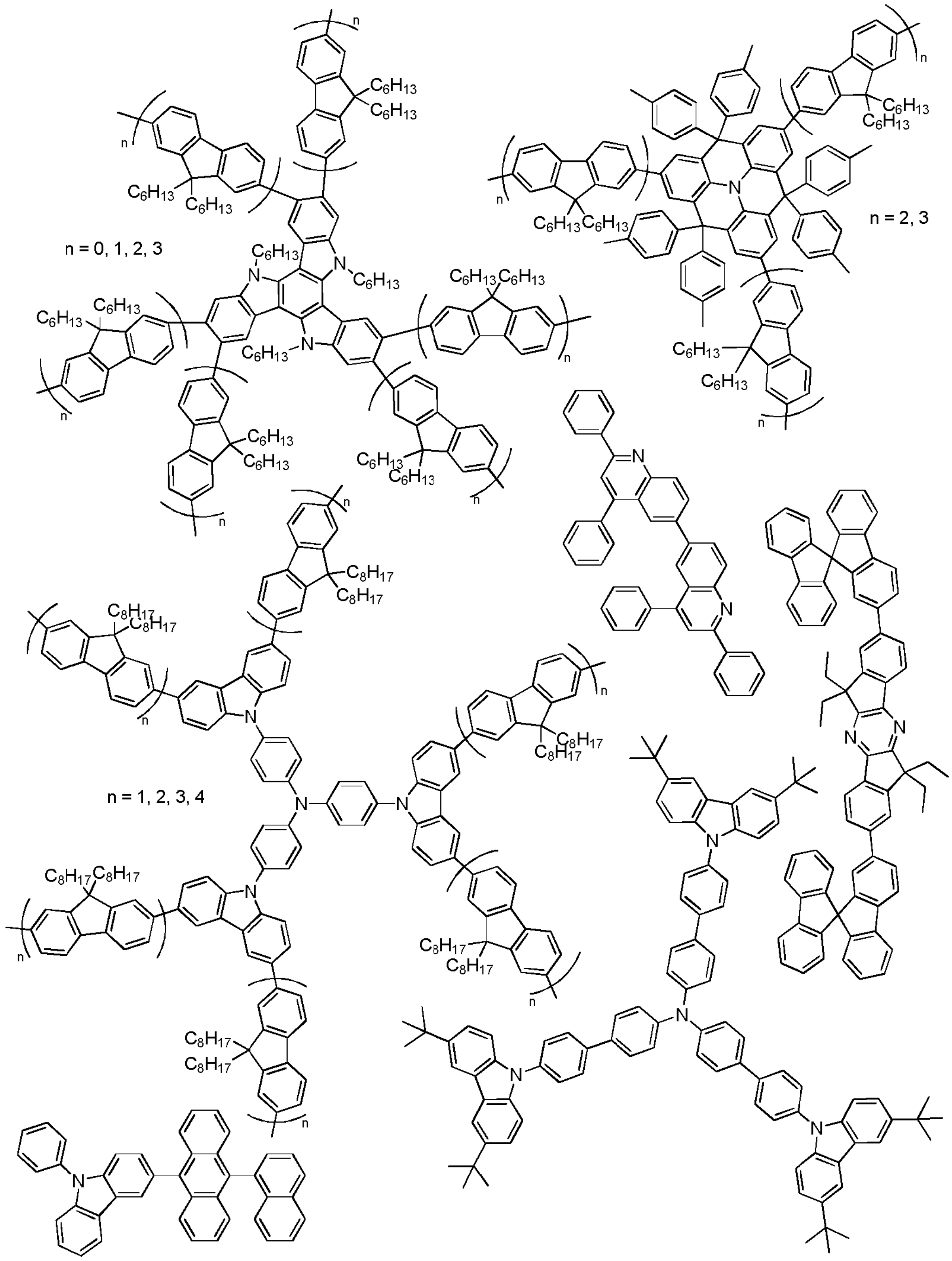

n = 0, 1, 2, 3

n = 2, 3

n = 1, 2, 3, 4

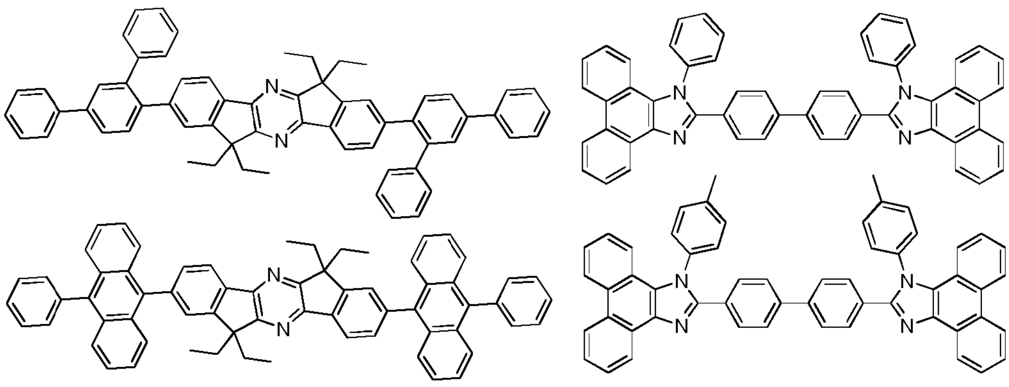

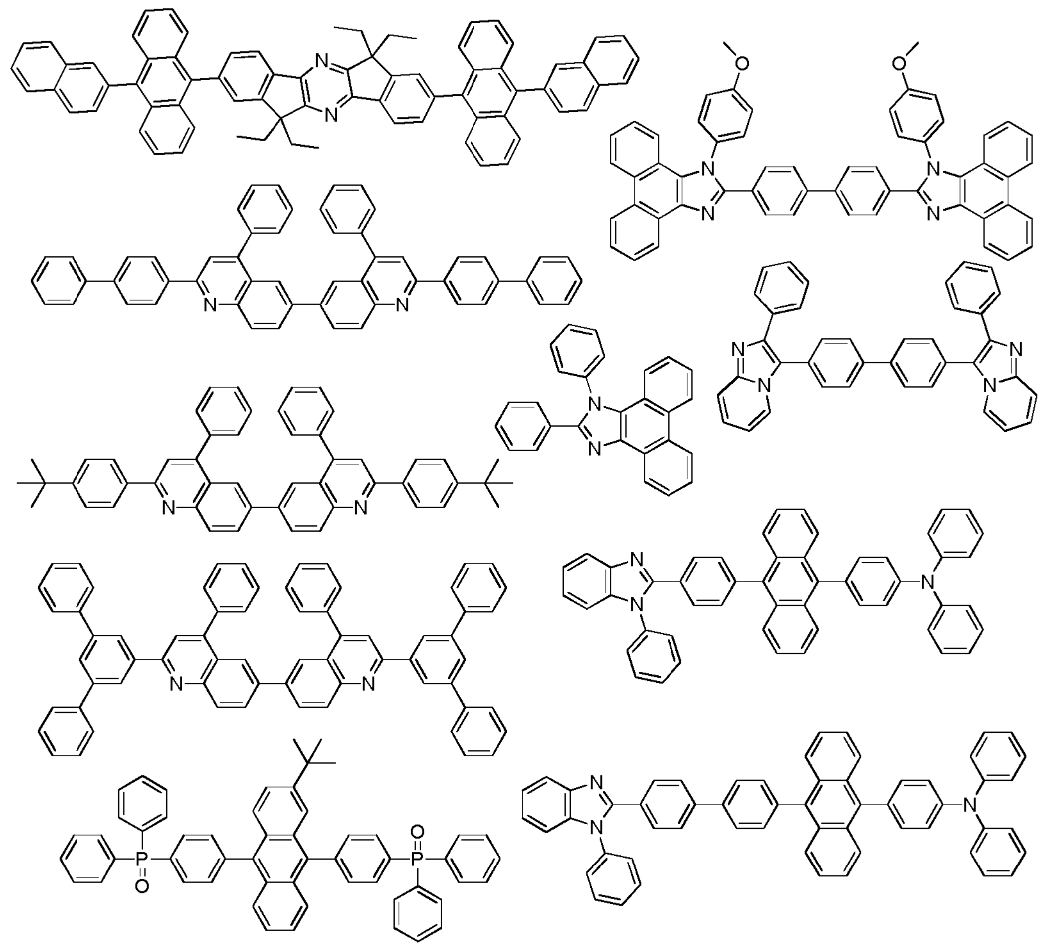

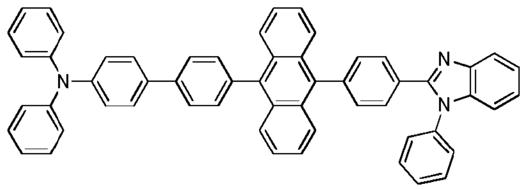

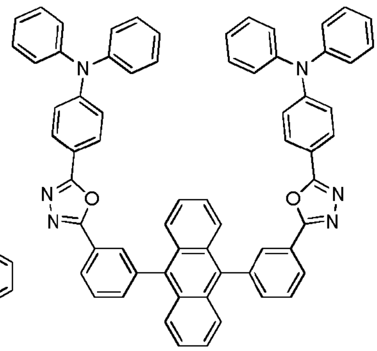

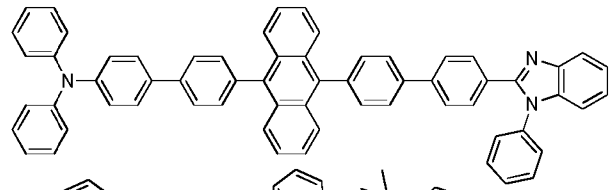

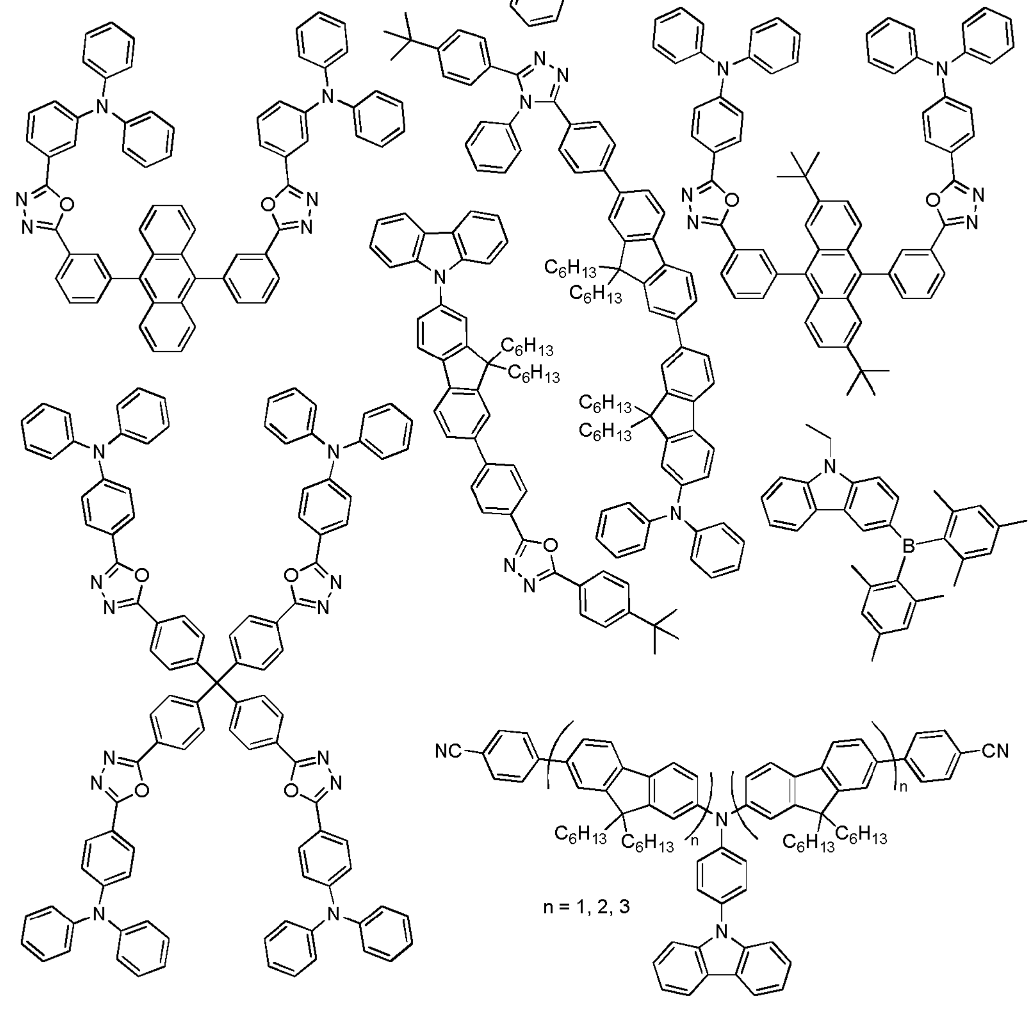

n = 1, 2, 3

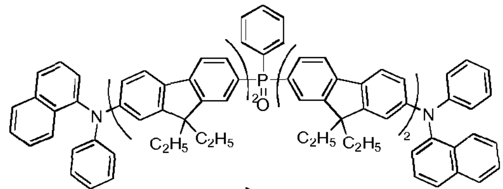

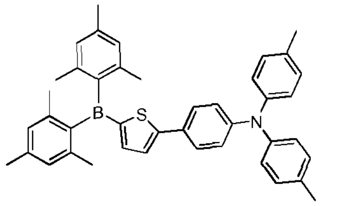

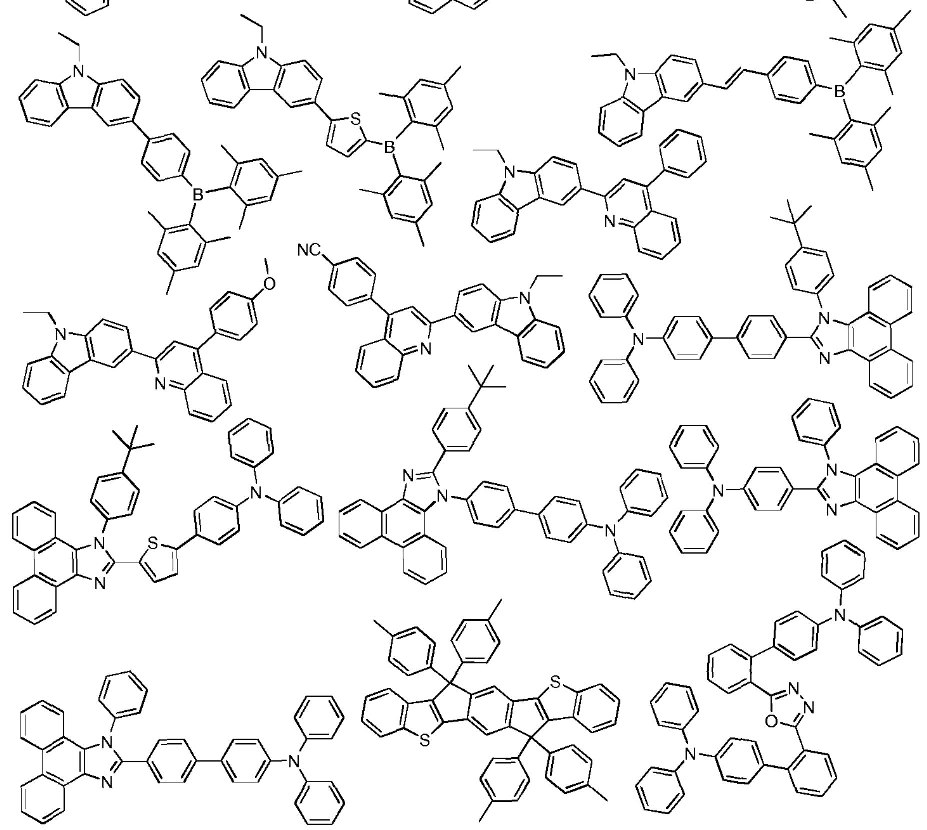

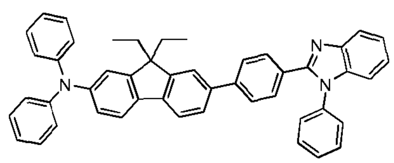

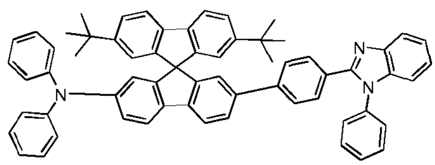

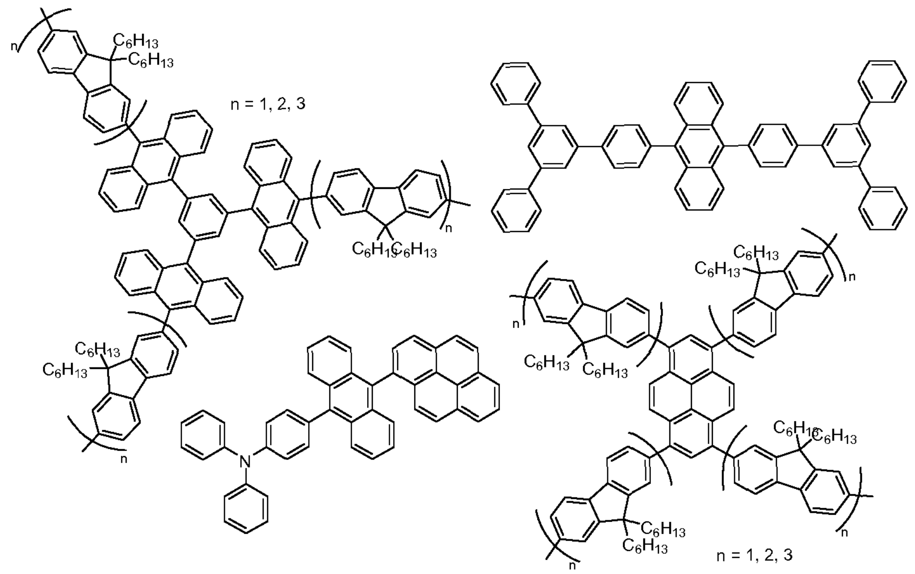

n = 1, 2, 3

n = 1, 2, 3

In certain embodiments, the emitter material $S^B$ is a blue fluorescence emitter selected from the following group:

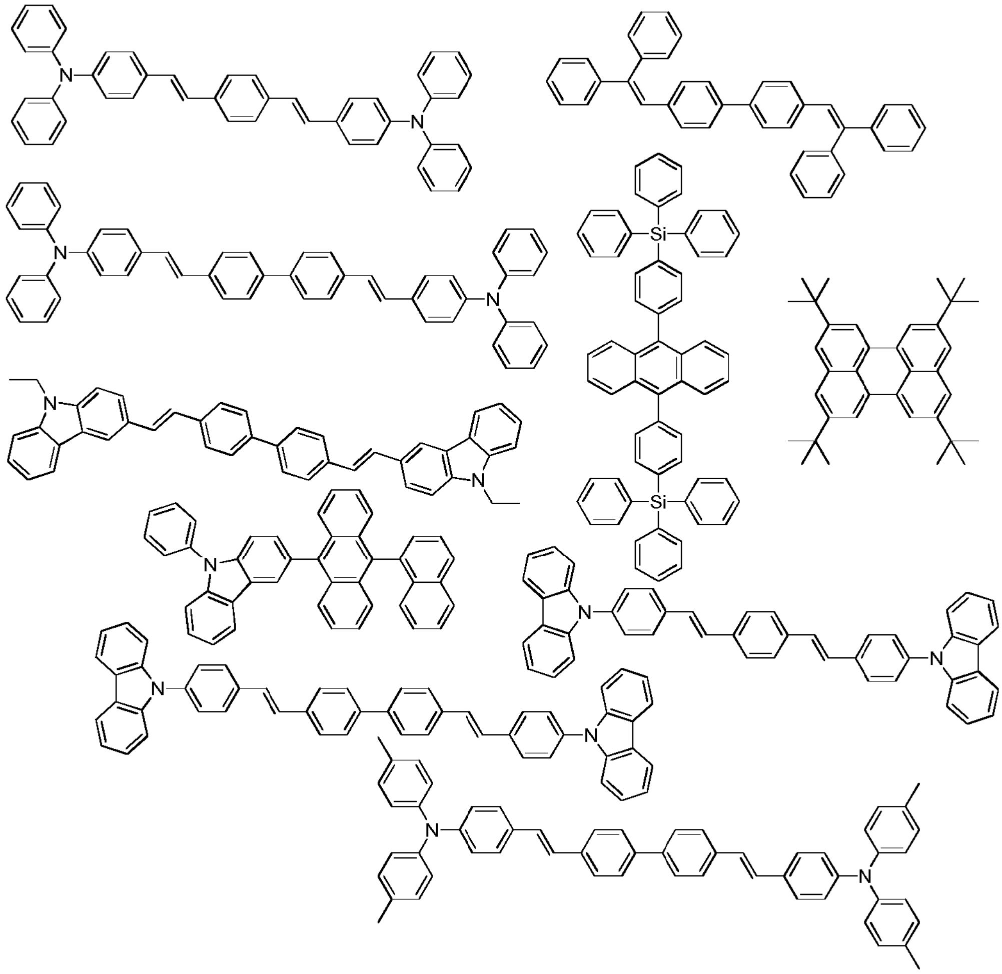

*Device wherein the emitter material $S^B$ is a triplet-triplet annihilation (TTA) fluorescence emitter*

In one embodiment of the invention, the emitter material $S^B$ is a triplet-triplet annihilation (TTA) emitter.

In one embodiment, $S^B$ is a blue TTA emitter selected from the following group:

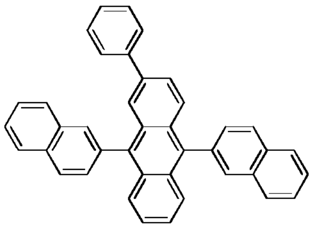

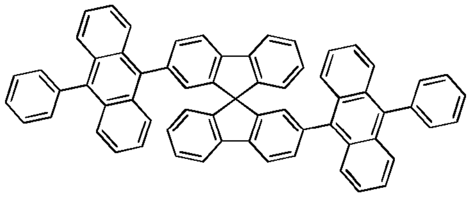

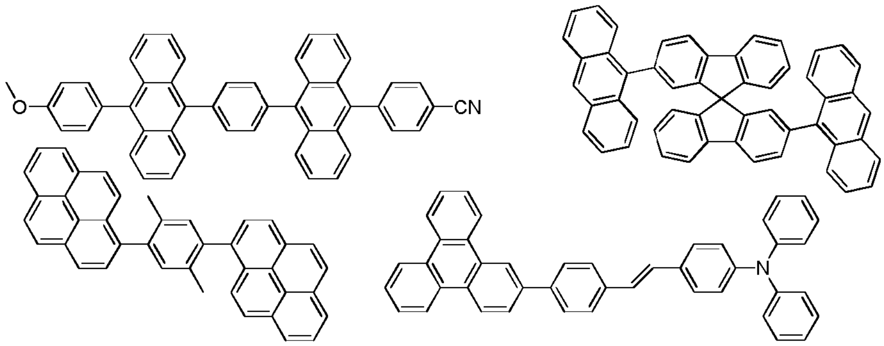

*Device wherein the emitter material $S^B$ is a green fluorescence emitter*

In a further embodiment of the invention, the emitter material $S^B$ is a fluorescence emitter, in particular a green fluorescence emitter.

In one embodiment, the emitter material $S^B$ is a fluorescence emitter selected from the following group:

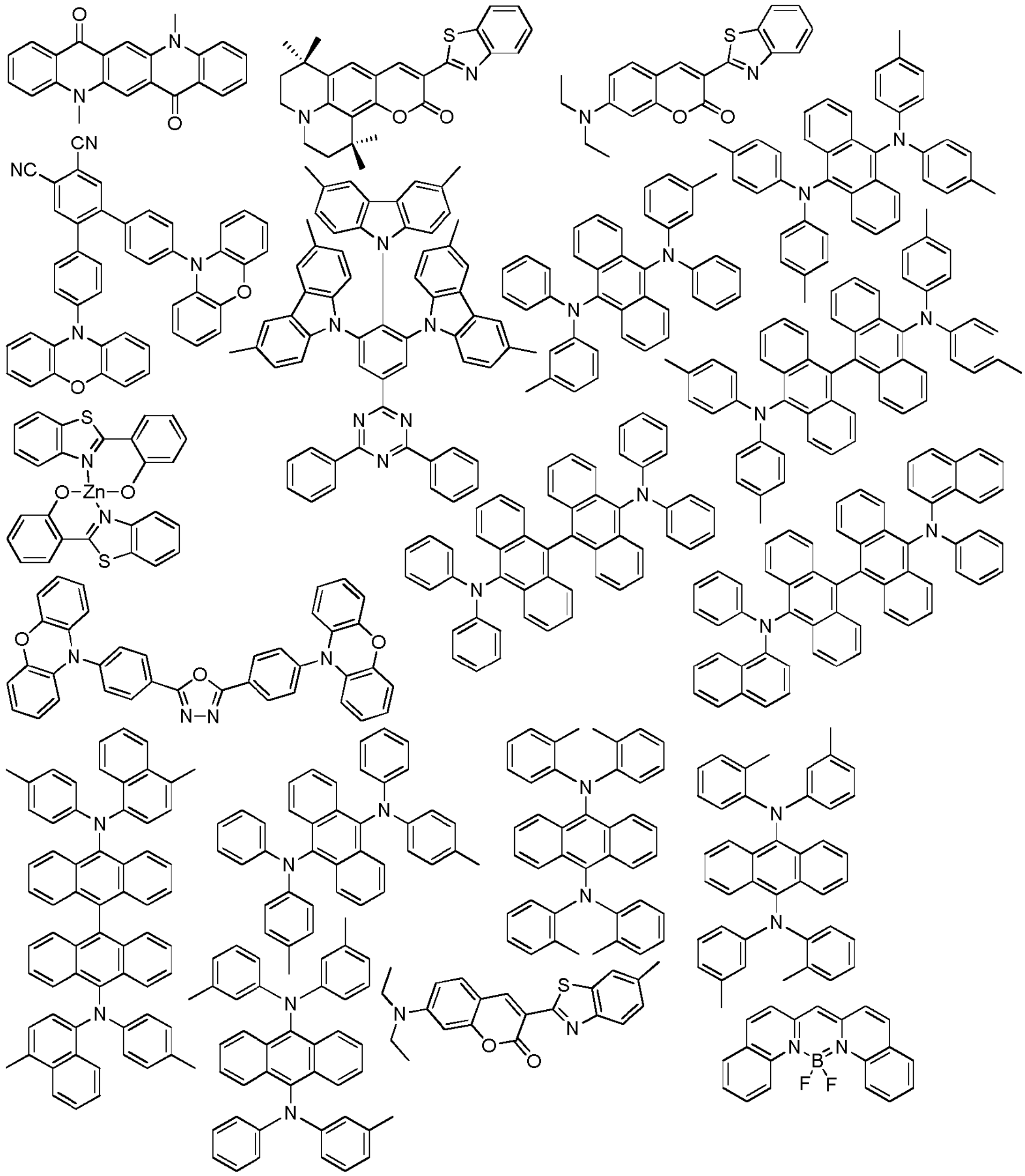

In a further embodiment of the invention, the device has an emission peak in the visible or nearest ultraviolet range, i.e., in the range of a wavelength of from 380 to 800 nm, in particular between 485 nm and 590 nm, preferably between 505 nm and 565 nm, even more preferably between 515 nm and 545 nm.

*Device wherein the emitter material $S^B$ is a red fluorescence emitter*

In a further embodiment of the invention, the emitter material $S^B$ is a fluorescence emitter, in particular a red fluorescence emitter.

In one embodiment, the emitter material $S^B$ is a fluorescence emitter selected from the following group:

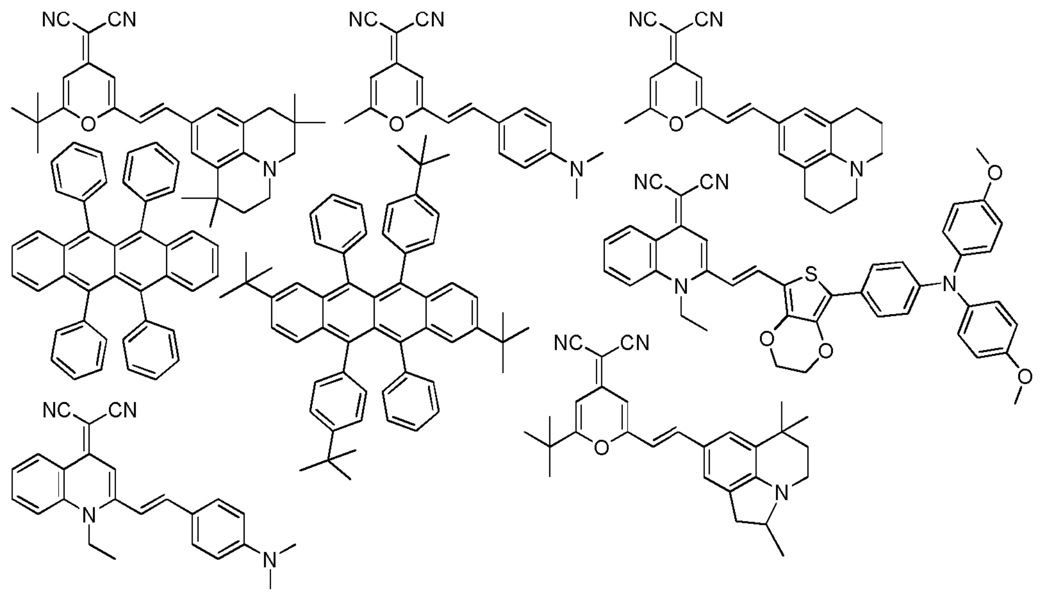

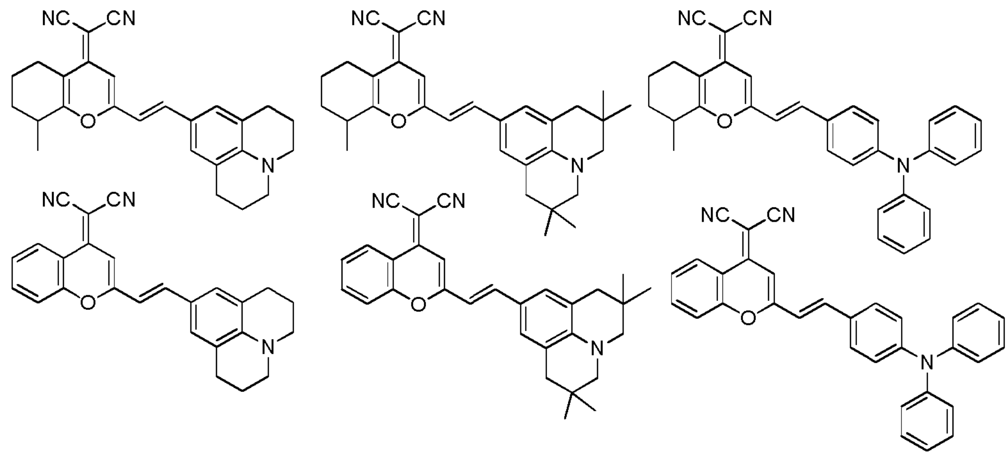

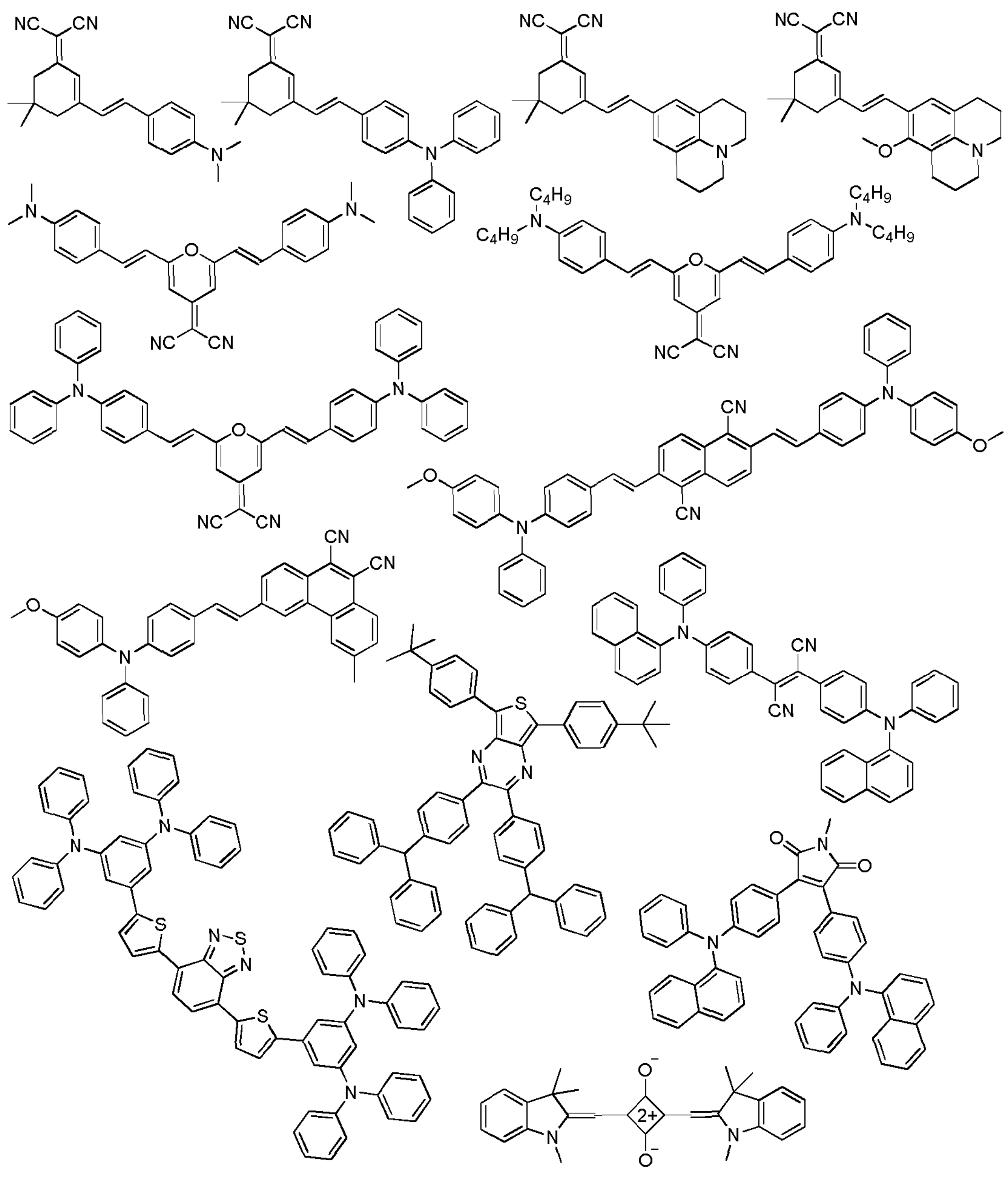

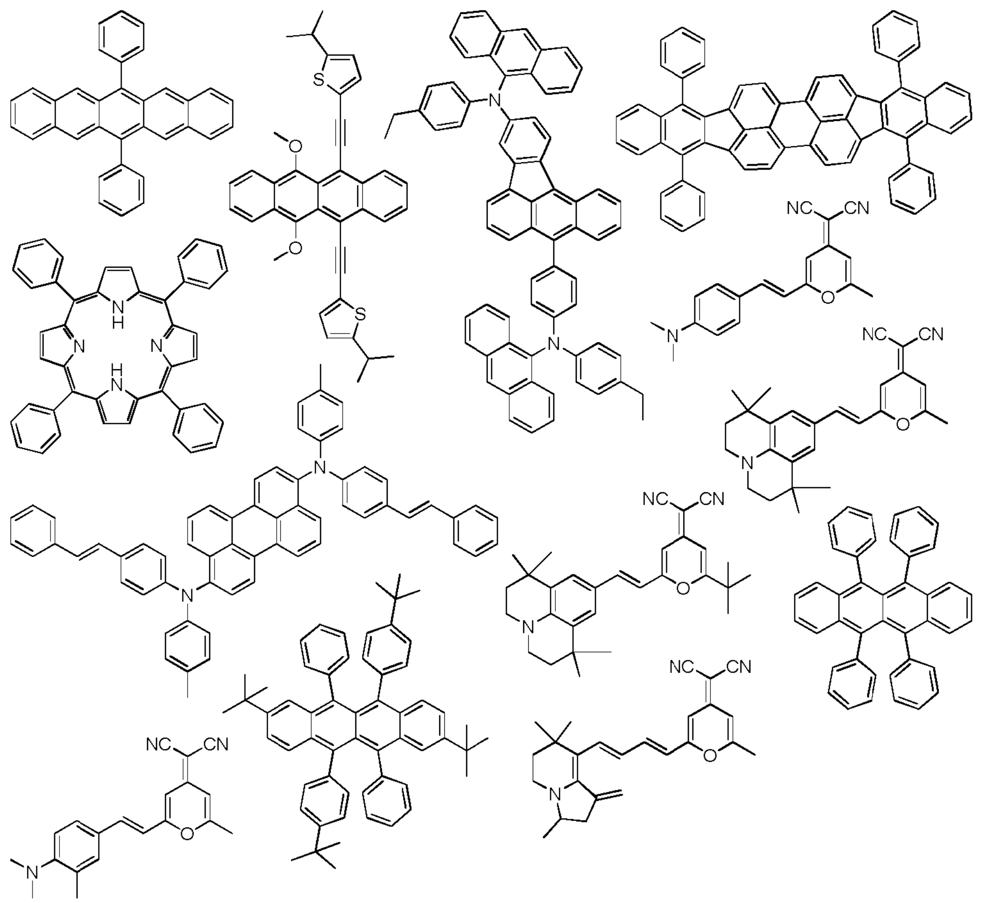

In a further embodiment of the invention, the device has an emission peak in the visible or nearest ultraviolet range, i.e., in the range of a wavelength of from 380 to 800 nm, in particular between 590 nm and 690 nm, preferably between 610 nm and 665 nm, even more preferably between 620 nm and 640 nm.

Orbital and excited state energies can be determined either by means of experimental methods known to the person skilled in the art. Experimentally, the energy of the highest occupied molecular orbital $E^{HOMO}$ is determined by methods known to the person skilled in the art from cyclic voltammetry measurements with an accuracy of 0.1 eV. The energy of the lowest unoccupied molecular orbital $E^{LUMO}$ is calculated as $E^{HOMO} + E^{gap}$, where $E^{gap}$ is determined as follows:

For host compounds, the onset of emission of a film with 10 % by weight of host in poly(methyl methacrylate) (PMMA) is used as $E^{gap}$, unless stated otherwise.

For emitter compounds, e.g., NRCT emitters and fluorescence emitters, $E^{gap}$ is determined as the energy at which the excitation and emission spectra of a film with 1 % by weight of emitter in PMMA cross, unless stated otherwise.

For organic TADF emitters, $E^{gap}$ is determined as the energy at which the excitation and emission spectra of a film with 10 % by weight of emitter in PMMA cross, unless stated otherwise.

For host compounds, the onset of emission of a film with 10 % by weight of host in poly(methyl methacrylate) (PMMA), which corresponds to the energy of the first excited singlet state S1, is used as $E^{gap}$, unless stated otherwise.

For emitter compounds, e.g., NRCT emitters and fluorescence emitters, $E^{gap}$ and thus the energy of the first excited singlet state S1 is determined in the same way, unless stated otherwise.

For organic TADF emitters, the onset of emission of a film with 10 % by weight of host in poly(methyl methacrylate) (PMMA), which corresponds to the energy of the first excited singlet state S1, is used as $E^{gap}$, unless stated otherwise.

For host compounds, the energy of the first excited triplet state T1 is determined from the onset of the time-gated emission spectrum at 77 K, typically with a delay time of 1 ms and an integration time of 1 ms, if not otherwise stated measured in a film of poly(methyl methacrylate) (PMMA) with 10 % by weight of host.

For emitter compounds, e.g., NRCT emitters and fluorescence emitters, the energy of the first excited triplet state T1 is determined from the onset of the time-gated emission spectrum at 77 K, typically with a delay time of 1 ms and an integration time of 1 ms, if not otherwise stated measured in a film of poly(methyl methacrylate) (PMMA) with 1 % by weight of emitter.

For organic TADF emitters, the energy of the first excited triplet state T1 is determined from the onset of the

time-gated emission spectrum at 77 K, typically with a delay time of 1 ms and an integration time of 1 ms, if not otherwise stated measured in a film of poly(methyl methacrylate) (PMMA) with 10 % by weight of TADF compound.

For TADF compounds, the energy of the first excited triplet state T1 is determined from the onset of the time-gated emission spectrum at 77 K, typically with a delay time of 1 ms and an integration time of 1 ms.

In the electron transport layer (ETL, , any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter $ETM^D$ may also be a star-shaped heterocycle such as 1,3,5-tri(1-phenyl-1H-benzo[d]imidazol-2-yl)phenyl (TPBi). The $ETM^D$ may exemplarily be NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the electron transport layer may be doped with materials such as Liq (8-hydroxyquinolinolatolithium). Optionally, a second electron transport layer may be located between electron transport layer and the cathode layer C.

Adjacent to the electron transport layer (ETL), a cathode layer C may be located. Exemplarily, the cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer C may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscale silver wires.

An OLED may further, optionally, comprise a protection layer between the electron transport layer (ETL) D and the cathode layer C (which may be designated as electron injection layer (EIL)). This layer may comprise lithium fluoride, caesium fluoride, silver, Liq (8-hydroxyquinolinolatolithium), $Li_2O$, $BaF_2$, MgO and/or NaF.

Accordingly, a further embodiment of the present invention relates to an OLED, which exhibits an external quantum efficiency at 1000 cd/$m^2$ of more than 10 %, more preferably of more than 12 %, more preferably of more than 15 %, even more preferably of more than 17 % or even more than 20 % and/or exhibits an emission maximum between 490 nm and 570 nm, preferably between 500 nm and 560 nm, more preferably between 510 nm and 550 nm, even more preferably between 520 nm and 540 nm and/or exhibits a LT80 value at 500 cd/$m^2$ of more than 3000 h, preferably more than 6000 h, more preferably more than 12000 h, even more preferably more than 22500 h or even more than 30000 h.

Accordingly, a further embodiment of the present invention relates to an OLED, which exhibits an external quantum efficiency at 1000 cd/$m^2$ of more than 10 %, more preferably of more than 12 %, more preferably of more than 15 %, even more preferably of more than 17 % or even more than 20 % and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 100 h, preferably more than 200 h, more preferably more than 400 h, even more preferably more than 750 h or even more than 1000 h.

A further embodiment of the present invention relates to an OLED, which emits light at a distinct color point. According to the present invention, the OLED emits light with a narrow emission band (small full width at half maximum (FWHM)). In a preferred embodiment, the OLED according to the invention emits light with a FWHM of the main emission peak of below 0.43 eV, more preferably of below 0.39 eV, even more preferably of below 0.35 eV or even below 0.31 eV.

In a particularly preferred embodiment, the emitter material $S^B$ is a NRCT emitter and the OLED according to the invention emits light with a FWHM of the main emission peak of below 0.25 eV, more preferably of below 0.23 eV, even more preferably of below 0.21 eV or even below 0.20 eV.

A further embodiment of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further embodiment of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/or a CIEy color coordinate of between 0.00 and 0.45, preferably between 0.01 and 0.30, more preferably between 0.02 and 0.20 or even more preferably between 0.03 and 0.15 or even between 0.04 and 0.10.

A further embodiment of the present invention relates to an OLED, which emits light with CIEx and CIEy color coordinates close to the CIEx (= 0.170) and CIEy (= 0.797) color coordinates of the primary color green (CIEx = 0.170 and CIEy = 0.797) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is

transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further embodiment of the present invention relates to an OLED, whose emission exhibits a CIEx color coordinate of between 0.06 and 0.34, preferably between 0.07 and 0.29, more preferably between 0.09 and 0.24 or even more preferably between 0.12 and 0.22 or even between 0.14 and 0.19 and/ or a CIEy color coordinate of between 0.75 and 1.20, preferably between 0.76 and 1.05, more preferably between 0.77 and 0.95 or even more preferably between 0.78 and 0.90 or even between 0.79 and 0.85.

A further embodiment of the present invention relates to an OLED, which emits light with CIEx and CIEy color coordinates close to the CIEx (= 0.708) and CIEy (= 0.292) color coordinates of the primary color red (CIEx = 0.708 and CIEy = 0.292) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al. doi:10.1002/sdtp.10480). Accordingly, a further embodiment of the present invention relates to an OLED, whose emission exhibits a CIEx color coordinate of between 0.60 and 0.88, preferably between 0.61 and 0.83, more preferably between 0.63 and 0.78 or even more preferably between 0.66 and 0.76 or even between 0.68 and 0.73 and/ or a CIEy color coordinate of between 0.25 and 0.70, preferably between 0.26 and 0.55, more preferably between 0.27 and 0.45 or even more preferably between 0.28 and 0.40 or even between 0.29 and 0.35.

As used throughout the present application, the terms "aryl" and "aromatic" may be understood in the broadest sense as any mono-, bi- or polycyclic aromatic moieties. If not otherwise indicated, an aryl may also be optionally substituted by one or more substituents which are exemplified further throughout the present application. Accordingly, the term "arylene" refers to a divalent residue that bears two binding sites to other molecular structures and thereby serving as a linker structure. As used throughout the present application, the terms "heteroaryl" and "heteroaromatic" may be understood in the broadest sense as any mono-, bi- or polycyclic heteroaromatic moieties that include at least one heteroatom, in particular which bear from one to three heteroatoms per aromatic ring. Exemplarily, a heteroaromatic compound may be pyrrole, furan, thiophene, imidazole, oxazole, thiazole, triazole, pyrazole, pyridine, pyrazine and pyrimidine, and the like. If not otherwise indicated, a heteroaryl may also be optionally substituted by one or more substituents which are exemplified further throughout the present application. Accordingly, the term "heteroarylene" refers to a divalent residue that bears two binding sites to other molecular structures and thereby serving as a linker structure.

As used throughout the present application, the term "alkyl" may be understood in the broadest sense as both, linear or branched chain alkyl residue. Preferred alkyl residues are those containing from one to fifteen carbon atoms. Exemplarily, an alkyl residue may be methyl, ethyl, propyl, isopropyl, butyl, isobutyl, tert-butyl, and the like. If not otherwise indicated, an alkyl may also be optionally substituted by one or more substituents which are exemplified further throughout the present application. Accordingly, the term "alkylene" refers to a divalent residue that bears two binding sites to other molecular structures and thereby serving as a linker structure.

If not otherwise indicated, as used herein, in particular in the context of aryl, arylene, heteroaryl, alkyl and the like, the term "substituted" may be understood in the broadest sense. Preferably, such substitution means a residue selected from the group consisting of $C_1$-$C_{20}$-alkyl, $C_7$-$C_{19}$-alkaryl, and $C_6$-$C_{18}$-aryl. Accordingly, preferably, no charged moiety, more preferably no functional group is present in such substitution.

It will be noticed that hydrogen can, at each occurrence, be replaced by deuterium.

Unless otherwise specified, any of the layers of the various embodiments may be deposited by any suitable method. The layers in the context of the present invention, including the light-emitting layer B, may optionally be prepared by means of liquid processing (also designated as "film processing", "fluid processing", "solution processing" or "solvent processing"). This means that the components comprised in the respective layer are applied to the surface of a part of a device in liquid state. Preferably, the layers in the context of the present invention, including the light-emitting layer B, may be prepared by means of spin-coating. This method well-known to those skilled in the art allows obtaining thin and (essentially) homogeneous layers.

Alternatively, the layers in the context of the present invention, including the light-emitting layer B, may be prepared by other methods based on liquid processing such as, e.g., casting (e.g., drop-casting) and rolling methods, and printing methods (e.g., inkjet printing, gravure printing, blade coating). This may optionally be carried out in an inert atmosphere (e.g., in a nitrogen atmosphere).

In another preferred embodiment, the layers in the context of the present invention may be prepared by any other method known in the art, including but not limited to vacuum processing methods well-known to those skilled in the art such as, e.g., thermal (co-)evaporation, organic vapor phase deposition (OVPD), and deposition by organic vapor

jet printing (OVJP).

When preparing layers by means of liquid processing, the solutions including the components of the layers (i.e., with respect to the light-emitting layer B of the present invention, at least one host compound $H^B$ and, typically, at least one first TADF material $E^B$, at least one second TADF material $S^B$ and optionally one or more other host compounds $H^{B2}$) may further comprise a volatile organic solvent. Such volatile organic solvent may optionally be one selected from the group consisting of tetrahydrofuran, dioxane, chlorobenzene, diethylene glycol diethyl ether, 2-(2-ethoxyethoxy)ethanol, gamma-butyrolactone, N-methyl pyrrolidinon, ethoxyethanol, xylene, toluene, anisole, phenetol, acetonitrile, tetrahydrothiophene, benzonitrile, pyridine, trihydrofuran, triarylamine, cyclohexanone, acetone, propylene carbonate, ethyl acetate, benzene and PGMEA (propylen glycol monoethyl ether acetate). Also a combination of two or more solvents may be used. After applied in liquid state, the layer may subsequently be dried and/or hardened by any means of the art, exemplarily at ambient conditions, at increased temperature (e.g., about 50 °C or about 60 °C) or at diminished pressure.

Optionally, an organic electroluminescent device (e.g., an OLED) may exemplarily be an essentially white organic electroluminescent device or a blue organic electroluminescent device. Exemplarily such white organic electroluminescent device may comprise at least one (deep) blue emitter compound (e.g., TADF material $E^B$) and one or more emitter compounds emitting green and/or red light. Then, there may also optionally be energy transmittance between two or more compounds as described above.

The organic electroluminescent device as a whole may also form a thin layer of a thickness of not more than 5 mm, more than 2 mm, more than 1 mm, more than 0.5 mm, more than 0.25 mm, more than 100 $\mu$m, or more than 10 $\mu$m.

An organic electroluminescent device (e.g., an OLED) may be a small-sized (e.g., having a surface not larger than 5 $mm^2$, or even not larger than 1 $mm^2$), medium-sized (e.g., having a surface in the range of 0.5 to 20 $cm^2$), or a large-sized (e.g., having a surface larger than 20 $cm^2$). An organic electroluminescent device (e.g., an OLED) according to the present invention may optionally be used for generating screens, as large-area illuminating device, as luminescent wallpaper, luminescent window frame or glass, luminescent label, luminescent poser or flexible screen or display. Next to the common uses, an organic electroluminescent device (e.g., an OLED) may exemplarily also be used as luminescent films, "smart packaging" labels, or innovative design elements. Further they are usable for cell detection and examination (e.g., as bio labelling).

One of the main purposes of an organic electroluminescent device is the generation of light. Thus, the present invention further relates to a method for generating light of a desired wavelength range, comprising the step of providing an organic electroluminescent device according to any the present invention.

Accordingly, a further aspect of the present invention relates to a method for generating light of a desired wavelength range, comprising the steps of

(i) providing an organic electroluminescent device according to the present invention; and
(ii) applying an electrical current to said organic electroluminescent device.

A further aspect of the present invention relates to a process of making the organic electroluminescent devices by assembling the elements described above. The present invention also relates to a method for generating blue, green, yellow, orange, red or white light, in particular blue or white light by using said organic electroluminescent device. The invention is illustrated by the examples and claims.

## Examples

*Cyclic voltammetry*

Cyclic voltammograms of solutions having concentration of 10-3 mol/l of the organic molecules in dichloromethane or a suitable solvent and a suitable supporting electrolyte (e.g. 0.1 mol/l of tetrabutylammonium hexafluorophosphate) are measured. The measurements are conducted at room temperature and under nitrogen atmosphere with a three-electrode assembly (Working and counter electrodes: Pt wire, reference electrode: Pt wire) and calibrated using $FeCp_2/FeCp_2^+$ as internal standard. HOMO data was corrected using ferrocene as internal standard against SCE.

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration were used. The Turbomole program package was used for all calculations.

*Photophysical measurements*

Sample Preparation of host material and organic TADF emitters:

Stock solution 1: 10 mg of sample (organic TADF material or host material) is dissolved in 1 ml of solvent.
Stock solution 2: 10 mg of PMMA is dissolved in 1 ml solvent.

The solvent is typically selected from toluene, chlorobenzene, dichloromethane and chloroform.
An Eppendorf pipette is used to add 1 ml of stock solution 1 to 9 ml of stock solution 2 to achieve a 10% by weight of sample in PMMA.
Alternatively, the photophysical properties of host material can be characterized in neat films of host material.
Sample Preparation of fluorescence emitters and NRCT emitters:

Stock solution 1: 10 mg of sample (fluorescence emitters and NRCT emitters) is dissolved in 1 ml of solvent.
Stock solution 1a: 9 ml of solvent is added to1 ml of stock solution 1.
Stock solution 2: 10 mg of PMMA is dissolved in 1 ml solvent.

The solvent is typically selected from toluene, chlorobenzene, dichloromethane and chloroform.
An Eppendorf pipette is used to add 1ml of stock solution 1 to 9.9 ml of stock solution 2 to achieve a 1% by weight of sample in PMMA.
Alternatively, the photophysical properties of fluorescence emitters can be characterized in solution, wherein a concentration of 0.001 mg/ml of fluorescence emitter in solution is used.

Sample pretreatment: Spin-coating
Apparatus: Spin150, SPS euro.
Program: 1) 3 s at 400 U/min; 20 s at 1000 U/min at 1000 Upm/s. 3) 10 s at 4000 U/min at 1000 Upm/s. After coating, the films are dried at 70 °C for 1 min. Photoluminescence spectroscopy and TCSPC (*Time-correlated single-photon counting*)

Steady-state emission spectroscopy is recorded using a Horiba Scientific, Modell FluoroMax-4 equipped with a 150 W Xenon-Arc lamp, excitation- and emissions monochromators and a Hamamatsu R928 photomultiplier and a time-correlated single-photon counting option. Emissions and excitation spectra are corrected using standard correction fits.
Excited state lifetimes are determined employing the same system using the TCSPC method with FM-2013 equipment and a Horiba Yvon TCSPC hub.

Excitation sources:

NanoLED 370 (wavelength: 371 nm, puls duration: 1,1 ns)
NanoLED 290 (wavelength: 294 nm, puls duration: <1 ns)
SpectraLED 310 (wavelength: 314 nm)
SpectraLED 355 (wavelength: 355 nm).

Data analysis (exponential fit) was done using the software suite DataStation and DAS6 analysis software. The fit is specified using the chi-squared-test.

*Photoluminescence quantum yield measurements*

For photoluminescence quantum yield (PLQY) measurements an *Absolute PL Quantum Yield Measurement C9920-03G* system (*Hamamatsu Photonics*) is used. Quantum yields and CIE coordinates were determined using the software U6039-05 version 3.6.0.
Emission maxima are given in nm, quantum yields $\Phi$ in % and CIE coordinates as x,y values.
PLQY was determined using the following protocol:

1) Quality assurance: Anthracene in ethanol (known concentration) is used as reference
2) Excitation wavelength: the absorption maximum of the organic molecule is determined and the molecule is excited using this wavelength
3) Measurement

Quantum yields are measured for sample of solutions or films under nitrogen atmosphere. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. is the intensity.

*Production and characterization of organic electroluminescence devices*

Via vacuum-deposition methods OLED devices comprising organic molecules according to the invention can be produced. If a layer contains more than one compound, the weight-percentage of one or more compounds is given in %. The total weight-percentage values amount to 100 %, thus if a value is not given, the fraction of this compound equals to the difference between the given values and 100 %.

The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density, which is given in mA/cm$^2$. The LT50 value corresponds to the time, where the measured luminance decreased to 50 % of the initial luminance, analogously LT80 corresponds to the time point, at which the measured luminance decreased to 80 % of the initial luminance, LT97 to the time point, at which the measured luminance decreased to 97 % of the initial luminance etc.

Accelerated lifetime measurements are performed (e.g. applying increased current densities). Exemplarily LT80 values at 500 cd/m$^2$ are determined using the following equation:

$$\mathrm{LT80}\left(500\frac{cd^2}{m^2}\right) = \mathrm{LT80}(L_0)\left(\frac{L_0}{500\frac{cd^2}{m^2}}\right)^{1.6}$$

wherein $L_0$ denotes the initial luminance at the applied current density.

The values correspond to the average of several pixels (typically two to eight), the standard deviation between these pixels is given. Figures show the data series for one OLED pixel.

Example D1 and comparative examples C1 and C2

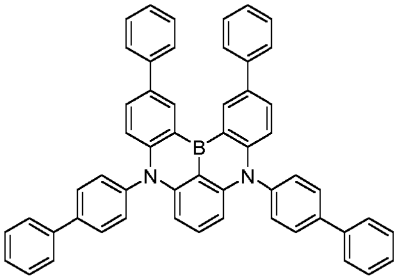

TADF1

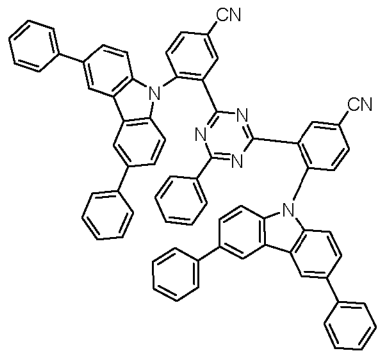

Emitter1

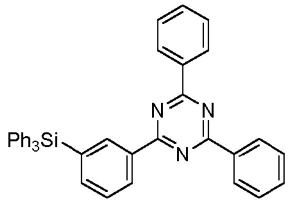

HBL1

Table 1. Physicochemical properties oft he ingredients

| | $E^{HOMO}$ [eV] | $E^{LUMO}$ [eV] | S1 [eV] | T1 [eV] |
|---|---|---|---|---|
| mCBP ($H^B$) | -6.02 | -2.42 | 3.60 | 2.82 |
| TADF1 ($E^B$) | -5.48 | -2.73 | 2.75 | 2.59 |
| Emitter1 ($S^B$) | -5.99 | -3.35 | 2.64 | |

Table 2. Examples of setups of devices

| Layer | Thickness | D1 | C1 |
|---|---|---|---|
| 10 | 100 nm | Al | Al |
| 9 | 2 nm | Liq | Liq |
| 8 | 20 nm | NBPhen | NBPhen |
| 7 | 10 nm | HBL1 | HBL1 |
| 6 | 50 nm | TADF1 (1%): Emitter1 (15%) : mCBP (84%) | Emitter1 (15%) : mCBP (85%) |
| 5 | 10 nm | mCBP | mCBP |
| 4 | 10 nm | TCTA | TCTA |
| 3 | 40 nm | NPB | NPB |
| 2 | 5 nm | HAT-CN | HAT-CN |
| 1 | 50 nm | ITO | ITO |
| substrate | | glass | glass |

Device **D1** yielded an external quantum efficiency (EQE) at 1000 cd/$m^2$ of 16.7 % LT80 value at 15 mA/$cm^2$ was determined to be 558 h. The emission maximum is at 519 nm nm at 10 mA/$cm^2$. The corresponding CIEx value is

0.314 and CIEy is 0.589.

Comparative device **C1** comprises the same layer arrangement as device **D1,** except that the emitting layer contains only **Emitter1** and mCBP. The EQE at 1000 cd/m$^2$ is 14.5 % and the lifetime LT80 value at 15 mA/cm$^2$ was determined to be 111 h. The emission maximum is at 516 nm at 10 mA/cm$^2$. The corresponding CIEx value is 0.293 and CIEy is 0.596.

In a direct comparison of device D1 and Comparative device C1, an increased LT80 value at 15 mA/cm$^2$ by a factor 5.03 and an increased external quantum efficiency at 1000 cd/m$^2$ by a factor of 1.15 can be observed.

**Additional material properties**

**TADF1**

The emission maximum of **TADF1** (1% by weight in PMMA) is at 469 nm, the full width at half maximum (FWHM) is 0.16 eV, the CIEy coordinate is 0.16 and the PLQY is 80%.

**Emitter1**

The emission maximum of **Emitter1** (10% by weight in PMMA) is at 521 nm, the CIEy coordinate is 0.56 and the PLQY is 59%.

## Claims

1. An organic electroluminescent device comprising a light-emitting layer B comprising:

(i) a host material $H^B$, which has a lowermost excited singlet state energy level $S1^H$, a lowermost excited triplet state energy level $T1^H$, and a highest occupied molecular orbital HOMO($H^B$) having an energy $E^{HOMO}(H^B)$;
(ii) a first thermally activated delayed fluorescence (TADF) material $E^B$, which has a lowermost excited singlet state energy level $S1^E$, a lowermost excited triplet state energy level $T1^E$, and a highest occupied molecular orbital HOMO($E^B$) having an energy $E^{HOMO}(E^B)$; and
(iii) an emitter material $S^B$, which has a lowermost excited singlet state energy level $S1^S$ and a highest occupied molecular orbital HOMO($S^B$) having an energy $E^{HOMO}(S^B)$;
wherein the relations expressed by the following formulas (1) to (5) apply:

$$S1^H > S1^E \qquad (1)$$

$$S1^H > S1^S \qquad (2)$$

$$S1^E > S1^S \qquad (3)$$

$$E^{HOMO}(E^B) > E^{HOMO}(S^B) \qquad (4)$$

$$E^{HOMO}(E^B) > E^{HOMO}(H^B) \qquad (5),$$

**characterized in that** the
TADF material $E^B$ comprises or consists of a structure according to Formula I-NRCT:

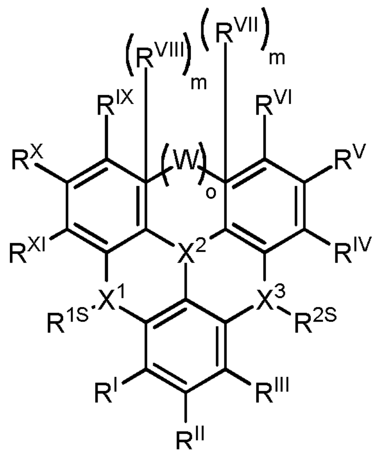

Formula I-NRCT

wherein
o is 0 or 1;
m = 1-o;
$X^1$ is N or B;
$X^2$ is N or B;
$X^3$ is N or B;
W is selected from the group consisting of $Si(R^{3S})_2$, $C(R^{3S})_2$ and $BR^{3S}$;
each of $R^{1S}$, $R^{2S}$ and $R^{3S}$ is independently from each other selected from the group consisting of:

$C_1$-$C_5$-alkyl,
which is optionally substituted with one or more substituents $R^{6S}$;
$C_6$-$C_{60}$-aryl,
which is optionally substituted with one or more substituents $R^{6S}$; and
$C_3$-$C_{57}$-heteroaryl,
which is optionally substituted with one or more substituents $R^{6S}$;

each of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ is independently from another selected from the group consisting of:
hydrogen, deuterium, $N(R^{5S})_2$, $OR^{5S}$, $Si(R^{5S})_3$, $B(OR^{5S})_2$, $OSO_2R^{5S}$, $CF_3$, CN, halogen,
$C_1$-$C_{40}$-alkyl,

which is optionally substituted with one or more substituents $R^{5S}$ and
wherein one or more non-adjacent $CH_2$-groups are each optionally substituted by $R^{5S}C=CR^{5S}$, $C\equiv C$, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S or $CONR^{5S}$;

$C_1$-$C_{40}$-alkoxy,

which is optionally substituted with one or more substituents $R^{5S}$ and
wherein one or more non-adjacent $CH_2$-groups are each optionally substituted by $R^{5S}C=CR^{5S}$, $C\equiv C$, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S or $CONR^{5S}$;

$C_1$-$C_{40}$-thioalkoxy,

which is optionally substituted with one or more substituents $R^{5S}$ and
wherein one or more non-adjacent $CH_2$-groups are each optionally substituted by $R^{5S}C=CR^{5S}$, $C\equiv C$, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S or $CONR^{5S}$;

$C_2$-$C_{40}$-alkenyl,

which is optionally substituted with one or more substituents $R^{5S}$ and
wherein one or more non-adjacent $CH_2$-groups are each optionally substituted by $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S or $CONR^{5S}$;

$C_2$-$C_{40}$-alkynyl,

which is optionally substituted with one or more substituents $R^{5S}$ and
wherein one or more non-adjacent $CH_2$-groups are each optionally substituted by $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S or $CONR^{5S}$;

$C_6$-$C_{60}$-aryl,
which is optionally substituted with one or more substituents $R^{5S}$; and
$C_3$-$C_{57}$-heteroaryl,
which is optionally substituted with one or more substituents $R^{5S}$;
$R^{5S}$ is at each occurrence independently from another selected from the group consisting of: hydrogen, deuterium, OPh, $CF_3$, CN, F,
$C_1$-$C_5$-alkyl,
wherein optionally one or more hydrogen atoms are independently from each other substituted by deuterium, CN, $CF_3$, or F;
$C_1$-$C_5$-alkoxy,
wherein optionally one or more hydrogen atoms are independently from each other substituted by deuterium, CN, $CF_3$, or F;
$C_1$-$C_5$-thioalkoxy,
wherein optionally one or more hydrogen atoms are independently from each other substituted by deuterium, CN, $CF_3$, or F;
$C_2$-$C_5$-alkenyl,
wherein optionally one or more hydrogen atoms are independently from each other substituted by deuterium, CN, $CF_3$, or F;
$C_2$-$C_5$-alkynyl,
wherein optionally one or more hydrogen atoms are independently from each other substituted by deuterium, CN, $CF_3$, or F;
$C_6$-$C_{18}$-aryl,
which is optionally substituted with one or more $C_1$-$C_5$-alkyl substituents;
$C_3$-$C_{17}$-heteroaryl,
which is optionally substituted with one or more $C_1$-$C_5$-alkyl substituents;
$N(C_6$-$C_{18}$-$aryl)_2$,
$N(C_3$-$C_{17}$-$heteroaryl)_2$; and
$N(C_3$-$C_{17}$-heteroaryl$)(C_6$-$C_{18}$-aryl$)$;
$R^{6S}$ is at each occurrence independently from another selected from the group consisting of hydrogen, deuterium, OPh, $CF_3$, CN, F,
$C_1$-$C_5$-alkyl,
wherein optionally one or more hydrogen atoms are independently from each other substituted by deuterium, CN, $CF_3$, or F;
$C_1$-$C_5$-alkoxy,
wherein optionally one or more hydrogen atoms are independently from each other substituted by deuterium, CN, $CF_3$, or F;
$C_1$-$C_5$-thioalkoxy,
wherein optionally one or more hydrogen atoms are independently from each other substituted by deuterium, CN, $CF_3$, or F;
$C_2$-$C_5$-alkenyl,
wherein optionally one or more hydrogen atoms are independently from each other substituted by deuterium, CN, $CF_3$, or F;
$C_2$-$C_5$-alkynyl,
wherein optionally one or more hydrogen atoms are independently from each other substituted by deuterium, CN, $CF_3$, or F;
$C_6$-$C_{18}$-aryl,
which is optionally substituted with one or more $C_1$-$C_5$-alkyl substituents;
$C_3$-$C_{17}$-heteroaryl,

which is optionally substituted with one or more $C_1$-$C_5$-alkyl substituents;
$N(C_6$-$C_{18}$-aryl$)_2$,
$N(C_3$-$C_{17}$-heteroaryl$)_2$; and
$N(C_3$-$C_{17}$-heteroaryl$)(C_6$-$C_{18}$-aryl);
wherein two or more of the substituents selected from the group consisting of $R^I$, $R^{II}$, $R^{III}$, $R^{IV}$, $R^V$, $R^{VI}$, $R^{VII}$, $R^{VIII}$, $R^{IX}$, $R^X$, and $R^{XI}$ that are positioned adjacent to another may optionally each form a mono- or polycyclic, aliphatic, aromatic and/or benzo-fused ring system with another; and
wherein at least one of $X^1$, $X^2$ and $X^3$ is B and at least one of $X^1$, $X^2$ and $X^3$ is N.

2. The organic electroluminescent device according to claim 1, wherein at least one of the following formulas (6) and (7) applies

$$0.2\ \text{eV} \leq E^{HOMO}(E^B) - E^{HOMO}(S^B) \leq 0.8\ \text{eV} \qquad (6).$$

$$0.2\ \text{eV} \leq E^{HOMO}(E^B) - E^{HOMO}(H^B) \leq 0.8\ \text{eV} \qquad (7).$$

3. The organic electroluminescent device according to any of claims 1 or 2, the TADF material $E^B$ is **characterized in that** it has a $\Delta E_{ST}$ value, which corresponds to the energy difference between $S1^E$ and $T1^E$, of less than 0.4 eV.

4. The organic electroluminescent device according to any of claims 1 to 3, wherein the relation expressed by formula (8) applies:

$$S1^S > T1^E \qquad (8).$$

5. The organic electroluminescent device according to any of claims 1 to 4, wherein the mass ratio of the emitter material $S^B$ to TADF material $E^B$ ($S^B : E^B$) is >1.

6. The organic electroluminescent device according to any of claims 1 to 5, wherein said organic electroluminescent device is a device selected from the group consisting of an organic light emitting diode, a light emitting electrochemical cell, and a light-emitting transistor.

7. The organic electroluminescent device according to any of claims 1 to 2. 6, wherein the emitter material $S^B$ has a lowermost excited triplet state energy level $T1^S$, wherein the emitter material $S^B$ is selected from the group consisting of a fluorescence emitter and an organic TADF emitter, whereas the organic TADF emitter is **characterized in that** it has a $\Delta E_{ST}$ value, which corresponds to the energy difference between $S1^S$ and $T1^S$, of less than 0.4 eV.

8. The organic electroluminescent device according to any of claims 1 to 7, wherein the relation expressed by formula (10a), (10b) or (10c) applies:

$$E^{HOMO}(H^B) > E^{HOMO}(S^B) \qquad (10a)$$

$$E^{HOMO}(S^B) > E^{HOMO}(H^B) \qquad (10b)$$

$$-0.1\ \text{eV} \leq E^{HOMO}(H^B) - E^{HOMO}(S^B) \leq 0.1\ \text{eV} \qquad (10c).$$

9. The organic electroluminescent device according to any of claims 1 to 8, wherein the relation between the lowest unoccupied molecular orbital LUMO($E^B$) having an energy $E^{LUMO}(E^B)$ and the lowest unoccupied molecular orbital LUMO($S^B$) having an energy $E^{LUMO}(S^B)$ expressed by formula (11) applies:

$$E^{LUMO}(E^B) > E^{LUMO}(S^B) \qquad (11).$$

**10.** The organic electroluminescent device according to any of claims 1 to 9, wherein the light-emitting layer B comprises:

(i) 39.8-98 % by weight of the host compound $H^B$;
(ii) 0.1-50 % by weight of the TADF material $E^B$; and
(iii) 0.1-50 % by weight of emitter material $S^B$; and optionally
(iv) 0-60 % by weight of one or more further host compounds $H^{B2}$ differing from $H^B$; and optionally
(v) 0-60 % by weight of one or more solvents.

**11.** The organic electroluminescent device according to any of claims 1 to 10, wherein the light-emitting layer B comprises the TADF material $E^B$ in 0.1-10 % by weight.

**12.** The organic electroluminescent device according to any of claims 1 to 11, wherein the device exhibits an emission maximum $\lambda_{max}(D)$ of 440 to 560 nm.

**13.** A method for generating visible light comprising the steps of:

(i) providing the organic electroluminescent device according to any of claims 1 to 12; and
(ii) applying an electrical current to the organic electroluminescent device.

**14.** Use of the thermally activated delayed fluorescence (TADF) material $E^B$ in combination with at least one host material $H^B$ and at least one emitter material $S^B$ in the light-emitting layer B, **characterized in that** the light emitting layer B is as in any of claims 1 to 13, for increasing the lifetime of the organic electroluminescent device.

## Patentansprüche

**1.** Organische elektrolumineszente Vorrichtung mit einer lichtemittierenden Schicht B, umfassend:

(i) ein Wirtsmaterial $H^B$, das ein unterstes angeregtes Singulett-Zustand-Energieniveau $S1^H$, ein unterstes angeregtes Triplett-Zustand-Energieniveau $T1^H$, und ein höchstes besetztes Molekülorbital HOMO($H^B$) mit einer Energie $E^{HOMO}(H^B)$ aufweist;
(ii) ein erstes thermisch aktivierte verzögerte Fluoreszenz (engl. thermally activated delayed fluorescence) (TADF-) Material $E^B$, das ein unterstes angeregtes Singulett-Zustand-Energieniveau $S1^E$, ein unterstes angeregtes Triplett-Zustand-Energieniveau $T1^E$, und ein höchstes besetztes Molekülorbital HOMO($E^B$) mit einer Energie $E^{HOMO}(E^B)$ aufweist; und
(iii) ein Emitter-Material $S^B$, das ein unterstes angeregtes Singulett-Zustand-Energieniveau $S1^S$ und ein höchstes besetztes Molekülorbital HOMO($S^B$) mit einer Energie $E^{HOMO}(S^B)$ aufweist;
wobei die Beziehungen, die durch die folgenden Formeln (1) bis (5) ausgedrückt werden, gelten:

$$S1^H > S1^E \quad (1)$$

$$S1^H > S1^S \quad (2)$$

$$S1^E > S1^S \quad (3)$$

$$E^{HOMO}(E^B) > E^{HOMO}(S^B) \quad (4)$$

$$E^{HOMO}(E^B) > E^{HOMO}(H^B) \quad (5),$$

dadurch charakterisiert, dass das TADF-Material $E^B$ umfasst oder besteht aus einer Struktur gemäß Formel I-NRCT:

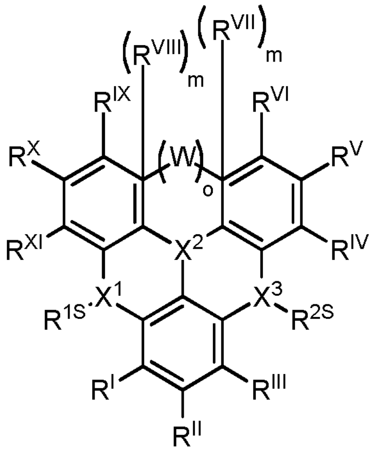

Formel I-NRCT

wobei
o 0 oder 1 ist;
m = 1-o;
$X^1$ N oder B ist;
$X^2$ N oder B ist;
$X^3$ N oder B ist;
W ausgewählt ist aus der Gruppe bestehend aus $Si(R^{3S})_2$, $C(R^{3S})_2$ und $BR^{3S}$;
jeder von $R^{1S}$, $R^{2S}$ und $R^{3S}$ unabhängig voneinander ausgewählt ist aus der Gruppe bestehend aus:

$C_1$-$C_5$-Alkyl,
das gegebenenfalls mit einem oder mehreren Substituenten $R^{6S}$ substituiert ist;
$C_6$-$C_{60}$-Aryl,
das gegebenenfalls mit einem oder mehreren Substituenten $R^{6S}$ substituiert ist; und
$C_3$-$C_{57}$-Heteroaryl,
das gegebenenfalls mit einem oder mehreren Substituenten $R^{6S}$ substituiert ist;

jeder von $R^I$, $R^{II}$, $R^{III}$, $R^{IV}$, $R^V$, $R^{VI}$, $R^{VII}$, $R^{VIII}$, $R^{IX}$, $R^X$ und $R^{XI}$ unabhängig von einander ausgewählt ist aus der Gruppe bestehend aus:

Wasserstoff, Deuterium, $N(R^{5S})_2$, $OR^{5S}$, $Si(R^{5S})_3$, $B(OR^{5S})_2$, $OSO_2R^{5S}$, $CF_3$, CN, Halogen,
$C_1$-$C_{40}$-Alkyl,

das gegebenenfalls mit einem oder mehreren Substituenten $R^{5S}$ substituiert ist und
wobei einer oder mehr nicht benachbarte $CH_2$-Gruppen jeweils substituiert sind durch $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S oder $CONR^{5S}$;

$C_1$-$C_{40}$-Alkoxy,

das gegebenenfalls mit einem oder mehreren Substituenten $R^{5S}$ substituiert ist und
wobei einer oder mehr nicht benachbarte $CH_2$-Gruppen jeweils substituiert sind durch $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S oder $CONR^{5S}$;

$C_1$-$C_{40}$-Thioalkoxy,

das gegebenenfalls mit einem oder mehreren Substituenten $R^{5S}$ substituiert ist und
wobei einer oder mehr nicht benachbarte $CH_2$-Gruppen jeweils substituiert sind durch $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S oder $CONR^{5S}$;

$C_2$-$C_{40}$-Alkenyl,

das gegebenenfalls mit einem oder mehreren Substituenten $R^{5S}$ substituiert ist und wobei einer oder mehr nicht benachbarte $CH_2$-Gruppen jeweils substituiert sind durch $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S oder $CONR^{5S}$;

$C_2$-$C_{40}$-Alkinyl,

das gegebenenfalls mit einem oder mehreren Substituenten $R^{5S}$ substituiert ist und wobei einer oder mehr nicht benachbarte $CH_2$-Gruppen jeweils substituiert sind durch $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S oder $CONR^{5S}$;

$C_6$-$C_{60}$-Aryl,
das gegebenenfalls mit einem oder mehreren Substituenten $R^{5S}$ substituiert ist; und
$C_3$-$C_{57}$-Heteroaryl,
das gegebenenfalls mit einem oder mehreren Substituenten $R^{5S}$ substituiert ist;
$R^{5S}$ bei jedem Auftreten unabhängig voneinander ausgewählt ist aus der Gruppe bestehend aus: Wasserstoff, Deuterium, OPh, $CF_3$, CN, F,
$C_1$-$C_5$-Alkyl,
wobei gegebenenfalls ein oder mehrere Wasserstoffatome unabhängig voneinander substituiert sind durch Deuterium, CN, $CF_3$ oder F;
$C_1$-$C_5$-Alkoxy,
wobei gegebenenfalls ein oder mehrere Wasserstoffatome unabhängig voneinander substituiert sind durch Deuterium, CN, $CF_3$ oder F;
$C_1$-$C_5$-Thioalkoxy,
wobei gegebenenfalls ein oder mehrere Wasserstoffatome unabhängig voneinander substituiert sind durch Deuterium, CN, $CF_3$ oder F;
$C_2$-$C_5$-Alkenyl,
wobei gegebenenfalls ein oder mehrere Wasserstoffatome unabhängig voneinander substituiert sind durch Deuterium, CN, $CF_3$ oder F;
$C_2$-$C_5$-Alkinyl,
wobei gegebenenfalls ein oder mehrere Wasserstoffatome unabhängig voneinander substituiert sind durch Deuterium, CN, $CF_3$ oder F;
$C_6$-$C_{18}$-Aryl,
das optional substituiert ist mit einem oder mehr $C_1$-$C_5$-Alkyl-Substituenten;
$C_3$-$C_{17}$-Heteroaryl,
das optional substituiert ist mit einem oder mehr $C_1$-$C_5$-Alkyl-Substituenten;
$N(C_6$-$C_{18}$-$Aryl)_2$,
$N(C_3$-$C_{17}$-$Heteroaryl)_2$; und
$N(C_3$-$C_{17}$-Heteroaryl)($C_6$-$C_{18}$-Aryl);
$R^{6S}$ bei jedem Auftreten unabhängig voneinander ausgewählt ist aus der Gruppe bestehend aus Wasserstoff, Deuterium, OPh, $CF_3$, CN, F,
$C_1$-$C_5$-Alkyl,
wobei gegebenenfalls ein oder mehrere Wasserstoffatome unabhängig voneinander substituiert sind durch Deuterium, CN, $CF_3$, oder F;
$C_1$-$C_5$-Alkoxy,
wobei gegebenenfalls ein oder mehrere Wasserstoffatome unabhängig voneinander substituiert sind durch Deuterium, CN, $CF_3$, oder F;
$C_1$-$C_5$-Thioalkoxy,
wobei gegebenenfalls ein oder mehrere Wasserstoffatome unabhängig voneinander substituiert sind durch Deuterium, CN, $CF_3$, oder F;
$C_2$-$C_5$-Alkenyl,
wobei gegebenenfalls ein oder mehrere Wasserstoffatome unabhängig voneinander substituiert sind durch Deuterium, CN, $CF_3$, oder F;
$C_2$-$C_5$-Alkinyl,
wobei gegebenenfalls ein oder mehrere Wasserstoffatome unabhängig voneinander substituiert sind durch

Deuterium, CN, $CF_3$, oder F;
$C_6$-$C_{18}$-Aryl,
das optional substituiert ist mit einem oder mehr $C_1$-$C_5$-Alkyl-Substituenten;
$C_3$-$C_{17}$-heteroaryl,
das optional substituiert ist mit einem oder mehr $C_1$-$C_5$-Alkyl-Substituenten;
$N(C_6$-$C_{18}$-Aryl$)_2$,
$N(C_3$-$C_{17}$-Heteroaryl$)_2$; und
$N(C_3$-$C_{17}$-Heteroaryl$)(C_6$-$C_{18}$-Aryl);
wobei zwei oder mehr der Substituenten ausgewählt aus der Gruppe bestehend aus $R^I$, $R^{II}$, $R^{III}$, $R^{IV}$, $R^V$, $R^{VI}$, $R^{VII}$, $R^{VIII}$, $R^{IX}$, $R^X$ und $R^{XI}$, die benachbart zueinander positioniert sind, optional jeweils ein mono- oder polyzyklisches, aliphatisches, aromatisches und/der benzokondensiertes Ringsystem bilden können; und
wobei mindestens einer von $X^1$, $X^2$ und $X^3$ B ist und mindestens einer von $X^1$, $X^2$ und $X^3$ N ist.

**2.** Organische elektrolumineszente Vorrichtung gemäß Anspruch 1, wobei mindestens eine der folgenden Formeln (6) und (7) gilt

$$0{,}2\ \text{eV} \leq E^{HOMO}(E^B) - E^{HOMO}(S^B) \leq 0{,}8\ \text{eV} \qquad (6).$$

$$0{,}2\ \text{eV} \leq E^{HOMO}(E^B) - E^{HOMO}(H^B) \leq 0{,}8\ \text{eV} \qquad (7).$$

**3.** Organische elektrolumineszente Vorrichtung gemäß einem der Ansprüche 1 oder 2, wobei das TADF-Material $E^B$ **dadurch gekennzeichnet ist, dass** es einen $\Delta E_{ST}$-Wert, welcher der Energiedifferenz zwischen $S1^E$ und $T1^E$ entspricht, von weniger als 0,4 eV aufweist.

**4.** Organische elektrolumineszente Vorrichtung gemäß einem der Ansprüche 1 bis 3, wobei die Beziehung, die durch Formel (8) ausgedrückt wird, gilt:

$$S1^S > T1^E \qquad (8).$$

**5.** Organische elektrolumineszente Vorrichtung gemäß einem der Ansprüche 1 bis 4, wobei das Massenverhältnis des Emitter-Materials $S^B$ zu TADF-Material $E^B$ ($S^B : E^B$) >1 ist.

**6.** Organische elektrolumineszente Vorrichtung gemäß einem der Ansprüche 1 bis 5, wobei die organische elektrolumineszente Vorrichtung eine Vorrichtung ist, die aus der Gruppe bestehend aus einer organischen Leuchtdiode, einer lichtemittierenden elektrochemischen Zelle und einem lichtemittierenden Transistor ausgewählt ist.

**7.** Organische elektrolumineszente Vorrichtung gemäß einem der Ansprüche 1 bis 6, wobei das Emitter-Material $S^B$ ein unterstes angeregtes Triplett-Zustand-Energieniveau $T1^S$ aufweist,
wobei das Emitter-Material $S^B$ ausgewählt ist aus der Gruppe bestehend aus einem fluorezenten Emitter und einem organischen TADF-Emitter, wobei der organische TADF-Emitter **dadurch gekennzeichnet ist, dass** er einen $\Delta E_{ST}$-Wert, welcher der Energiedifferenz zwischen $S1^S$ und $T1^S$ entspricht, von weniger als 0,4 eV aufweist.

**8.** Organische elektrolumineszente Vorrichtung gemäß einem der Ansprüche 1 bis 7, wobei die Beziehung, die durch Formeln (10a), (10b) oder (10c) augedrückt wird, gilt:

$$E^{HOMO}(H^B) > E^{HOMO}(S^B) \qquad (10a)$$

$$E^{HOMO}(S^B) > E^{HOMO}(H^B) \qquad (10b)$$

$$-0{,}1\ \text{eV} \leq E^{HOMO}(H^B) - E^{HOMO}(S^B) \leq 0{,}1\ \text{eV} \qquad (10c).$$

**9.** Organische elektrolumineszente Vorrichtung gemäß einem der Ansprüche 1 bis 8, wobei die Beziehung zwischen dem niedrigsten unbesetzten Molekülorbital LUMO($E^B$) mit einer Energie $E^{LUMO}(E^B)$ und dem niedrigsten unbesetzten Molekülorbital LUMO($S^B$) mit einer Energie $E^{LUMO}(S^B)$ ausgedrückt durch Formel (11) gilt:

$$E^{LUMO}(E^B) > E^{LUMO}(S^B) \qquad (11).$$

**10.** Organische elektrolumineszente Vorrichtung gemäß einem der Ansprüche 1 bis 9, wobei die lichtemittierende Schicht B umfasst:

(i) 39,8-98 Gewichts-% von der Wirtsverbindung $H^B$;
(ii) 0,1-50 Gewichts-% von dem TADF-Material $E^B$; und
(iii) 0,1-50 Gewichts-% von dem Emitter-Material $S^B$; und optional
(iv) 0-60 Gewichts-% von einer oder mehr weiteren Wirtsverbindungen $H^{B2}$, die sich von $H^B$ unterscheiden; und optional
(v) 0-60 Gewichts-% von einem oder mehr Lösungsmitteln.

**11.** Organische elektrolumineszente Vorrichtung gemäß einem der Ansprüche 1 bis 10, wobei die lichtemittierende Schicht B das TADF-Material $E^B$ in 0,1 - 10 Gewichts-% umfasst.

**12.** Organische elektrolumineszente Vorrichtung gemäß einem der Ansprüche 1 bis 11, wobei die Vorrichtung ein Emissionsmaximum $\lambda_{max}(D)$ von 440 bis 560 nm zeigt.

**13.** Verfahren zum Erzeugen von sichtbarem Licht umfassend die Schritte von:

(i) Bereitstellen der organischen elektrolumineszenten Vorrichtung gemäß einem der Ansprüche 1 bis 12; und
(ii) Anlegen eines elektrischen Stroms an die organische elektrolumineszente Vorrichtung.

**14.** Verwendung des thermisch aktivierte verzögerte Fluoreszenz (TADF-) Materials $E^B$ in Kombination mit mindestens einem Wirtsmaterial $H^B$ und mindestens einem Emitter-Material $S^B$ in der lichtemittierenden Schicht B, **dadurch gekennzeichnet, dass** die lichtemittierende Schicht B wie in einem der Ansprüche 1 bis 13 ist, zur Erhöhung der Lebensdauer der organischen elektrolumineszenten Vorrichtung.

## Revendications

**1.** Dispositif électroluminescent organique comprenant une couche luminescente B comprenant :

(i) un matériau hôte $H^B$, qui possède un niveau d'énergie d'état singulet excité le plus bas $S1^H$, un niveau d'énergie d'état triplet excité le plus bas $T1^H$, une plus haute orbitale moléculaire occupée HOMO($H^B$) possédant une énergie $E^{HOMO}(H^B)$ ;
(ii) un premier matériau $E^B$ à fluorescence retardée activée thermiquement (TADF), qui possède un niveau d'énergie d'état singulet excité le plus bas $S1^E$, un niveau d'énergie d'état triplet excité le plus bas $T1^E$, et une plus haute orbitale moléculaire occupée HOMO($E^B$) possédant une énergie $E^{HOMO}(E^B)$ ; et
(iii) un matériau émetteur $S^B$, qui possède un niveau d'énergie d'état singulet excité le plus bas $S1^S$ et une plus haute orbitale moléculaire occupée HOMO($S^B$) possédant une énergie $E^{HOMO}(S^B)$,
les relations exprimées par les formules suivantes (1) à (5) s'appliquant :

$$S1^H > S1^E \qquad (1)$$

$$S1^H > S1^S \qquad (2)$$

$$S1^E > S1^S \qquad (3)$$

$$E^{HOMO}(E^B) > E^{HOMO}(S^B) \quad (4)$$

$$E^{HOMO}(E^B) > E^{HOMO}(H^B) \quad (5),$$

**caractérisé en ce que** le matériau TADF $E^B$ comprend ou est constitué d'une structure selon la formule I-NRCT :

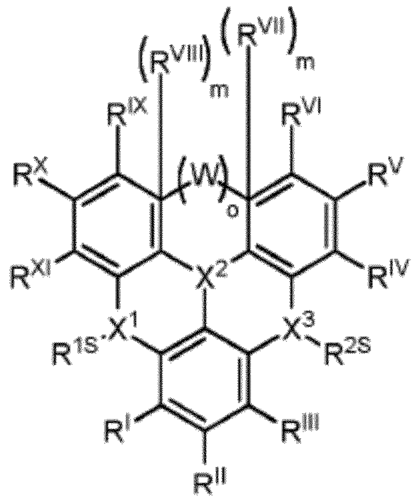

formule I-NRCT

o étant 0 ou 1 ;
m = 1 - o ;
$X^1$ étant N ou B ;
$X^2$ étant N ou B ;
$X^3$ étant N ou B ;
W étant choisi dans le groupe constitué par $Si(R^{3S})_2$, $C(R^{3S})_2$, et $BR^{3S}$
chacun parmi $R^{1S}$, $R^{2S}$ et $R^{3S}$ étant indépendamment les uns des autres choisis dans le groupe constitué par :

$C_{1-5}$-alkyle,
qui est éventuellement substitué par un ou plusieurs substituants $R^{6S}$ ;
$C_{6-60}$-aryle,
qui est éventuellement substitué par un ou plusieurs substituants $R^{6S}$ ; et
$C_{3-57}$-hétéroaryle,
qui est éventuellement substitué par un ou plusieurs substituants $R^{6S}$ ;
chacun parmi $R^I$, $R^{II}$, $R^{III}$, $R^{IV}$, $R^V$, $R^{VI}$, $R^{VII}$, $R^{VIII}$, $R^{IX}$, $R^X$, et $R^{XI}$ étant indépendamment les uns des autres choisis dans le groupe constitué par :

hydrogène, deutérium, $N(R^{5S})_2$, $OR^{5S}$, $Si(R^{5S})_3$, $B(OR^{5S})_2$, $OSO_2R^{5S}$, $CF_3$, CN, halogène,
$C_{1-40}$-alkyle,

qui est éventuellement substitué par un ou plusieurs substituants $R^{5S}$ et
un ou plusieurs groupes $CH_2$ non adjacents étant éventuellement remplacés par $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S, ou $CONR^{5S}$;

$C_{1-40}$-alcoxy,

qui est éventuellement substitué par un ou plusieurs substituants $R^{5S}$ et
un ou plusieurs groupes $CH_2$ non adjacents étant éventuellement remplacés par $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S, ou $CONR^{5S}$;

$C_{1-40}$-thioalcoxy,

qui est éventuellement substitué par un ou plusieurs substituants $R^{5S}$ et un ou plusieurs groupes $CH_2$ non adjacents étant éventuellement remplacés par $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S, ou $CONR^{5S}$;

$C_{2-40}$-alcényle,

qui est éventuellement substitué par un ou plusieurs substituants $R^{5S}$ et un ou plusieurs groupes $CH_2$ non adjacents étant éventuellement remplacés par $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S, ou $CONR^{5S}$;

$C_{2-40}$-alcynyle,

qui est éventuellement substitué par un ou plusieurs substituants $R^{5S}$ et un ou plusieurs groupes $CH_2$ non adjacents étant éventuellement remplacés par $R^{5S}C=CR^{5S}$, C≡C, $Si(R^{5S})_2$, $Ge(R^{5S})_2$, $Sn(R^{5S})_2$, C=O, C=S, C=Se, $C=NR^{5S}$, $P(=O)(R^{5S})$, SO, $SO_2$, $NR^{5S}$, O, S, ou $CONR^{5S}$;

$C_{6-60}$-aryle,
qui est éventuellement substitué par un ou plusieurs substituants $R^{5S}$ ; et
$C_{3-57}$-hétéroaryle,
qui est éventuellement substitué par un ou plusieurs substituants $R^{5S}$ ;
$R^{5S}$ étant en chaque occurrence indépendamment d'un autre choisi dans le groupe constitué par : hydrogène, deutérium, OPh, $CF_3$, CN, F,
$C_{1-5}$-alkyle,
un ou plusieurs atomes d'hydrogène étant éventuellement, indépendamment les uns des autres, remplacés par deutérium, CN, $CF_3$, ou F ;
$C_{1-5}$-alcoxy,
un ou plusieurs atomes d'hydrogène étant éventuellement, indépendamment les uns des autres, remplacés par deutérium, CN, $CF_3$, ou F ;
$C_{1-5}$-thioalcoxy,
un ou plusieurs atomes d'hydrogène étant éventuellement, indépendamment les uns des autres, remplacés par deutérium, CN, $CF_3$, ou F ;
$C_{2-5}$-alcényle,
un ou plusieurs atomes d'hydrogène étant éventuellement, indépendamment les uns des autres, remplacés par deutérium, CN, $CF_3$, ou F ;
$C_{2-5}$-alcynyle,
un ou plusieurs atomes d'hydrogène étant éventuellement, indépendamment les uns des autres, remplacés par deutérium, CN, $CF_3$, ou F ;
$C_{6-18}$-aryle,
qui est éventuellement substitué par un ou plusieurs substituants $C_{1-5}$-alkyle ;
$C_{3-17}$-hétéroaryle,
qui est éventuellement substitué par un ou plusieurs substituants $C_{1-5}$-alkyle ;
$N(C_{6-18}\text{-aryle})_2$,
$N(C_{3-17}\text{-hétéroaryle})_2$ ; et
$N(C_{3-17}\text{-hétéroaryle})(C_{6-18}\text{-aryle})$ ;
$R^{6S}$ étant en chaque occurrence indépendamment d'un autre choisi dans le groupe constitué par : hydrogène, deutérium, OPh, $CF_3$, CN, F,
$C_{1-5}$-alkyle,
un ou plusieurs atomes d'hydrogène étant éventuellement, indépendamment les uns des autres, remplacés par deutérium, CN, $CF_3$, ou F ;
$C_{1-5}$-alcoxy,
un ou plusieurs atomes d'hydrogène étant éventuellement, indépendamment les uns des autres, remplacés par deutérium, CN, $CF_3$, ou F ;
$C_{1-5}$-thioalcoxy,

un ou plusieurs atomes d'hydrogène étant éventuellement, indépendamment les uns des autres, remplacés par deutérium, CN, $CF_3$, ou F ;
$C_{2-5}$-alcényle,
un ou plusieurs atomes d'hydrogène étant éventuellement, indépendamment les uns des autres, remplacés par deutérium, CN, $CF_3$, ou F ;
$C_{2-5}$-alcynyle,
un ou plusieurs atomes d'hydrogène étant éventuellement, indépendamment les uns des autres, remplacés par deutérium, CN, $CF_3$, ou F ;
$C_{6-18}$-aryle,
qui est éventuellement substitué par un ou plusieurs substituants $C_{1-5}$-alkyle ;
$C_{3-17}$-hétéroaryle,
qui est éventuellement substitué par un ou plusieurs substituants $C_{1-5}$-alkyle ;
$N(C_{6-18}$-aryle$)_2$,
$N(C_{3-17}$-hétéroaryle$)_2$ ; et
$N(C_{3-17}$-hétéroaryle$)(C_{6-18}$-aryle) ;
deux ou plus des substituants choisis dans le groupe constitué par $R^I$, $R^{II}$, $R^{III}$, $R^{IV}$, $R^V$, $R^{VI}$, $R^{VII}$, $R^{VIII}$, $R^{IX}$, $R^X$, et $R^{XI}$ qui sont positionnés de manière adjacente les uns par rapport aux autres pouvant éventuellement chacun former un système monocyclique ou polycyclique, aliphatique, aromatique et/ou benzo-condensé avec un autre ; et
au moins l'un parmi $X^1$, $X^2$ et $X^3$ étant B et au moins l'un parmi $X^1$, $X^2$ et $X^3$ étant N.

**2.** Dispositif électroluminescent organique selon la revendication 1, au moins l'une des formules suivantes (6) et (7) s'appliquant

$$0,2 \text{ eV} \leq E^{HOMO}(E^B) - E^{HOMO}(S^B) \leq 0,8 \text{ eV} \quad (6)$$

$$0,2 \text{ eV} \leq E^{HOMO}(E^B) - E^{HOMO}(H^B) \leq 0,8 \text{ eV} \quad (7).$$

**3.** Dispositif électroluminescent organique selon l'une quelconque des revendications 1 et 2, le matériau TADF $E^B$ étant **caractérisé en ce qu'**il possède une valeur $\Delta E_{ST}$, qui correspond à la différence d'énergie entre $S1^E$ et $T1^E$, de moins de 0,4 eV.

**4.** Dispositif électroluminescent organique selon l'une quelconque des revendications 1 à 3, la relation exprimée par la formule (8) s'appliquant :

$$S1^S > T1^E \quad (8).$$

**5.** Dispositif électroluminescent organique selon l'une quelconque des revendications 1 à 4, le rapport en masse du matériau émetteur $S^B$ sur le matériau TADF $E^B$ ($S^B$ : $E^B$) étant > 1.

**6.** Dispositif électroluminescent organique selon l'une quelconque des revendications 1 à 5, ledit dispositif électroluminescent organique étant un dispositif choisi dans le groupe constitué par une diode luminescente organique, une cellule électrochimique luminescente et un transistor luminescent.

**7.** Dispositif électroluminescent organique selon l'une quelconque des revendications 1 à 6, le matériau émetteur $S^B$ ayant un niveau d'énergie d'état triplet excité le plus bas $T1^S$, le matériau émetteur $S^B$ étant choisi dans le groupe constitué par un émetteur de fluorescence et un émetteur TADF organique, l'émetteur TADF organique étant **caractérisé en ce qu'**il possède une valeur $\Delta E_{ST}$, qui correspond à la différence d'énergie entre $S1^S$ et $T1^S$, de moins de 0,4 eV.

**8.** Dispositif électroluminescent organique selon l'une quelconque des revendications 1 à 7, la relation exprimée par la formule (10a), (10b) ou (10c) s'appliquant :

$$E^{HOMO}(H^B) > E^{HOMO}(S^B) \quad (10a)$$

$$E^{HOMO}(S^B) > E^{HOMO}(H^B) \qquad (10b)$$

$$-0{,}1\ eV \leq E^{HOMO}(H^B) - E^{HOMO}(S^B) \leq 0{,}1\ eV \qquad (10c).$$

**9.** Dispositif électroluminescent organique selon l'une quelconque des revendications 1 à 8, la relation entre l'orbitale moléculaire non occupée la plus basse LUMO($E^B$) ayant une énergie $E^{LUMO}(E^B)$ et l'orbitale moléculaire non occupée la plus basse LUMO($S^B$) ayant une énergie $E^{LUMO}(S^B)$ exprimée par la formule (11) s'appliquant :

$$E^{LUMO}(E^B) > E^{LUMO}(S^B) \qquad (11).$$

**10.** Dispositif électroluminescent organique selon l'une quelconque des revendications 1 à 9, la couche luminescente B comprenant :

(i) 39,8 à 98 % en poids du composé hôte $H^B$ ;
(ii) 0,1 à 50 % en poids du matériau TADF $E^B$ ;
(iii) 0,1 à 50 % en poids du matériau émetteur $S^B$ ; et éventuellement
(iv) 0 à 60 % en poids d'un ou plusieurs composés hôtes supplémentaires $H^{B2}$ différant de $H^B$ ; éventuellement
(v) 0 à 60 % en poids d'un ou plusieurs solvants.

**11.** Dispositif électroluminescent organique selon l'une quelconque des revendications 1 à 10, la couche luminescente B comprenant le matériau TADF $E^B$ en une quantité de 0,1 à 10 % en poids.

**12.** Dispositif électroluminescent organique selon l'une quelconque des revendications 1 à 11, le dispositif présentant un maximum d'émission $\lambda_{max}(D)$ de 440 à 560 nm.

**13.** Procédé pour la génération d'une lumière visible comprenant les étapes de :

(i) fourniture du dispositif électroluminescent organique selon l'une quelconque des revendications 1 à 12 ; et
(ii) application d'un courant électrique au dispositif électroluminescent organique.

**14.** Utilisation du matériau $E^B$ à fluorescence retardée activée thermiquement (TADF) en combinaison avec au moins un matériau hôte $H^B$ et au moins un matériau émetteur $S^B$ dans la couche luminescente B, **caractérisée en ce que** la couche luminescente B est telle que dans l'une quelconque des revendications 1 à 13, pour l'augmentation de la durée de vie du dispositif électroluminescent organique.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3490023 A1
- US 2015236274 A
- WO 2017005699 A


### Non-patent literature cited in the description


- **HATAKEYAMA et al.** *Advanced Materials,* 2016, vol. 28 (14), 2777-2781
- *CHEMICAL ABSTRACTS,* 73183-34-3